# EUROPEAN PATENT APPLICATION

(11) **EP 4 651 638 A1**
(43) Date of publication of application: **19.11.2025**
(21) Application number: 24757139.1
(22) Date of filing: 08.02.2024
(51) Int. Cl.: H05K 1/14, H05K 1/11, H01Q 1/38, H04M 1/02, H01Q 1/24, H01Q 1/22, H01Q 1/52, H01R 24/60

(54) **FLEXIBLE PRINTED CIRCUIT BOARD AND ELECTRONIC DEVICE COMPRISING SAME**

(30) Priority: 14.02.2023 KR 20230019622; 29.03.2023 KR 20230041284
(71) Applicant: Samsung Electronics Co., Ltd., Suwon-si, Gyeonggi-do 16677 (KR)
(72) Inventor: KIM, Gidae, Suwon-si, Gyeonggi-do 16677 (KR)
(74) Representative: Nederlandsch Octrooibureau
(86) International application number: PCT/KR2024/001907
(87) International publication number: WO 2024/172410

(57) **Abstract**

According to an exemplary embodiment of the present disclosure, an electronic device is provided, and the electronic device comprises a first electrical element, a second electrical element, and a flexible printed circuit board, the flexible printed circuit board connects the first electrical element and the second electrical element, the flexible printed circuit board comprises a first portion on which a first connector electrically connected to the first electrical element is disposed, a second portion on which a second connector electrically connected to the second electrical element is disposed, and a third portion between the first portion and the second portion, the third portion comprises a first partial region extending from the first portion, a second partial region extending from the second portion, and a corner between the first partial region and the second partial region, and the corner comprises a fan-shaped rigid portion.

## Description

### [Technical Field]

The disclosure relates to a flexible printed circuit board and an electronic device including the same.

### [Background Art]

An electronic device may include a flexible printed circuit board electrically connecting a first electrical element and a second electrical element.

The above information may be provided as the related art for the purpose of assisting in the understanding of the disclosure. No assertion or determination is made as to whether any of the above description may be applied as the prior art related to the disclosure.

### [Disclosure of Invention]

### [Technical Problem]

A flexible printed circuit board may have a form extended from a first end electrically connected to a first electrical element to a second end electrically connected to a second electrical element. Due to structural complexity within an electronic device, it may be difficult to extend and/or dispose the flexible printed circuit board while ensuring a signal transmission performance.

Various embodiments of the disclosure provide an electronic device including a flexible printed circuit board for securing a signal transmission performance while reducing interference (e.g., electromagnetic interference and/or structural interference) with other components in a restricted space within the electronic device.

The technical problems to be achieved in the disclosure are not limited to those mentioned above, and other technical problems that are not mentioned may be understood by those of ordinary skill in the art from the following description.

### [Solution to Problem]

According to an exemplary embodiment of the disclosure, an electronic device is provided, and the electronic device includes a first electrical element, a second electrical element, and a flexible printed circuit board. The flexible printed circuit board connects the first electrical element and the second electrical element. The flexible printed circuit board includes a first portion in which a first connector electrically connected to the first electrical element is disposed. The flexible printed circuit board includes a second portion in which a second connector electrically connected to the second electrical element is disposed. The flexible printed circuit board includes a third portion between the first portion and the second portion. The third portion includes a first partial area extended from the first portion. The third portion includes a second partial area extended from the second portion. The third portion includes a corner between the first partial area and the second partial area. The corner includes a fan-shaped rigid portion.

According to an exemplary embodiment of the disclosure, a flexible printed circuit board includes a plurality of conductive vias disposed in a rigid portion.

According to an exemplary embodiment of the disclosure, a flexible printed circuit board includes a first signal line, a second signal line, and a third signal line extended from a first connector to a second connector. The third signal line is extended between the first signal line and the second signal line. A portion of the first signal line included in a corner is disposed closer to an outer edge of the corner than a portion of the second signal line included in the corner to have a longer length. The first signal line crosses the rigid portion.

According to an exemplary embodiment of the disclosure, an electronic device is configured to transmit a wireless signal via a first signal line and a second signal line. The electronic device is configured to transmit power through a third signal line.

According to an exemplary embodiment of the disclosure, a flexible printed circuit board includes a ground structure that at least partially surrounds a first signal line, a second signal line, and a third signal line. The ground structure includes a first opening pattern overlapping with the first signal line and including a plurality of openings at least partially disposed along the first signal line. The ground structure includes a second opening pattern overlapping with the second signal line and including a plurality of openings at least partially disposed along the second signal line.

According to an exemplary embodiment of the disclosure, the first partial area includes another rigid portion spaced apart from the first portion and the rigid portion. The flexible printed circuit board includes a plurality of conductive vias disposed in the other rigid portion.

According to an exemplary embodiment of the disclosure, the first partial area includes a flexible portion between the first portion and other rigid portion. The flexible portion is extended from the first portion to other rigid portion by a length of 5 mm or less.

According to an exemplary embodiment of the disclosure, a flexible printed circuit board includes a first pattern layer, a second pattern layer, and a third pattern layer. The second pattern layer is disposed between the first pattern layer and the third pattern layer. The first pattern layer includes a fan-shaped ground pattern included in a rigid portion. The ground pattern is electrically connected to a ground pattern included in the second pattern layer and a ground pattern included in the third pattern layer through a plurality of conductive vias.

According to an exemplary embodiment of the disclosure, the first electrical element includes an antenna module. The second electrical element includes a first printed circuit board on which a wireless communication circuit configured to transmit and/or receive millimeter waves via the antenna module is disposed.

According to an exemplary embodiment of the disclosure, the electronic device includes a housing including a front plate forming at least a portion of a front surface thereof, a rear plate forming at least a portion of a rear surface thereof, and a side forming at least a portion of a side surface thereof. The antenna module includes a second printed circuit board including a first surface that faces a first side of the side and a second surface that faces opposite to the first surface. The antenna module includes at least one antenna element disposed on the first surface or disposed within the second printed circuit board closer to the first surface than the second surface. The antenna module includes a third connector disposed on the second surface. A first portion of the flexible printed circuit board faces the second surface so as to electrically connect the first connector to the third connector.

According to an exemplary embodiment of the disclosure, the electronic device further includes a camera unit received in the housing corresponding to the camera hole formed in the rear plate. When viewed from above the rear surface of the electronic device, the first portion of the flexible printed circuit board is positioned between the second surface of the antenna module and the camera unit.

According to an exemplary embodiment of the disclosure, the electronic device further includes a support wall positioned between the camera unit and the first printed circuit board, when viewed from above the rear surface of the electronic device. The support wall faces the camera unit in a direction perpendicular to a direction in which a first surface of the antenna module faces. When viewed from above the rear surface of the electronic device, a corner of the flexible printed circuit board is positioned between the camera unit and the first printed circuit board and is disposed on the support wall via an adhesive material.

According to an exemplary embodiment of the disclosure, the electronic device further includes a fourth connector disposed on a substrate surface of the first printed circuit board facing the rear plate. A second portion of the flexible printed circuit board is positioned between the rear plate and the substrate surface so as to electrically connect the second connector to the fourth connector.

According to an exemplary embodiment of the disclosure, a first partial area of the flexible printed circuit board is bent to have a first bending axis parallel to a direction from the front plate to the rear plate. A second partial area of the flexible printed circuit board is bent to have a second bending axis parallel to a direction in which a first surface of the antenna module faces.

According to an exemplary embodiment of the disclosure, the electronic device further includes a battery received in the housing. When viewed from above the rear surface of the electronic device, the second portion and the corner of the flexible printed circuit board are positioned between the camera unit and the battery.

### [Advantageous Effects of Invention]

A flexible printed circuit board according to exemplary embodiments of the disclosure can secure a signal transmission performance so as to reduce structural interference within an electronic device.

Further, the effects that may be obtained or anticipated from various embodiments of the disclosure are directly or implicitly disclosed in the detailed description of the embodiments of the disclosure.

### [Brief Description of Drawings]

The above and other aspects, features, and advantages of specific embodiments of the disclosure will become more apparent from the following detailed description taken in conjunction with the accompanying drawings.
FIG. 1 is a block diagram illustrating an electronic device within a network environment according to an embodiment of the disclosure.
FIG. 2 is a block diagram illustrating an electronic device in a network environment including a plurality of cellular networks according to an embodiment of the disclosure.
FIG. 3 is a diagram illustrating an electronic device according to an embodiment of the disclosure.
FIG. 4 is a diagram illustrating an antenna module according to an embodiment of the disclosure.
FIG. 5 is an exploded perspective view illustrating an electronic device according to an embodiment of the disclosure.
FIG. 6 is a diagram illustrating a portion of an electronic device according to an embodiment of the disclosure.
FIG. 7 is an enlarged view illustrating an area 'C' of FIG. 6 according to an embodiment of the disclosure.
FIG. 8 is a diagram illustrating a third flexible printed circuit board in an unfolded state according to an embodiment of the disclosure.
FIG. 9 is a diagram illustrating a portion of an electronic device according to an embodiment of the disclosure.
FIG. 10 is a diagram illustrating a combination of an antenna module, a first bracket, and a third flexible printed circuit board according to an embodiment of the disclosure.
FIG. 11 is a perspective view illustrating a third flexible printed circuit board according to an embodiment of the disclosure.
FIG. 12 is a cross-sectional view illustrating a portion of an electronic device, and illustrating the electronic device cut along lines HH', II', JJ', KK', LL', and MM' according to an embodiment of the disclosure.
FIG. 13 is a diagram illustrating a first pattern layer according to an embodiment of the disclosure.
FIG. 14 is a diagram illustrating a second pattern layer according to an embodiment of the disclosure.
FIG. 15 is a diagram illustrating a third pattern layer according to an embodiment of the disclosure.
FIG. 16 is a perspective view illustrating a portion of a third flexible printed circuit board according to an embodiment of the disclosure.
FIG. 17 is a cross-sectional view illustrating a third flexible printed circuit board taken along line NN' of FIG. 13 according to an embodiment of the disclosure.
FIG. 18 is a perspective view illustrating a third flexible printed circuit board according to various embodiments of the disclosure.
FIG. 19 is a perspective view illustrating a third flexible printed circuit board according to various embodiments of the disclosure.
FIG. 20 is a graph illustrating a signal transmission performance of a third flexible printed circuit board according to an exemplary embodiment of the disclosure including at least one fourth ground pattern and a third flexible printed circuit board of a comparative example not including at least one fourth ground pattern.
FIG. 21 is a graph illustrating isolation of a third flexible printed circuit board according to an exemplary embodiment of the disclosure including at least one fourth ground pattern and a third flexible printed circuit board of a comparative example not including at least one fourth ground pattern.

### [Mode for Disclosure]

Hereinafter, various example embodiments of the disclosure disclosed herein will be described in greater detail with reference to the accompanying drawings.

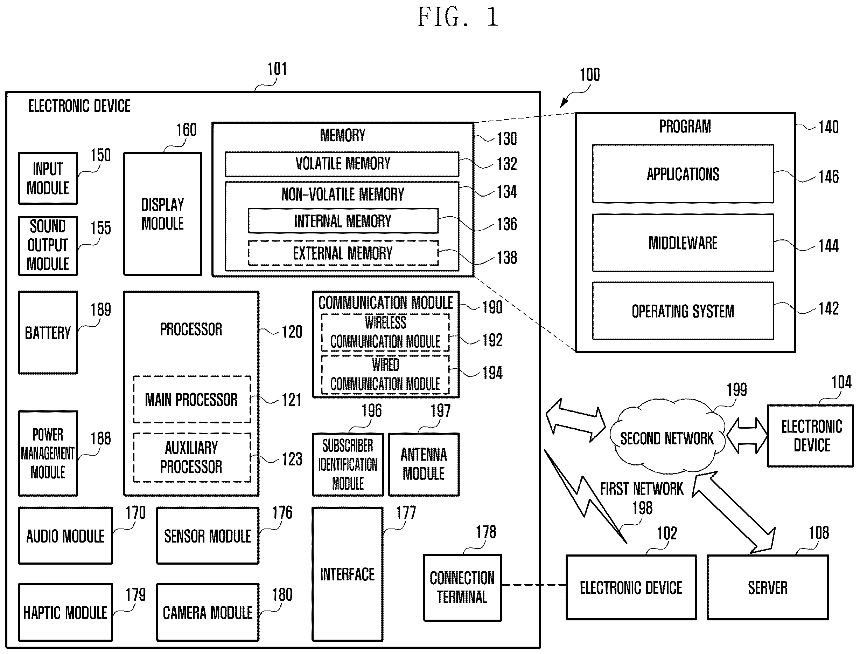

FIG. 1 is a block diagram of an electronic device 101 in a network environment 100 according to an embodiment of the disclosure.

Referring to FIG. 1, the electronic device 101 in the network environment 100 may communicate with an external electronic device 102 via a first network 198 (e.g., a short-range wireless communication network), or at least one of an external electronic device 104 or a server 108 via a second network 199 (e.g., a long-range wireless communication network). The electronic device 101 may communicate with the external electronic device 104 via the server 108. The electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, and/or an antenna module 197. In various embodiments of the disclosure, at least one (e.g., the connection terminal 178) of the components may be omitted from the electronic device 101, or one or more other components may be added in the electronic device 101. In various embodiments of the disclosure, some of the components may be implemented as single integrated circuitry. For example, the sensor module 176, the camera module 180, or the antenna module 197 may be implemented as embedded in single component (e.g., the display module 160).

The processor 120 may execute, for example, software (e.g., a program 140) to control at least one other component (e.g., a hardware or software component) of the electronic device 101 coupled with the processor 120, and may perform various data processing or computation. As at least part of the data processing or computation, the processor 120 may load a command or data received from another component (e.g., the sensor module 176 or the communication module 190) in a volatile memory 132, process the command or the data stored in the volatile memory 132, and store resulting data in a non-volatile memory 134. The processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., a sleep) state, or together with the main processor 121 while the main processor 121 is in an active state (e.g., executing an application). The auxiliary processor 123 (e.g., an ISP or a CP) may be implemented as part of another component (e.g., the camera module 180 or the communication module 190) functionally related to the auxiliary processor 123. According to an embodiment of the disclosure, the auxiliary processor 123 (e.g., a neural network processing device) may include a hardware structure specified for processing an artificial intelligence model. The artificial intelligence model may be created through machine learning. Such learning may be performed, for example, in the electronic device 101 itself on which the artificial intelligence model is performed, or may be performed through a separate server (e.g., the server 108). The learning algorithms may include, for example, supervised learning, unsupervised learning, semi-supervised learning, or reinforcement learning, but is not limited thereto. The artificial intelligence model may include a plurality of artificial neural network layers. The artificial neural network may be any of a deep neural network (DNN), a convolutional neural network (CNN), a recurrent neural network (RNN), a restricted Boltzmann machine (RBM), a deep belief network (DBN), a bidirectional recurrent DNN (BRDNN), a deep Q-network, or a combination of two or more of the above-mentioned networks, but is not limited the above-mentioned examples. In addition to the hardware structure, the artificial intelligence model may additionally or alternatively include a software structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 and/or the non-volatile memory 134.

The program 140 may be stored in the memory 130 as software, and may include, for example, an operating system (OS) 142, middleware 144, and/or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record, and the receiver may be used for incoming calls. The receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. The display module 160 may include touch circuitry (e.g., a touch sensor) adapted to detect a touch, or sensor circuitry (e.g., a pressure sensor) adapted to measure the intensity of force incurred by the touch.

The audio module 170 may convert a sound into an electrical signal and vice versa. The audio module 170 may obtain the sound via the input module 150, or output the sound via the sound output module 155 or a headphone of an external electronic device (e.g., the external electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. The sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. The interface 177 may include, for example, a high-definition multimedia interface (HDMI), a universal serial bus (USB) interface, a secure digital (SD) card interface, and/or an audio interface.

The connecting terminal 178 may include a connector via which the electronic device 101 may be physically connected with the external electronic device (e.g., the external electronic device 102). The connecting terminal 178 may include, for example, an HDMI connector, a USB connector, an SD card connector, and/or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. The haptic module 179 may include, for example, a motor, a piezoelectric element, or an electric stimulator.

The camera module 180 may capture a still image or moving images. The camera module 180 may include one or more lenses, image sensors, ISPs, or flashes.

The power management module 188 may manage power supplied to or consumed by the electronic device 101. The power management module 188 may be implemented as at least part of, for example, a power management integrated circuit (PMIC).

The battery 189 may supply power to at least one component of the electronic device 101. The battery 189 may include, for example, a primary cell which is not rechargeable, a secondary cell which is rechargeable, and/or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication via the established communication channel. The communication module 190 may include one or more CPs that are operable independently from the processor 120 (e.g., the AP) and supports a direct (e.g., wired) communication or a wireless communication. The communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BLUETOOTH, wireless-fidelity (Wi-Fi) direct, or IR data association (IrDA)) or the second network 199 (e.g., a long-range communication network, such as a legacy cellular network, a 5^{th} generation (5G) network, a next generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, after a 4^{th} generation (4G) network, and next-generation communication technology, e.g., new radio (NR) access technology. The NR access technology may support high-speed transmission of high-capacity data (i.e., enhanced mobile broadband (eMBB)), minimization of terminal power and connection of multiple terminals (massive machine type communications (mMTC)), or high reliability and low latency (ultra-reliable and low-latency communications (URLLC)). The wireless communication module 192 may support a high-frequency band (e.g., a mmWave band) to achieve, for example, a high data transmission rate. The wireless communication module 192 may support various technologies for securing performance in a high-frequency band, such as beamforming, massive multiple-input and multiple-output (MIMO), full-dimensional MIMO (FD-MIMO), array antenna, analog beam-forming, or large-scale antenna. The wireless communication module 192 may support various requirements specified in the electronic device 101, an external electronic device (e.g., external the electronic device 104), or a network system (e.g., the second network 199). According to an embodiment of the disclosure, the wireless communication module 192 may support a peak data rate for implementing eMBB (e.g., 20Gbps or more), loss coverage for implementing mMTC (e.g., 164dB or less), or U-plane latency for realizing URLLC (e.g., 0.5ms or less for each of downlink (DL) and uplink (UL) or 1ms or less for round trip).

The antenna module 197 may transmit or receive a signal or power to or from the outside (e.g., the external electronic device) of the electronic device 101. The antenna module 197 may include an antenna including a radiating element including a conductive material or a conductive pattern formed in or on a substrate (e.g., a printed circuit board (PCB)). The antenna module 197 may include a plurality of antennas (e.g., an antenna array). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. Another component (e.g., a radio frequency integrated circuit (RFIC)) other than the radiating element may be additionally formed as part of the antenna module 197.

According to various embodiments of the disclosure, the antenna module 197 may form a mmWave antenna module. According to an embodiment of the disclosure, the mmWave antenna module may include a PCB, an RFIC that is disposed on or adjacent to a first surface (e.g., the bottom surface) of the PCB and is capable of supporting a predetermined high-frequency band (e.g., a mmWave band), and a plurality of antennas (e.g., array antennas) that is disposed on or adjacent to a second surface (e.g., the top surface or the side surface) of the PCB and is capable of transmitting or receiving a signal of the predetermined high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

Commands or data may be transmitted or received between the electronic device 101 and the external electronic device 104 via the server 108 coupled with the second network 199. Each of the external electronic devices 102 or 104 may be a device of a same type as, or a different type, from the electronic device 101. All or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide an ultra-low delay service using, for example, distributed computing or MEC. In another embodiment of the disclosure, the external electronic device 104 may include an internet of things (IoT) device. The server 108 may be an intelligent server using machine learning and/or neural networks. According to an embodiment of the disclosure, the external electronic device 104 or the server 108 may be included in the second network 199. The electronic device 101 may be applied to an intelligent service (e.g., smart home, smart city, smart car, or healthcare) based on 5G communication technology or IoT-related technology.

An electronic device according to an embodiment of the disclosure may be one of various types of electronic devices. The electronic devices may include a portable communication device (e.g., a smartphone), a computer device, a portable multimedia device, a portable medical device, a camera, a wearable device, or a home appliance. However, the electronic device is not limited to any of those described above.

Various embodiments of the disclosure and the terms used herein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). If an element (e.g., a first element) is referred to, with or without the term "operatively" or "communicatively," as "coupled with," "coupled to," "connected with," or "connected to" another element (e.g., a second element), the element may be coupled with the other element directly (e.g., wiredly), wirelessly, or via a third element.

The term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment of the disclosure, the module may be implemented in a form of an application-specific integrated circuit (ASIC).

Various embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

A method according to an embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PLAYSTORE^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

Each component (e.g., a module or a program) of the above-described components may include a single entity or multiple entities. One or more of the above-described components may be omitted, or one or more other components may be added. Alternatively or additionally, a plurality of components (e.g., modules or programs) may be integrated into a single component. In such a case, the integrated component may perform one or more functions of each of the plurality of components in the same or similar manner as they are performed by a corresponding one of the plurality of components before the integration. Operations performed by the module, the program, or another component may be carried out sequentially, in parallel, repeatedly, or heuristically, or one or more of the operations may be executed in a different order or omitted, or one or more other operations may be added.

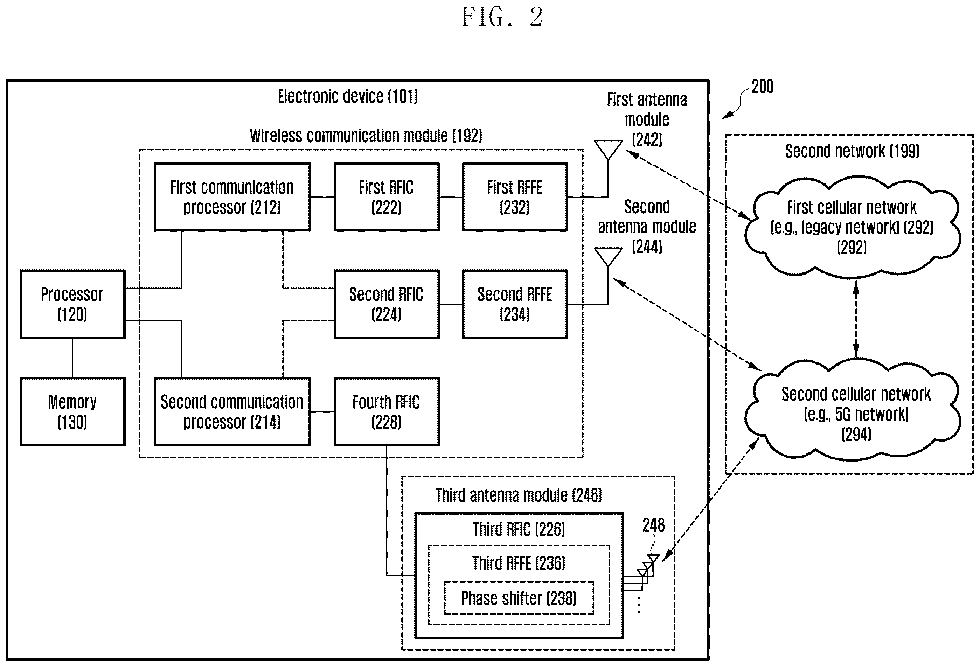

FIG. 2 is a block diagram 200 illustrating an electronic device 101 in a network environment including a plurality of cellular networks according to an embodiment of the disclosure.

With reference to FIG. 2, the electronic device 101 may include a first communication processor 212, a second communication processor 214, a first radio frequency integrated circuit (RFIC) 222, a second RFIC 224, a third RFIC 226, a fourth RFIC 228, a first radio frequency front end (RFFE) 232, a second RFFE 234, a first antenna module 242, a second antenna module 244, and/or an antenna 248. The electronic device 101 may include a processor 120 and a memory 130. A second network 199 may include a first cellular network 292 and a second cellular network 294. According to an embodiment, the electronic device 101 may further include at least one of the components described in FIG. 1, and the second network 199 may further include at least one other network. According to an embodiment, the first communication processor 212, the second communication processor 214, the first RFIC 222, the second RFIC 224, the fourth RFIC 228, the first RFFE 232, and the second RFFE 234 may form at least a portion of the wireless communication module 192. According to another embodiment, the fourth RFIC 228 may be omitted or included as a part of the third RFIC 226.

The first communication processor 212 may support establishment of a communication channel of a band to be used for wireless communication with the first cellular network 292, and legacy network communication through the established communication channel. According to various embodiments, the first cellular network may be a legacy network including a second generation (2G), a third generation (3G), a fourth generation (4G), or a long term evolution (LTE) network. The second communication processor 214 may support establishment of a communication channel corresponding to a designated band (e.g., about 6 GHz to about 60 GHz) among bands to be used for wireless communication with the second cellular network 294, and 5G network communication through the established communication channel. According to various embodiments, the second cellular network 294 may be a fifth generation (5G) network defined by 3GPP. Additionally, according to an embodiment, the first communication processor 212 or the second communication processor 214 may support establishment of a communication channel corresponding to another designated band (e.g., about 6 GHz or less) among bands to be used for wireless communication with the second cellular network 294, and 5G network communication through the established communication channel. According to an embodiment, the first communication processor 212 and the second communication processor 214 may be implemented in a single chip or a single package. According to various embodiments, the first communication processor 212 or the second communication processor 214 may be formed in a single chip or a single package with the processor 120, the auxiliary processor 123, or the communication module 190.

The first RFIC 222 may, upon transmission, convert a baseband signal generated by the first communication processor 212 into a radio frequency (RF) signal of about 700 MHz to about 3 GHz used in the first cellular network 292 (e.g., legacy network). Upon reception, the RF signal may be acquired from the first cellular network 292 (e.g., legacy network) through an antenna (e.g., the first antenna module 242) and preprocessed through an RFFE (e.g., the first RFFE 232). The first RFIC 222 may convert the preprocessed RF signal into a baseband signal so that the preprocessed RF may be processed by the first communication processor 212.

The second RFIC 224 may, upon transmission, convert a baseband signal generated by the first communication processor 212 or the second communication processor 214 into an RF signal (hereinafter, 5G Sub6 RF signal) of a Sub6 band (e.g., about 6 GHz or less) used in the second cellular network 294 (e.g., 5G network). Upon reception, the 5G Sub6 RF signal may be acquired from the second cellular network 294 (e.g., the 5G network) through an antenna (e.g., the second antenna module 244) and preprocessed via an RFFE (e.g., the second RFFE 234). The second RFIC 224 may convert the preprocessed 5G Sub6 RF signal into a baseband signal so that the preprocessed 5G Sub6 RF signal may be processed by a corresponding communication processor, either the first communication processor 212 or the second communication processor 214.

The third RFIC 226 may convert a baseband signal generated by the second communication processor 214 into an RF signal (hereinafter, "5G Above6 RF signal") of a 5G Above6 band (e.g., about 6 GHz to about 60 GHz) to be used in the second cellular network 294 (e.g., 5G network). Upon reception, the 5G Above6 RF signal may be acquired from the second cellular network 294 (e.g., 5G network) through an antenna (e.g., the antenna 248) and preprocessed through the third RFFE 236. The third RFIC 226 may convert the preprocessed 5G Above6 RF signal into a baseband signal so that the preprocessed 5G Above6 RF signal may be processed by the second communication processor 214. According to an embodiment, the third RFFE 236 may be formed as a part of the third RFIC 226.

According to an embodiment, the electronic device 101 may include a fourth RFIC 228 separately from or as at least a part of the third RFIC 226. In such a case, the fourth RFIC 228 may convert a baseband signal generated by the second communication processor 214 into an RF signal (hereinafter, IF signal) of an intermediate frequency band (e.g., about 9 GHz to about 11 GHz) and then transmit the IF signal to the third RFIC 226. The third RFIC 226 may convert the IF signal into a 5G Above6 RF signal. Upon reception, the 5G Above6 RF signal may be received from the second cellular network 294 (e.g., 5G network) through an antenna (e.g., the antenna 248) and converted into an IF signal by the third RFIC 226. The fourth RFIC 228 may convert the IF signal into a baseband signal so as to process by the second communication processor 214.

According to an embodiment, the first RFIC 222 and the second RFIC 224 may be implemented as at least a portion of a single chip or a single package. According to an embodiment, the first RFFE 232 and the second RFFE 234 may be implemented as at least a portion of a single chip or a single package. According to an embodiment, at least one antenna module of the first antenna module 242 or the second antenna module 244 may be omitted or combined with another antenna module to process RF signals of corresponding multiple bands.

According to an embodiment, the third RFIC 226 and the antenna 248 may be disposed on the same substrate to form the third antenna module 246. For example, the wireless communication module 192 or the processor 120 may be disposed on the first substrate (e.g., main PCB). In this case, the third RFIC 226 may be disposed on a partial area (e.g., bottom surface) of a second substrate (e.g., sub PCB) separate from the first substrate, and the antenna 248 may be disposed on another partial area (e.g., top surface) of the second substrate, thereby forming the third antenna module 246. By disposing the third RFIC 226 and the antenna 248 on the same substrate, it is possible to reduce a length of a transmission line therebetween. This may reduce, for example, the loss (e.g., attenuation) of signals in a high frequency band (e.g., about 6 GHz to about 60 GHz) used for 5G network communication by transmission lines. Therefore, the electronic device 101 may improve the quality or speed of communication with the second cellular network 294 (e.g., 5G network).

According to an embodiment, the antenna 248 may be formed as an antenna array including a plurality of antenna elements that may be used for beamforming. In such a case, the third RFIC 226 may include, for example, a plurality of phase shifters 238 corresponding to the plurality of antenna elements as part of the third RFFE 236. Upon transmission, each of the plurality of phase shifters 238 may shift the phase of a 5G Above6 RF signal to be transmitted from the electronic device 101 to the external device (e.g., a base station of a 5G network) through the corresponding antenna element. Upon reception, each of the plurality of phase shifters 238 may shift the phase of a 5G Above6 RF signal received from the external device through the corresponding antenna element to the same phase or substantially the same phase. This enables transmission or reception via beamforming between the electronic device 101 and the external device.

The second cellular network 294 (e.g., 5G network) may operate independently of the first cellular network 292 (e.g., legacy network) (e.g., stand-alone (SA)) or in connection with the first cellular network 292 (e.g., legacy network) (e.g., non-stand alone (NSA)). For example, the 5G network may only have an access network (e.g., 5G radio access network (RAN) or next generation RAN (NG RAN)) and no core network (e.g., next generation core (NGC)). In such a case, the electronic device 101 may access an external network (e.g., Internet) under the control of the core network (e.g., evolved packed core (EPC)) of the legacy network after accessing the access network of the 5G network. Protocol information (e.g., LTE protocol) information for communicating with a legacy network or protocol information (e.g., new radio (NR) protocol information) for communicating with a 5G network may be stored in the memory 230 to be accessed by other components (e.g., the processor 120, the first communication processor 212, or the second communication processor 214).

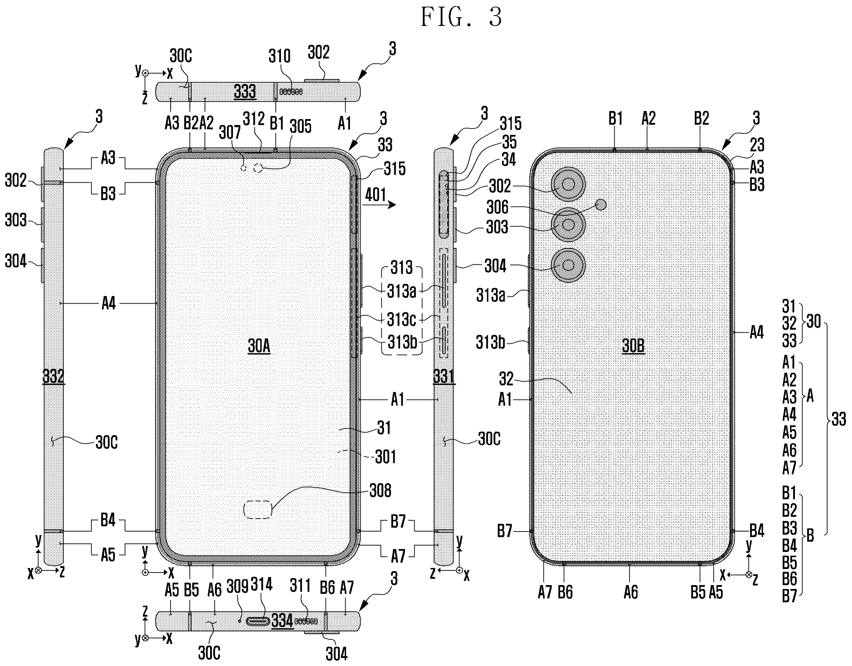

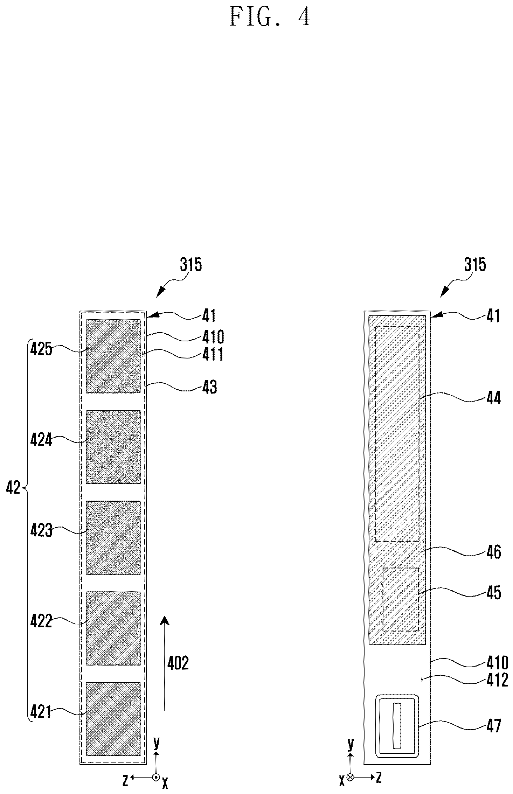

FIG. 3 is a diagram illustrating an electronic device 3 according to an embodiment of the disclosure. FIG. 4 is a diagram illustrating an antenna module 315 according to an embodiment of the disclosure.

In various embodiments of the disclosure, for convenience of description, a direction (e.g., +z-axis direction) in which a display area included in the electronic device 3 is visually visible is defined as a front surface 30A of the electronic device 3, and the opposite direction (e.g., -z-axis direction) is defined as a rear surface 30B of the electronic device 3.

With reference to FIG. 3, the electronic device 3 may include a housing 30 that provides (or forms) at least a portion of the exterior appearance thereof. The housing 30 may provide, for example, a front surface 30A, a rear surface 30B, and/or a side surface 30C of the electronic device 3. In various embodiments, the housing 30 may refer to a structure (or structural body) that provides at least a portion of the front surface 30A, the rear surface 30B, and the side surface 30C.

According to an embodiment, the housing 30 may include a front plate (or front cover, first cover, or first plate) 31, a rear plate (or rear cover, second cover, or second plate) 32, and/or a side (or side surface portion, lateral member, side bezel structure, or side wall portion) 33.

According to an embodiment, the front plate 31 may provide (or form) at least a portion of the front surface 30A of the electronic device 3. At least a portion of the front plate 31 may be substantially transparent. The front plate 31 may include, for example, a glass plate including various coating layers, or a polymer plate.

According to an embodiment, the rear plate 32 may provide (or form) at least a portion of the rear surface 30B of the electronic device 3. The rear plate 32 may be substantially opaque. The rear plate 32 may be made of, for example, coated or colored glass, ceramic, polymer, metal (e.g., aluminum, stainless steel, or magnesium), or a combination of at least two of the foregoing materials.

According to an embodiment, the side 33 may provide (or form) at least a portion of the side surface 30C of the electronic device 3. The side 33 may include a metallic material and/or a non-metallic material (e.g., polymer).

According to an embodiment, the side 33 may include a first side (or a first side surface portion, a first side wall, a first side wall portion, a first bezel, or a first bezel portion) 331, a second side (or a second side surface portion, a second side wall, a second side wall portion, a second bezel, or a second bezel portion) 332, a third side (or a third side surface portion, a third side wall, a third side wall portion, a third bezel, or a third bezel portion) 333, and/or a fourth side (or a fourth side surface portion, a fourth side wall, a fourth side wall portion, a fourth bezel, or a fourth bezel portion) 334.

According to an embodiment, when viewed from above the front plate 31 (e.g., when viewed in the -z-axis direction), the first side 331 may be spaced apart from the second side 332 in a first direction (e.g., the +x-axis direction) and be substantially parallel to the second side 332. The first side 331 may provide a first side surface corresponding to the first direction among the side surfaces 30C of the electronic device 3. The second side 332 may provide a second side surface corresponding to a second direction (e.g., the -x-axis direction) opposite to the first direction among the side surfaces 30C of the electronic device 3.

According to an embodiment, the third side 333 may connect one end of the first side 331 and one end of the second side 332. The fourth side 334 may connect the other end of the first side 331 and the other end of the second side 332. When viewed from above the front plate 31, the third side 333 may be spaced apart from the fourth side 334 in a third direction (e.g., the +y-axis direction) and be substantially parallel to the fourth side 334. The third side 333 may provide a third side surface corresponding to a third direction among the side surfaces 30C of the electronic device 3. The fourth side 334 may provide a fourth side surface corresponding to a fourth direction (e.g., the -y-axis direction) opposite to the third direction among the side surfaces 30C of the electronic device 3.

According to an embodiment, a first corner where the first side 331 and the third side 333 are connected (or between the first side 331 and the third side 333), a second corner where the first side 331 and the fourth side 334 are connected (or between the first side 331 and the fourth side 334), a third corner where the second side 332 and the third side 333 are connected (or between the second side 332 and the third side 333), and/or a fourth corner where the second side 332 and the fourth side 334 are connected (or between the second side 332 and the fourth side 334) may be implemented as a smooth curve.

According to an embodiment, the side 33 may include an outer metal (or an outer metal structure, an outer conductor, an outer conductive structure, a side metal, a side metal structure, a side conductor, or a side conductive structure) A and an outer non-metal (or an outer non-metal structure, an outer non-conductor, an outer non-conductive structure, a side non-metal, a side non-metal structure, a side non-conductor, or a side non-conductive structure) B.

According to an embodiment, the outer metal A of the side 33 may include a first outer metal (or a first outer conductive portion or a first side conductive portion) A1, a second outer metal (or a second outer conductive portion or a second side conductive portion) A2, a third outer metal (or a third outer conductive portion or a third side conductive portion) A3, a fourth outer metal (or a fourth outer conductive portion or a fourth side conductive portion) A4, a fifth outer metal (or a fifth outer conductive portion or a fifth side conductive portion) A5, a sixth outer metal (or a sixth outer conductive portion or a sixth side conductive portion) A6, and/or a seventh outer metal (or a seventh outer conductive portion or a seventh side conductive portion) A7.

According to an embodiment, the outer non-metal B of the side 33 may include a first outer non-metal (or a first outer non-conductive portion or a first side non-conductive portion) B1, a second outer non-metal (or a second outer non-conductive portion or a second side non-conductive portion) B2, a third outer non-metal (or a third outer non-conductive portion or a third side non-conductive portion) B3, a fourth outer non-metal (or a fourth outer non-conductive portion or a fourth side non-conductive portion) B4, a fifth outer non-metal (or a fifth outer non-conductive portion or a fifth side non-conductive portion) B5, a sixth outer non-metal (or a sixth outer non-conductive portion or a sixth side non-conductive portion) B6, and/or a seventh outer non-metal (or a seventh outer non-conductive portion or a seventh side non-conductive portion) B7.

According to an embodiment, a combination of the first outer metal A1, the second outer metal A2, the third outer metal A3, the fourth outer metal A4, the fifth outer metal A5, the sixth outer metal A6, the seventh outer metal A7, the first outer non-metal B1, a second outer non-metal B2, the third outer non-metal B3, the fourth outer non-metal B4, the fifth outer non-metal B5, the sixth outer non-metal B6, and the seventh outer non-metal B7 may provide a first side 331, a second side 332, a third side 333, and a fourth side 334.

According to an embodiment, the first outer non-metal B1 may be disposed at a first segment (e.g., first gap) between the first outer metal A1 and the second outer metal A2. The first outer metal A1 and the second outer metal A2 may be physically separated from each other with the first outer non-metal B1 therebetween. The first outer non-metal B1 may be defined or interpreted as a 'first insulating portion'. The second outer non-metal B2 may be disposed at a second segment (e.g., second gap) between the second outer metal A2 and the third outer metal A3. The second outer metal A2 and the third outer metal A3 may be physically separated from each other with the second outer non-metal B2 therebetween. The second outer non-metal B2 may be defined or interpreted as a 'second insulating portion'. The third outer non-metal B3 may be disposed at a third segment (e.g., third gap) between the third outer metal A3 and the fourth outer metal A4. The third outer metal A3 and the fourth outer metal A4 may be physically separated from each other with the third outer non-metal B3 therebetween. The third outer non-metal B3 may be defined or interpreted as a 'third insulating portion'. The fourth outer non-metal B4 may be disposed at a fourth segment (e.g., fourth gap) between the fourth outer metal A4 and the fifth outer metal A5. The fourth outer metal A4 and the fifth outer metal A5 may be physically separated from each other with the fourth outer non-metal B4 therebetween. The fourth outer non-metal B4 may be defined or interpreted as a 'fourth insulating portion'. The fifth outer non-metal B5 may be disposed at a fifth segment (e.g., fifth gap) between the fifth outer metal A5 and the sixth outer metal A6. The fifth outer metal A5 and the sixth outer metal A6 may be physically separated from each other with the fifth outer non-metal B5 therebetween. The fifth outer non-metal B5 may be defined or interpreted as a 'fifth insulating portion'. The sixth outer non-metal B6 may be disposed at a sixth segment (e.g., sixth gap) between the sixth outer metal A6 and the seventh outer metal A7. The sixth outer metal A6 and the seventh outer metal A7 may be physically separated from each other with the sixth outer non-metal B6 therebetween. The seventh outer non-metal B7 may be disposed at a seventh segment (e.g., seventh gap) between the first outer metal A1 and the seventh outer metal A7. The first outer metal A1 and the seventh outer metal A7 may be physically separated from each other with the seventh outer non-metal B7 therebetween.

According to an embodiment, the side surface 30C of the electronic device 3 may include first surface areas (e.g., conductive surface areas) provided by the first outer metal A1, the second outer metal A2, the third outer metal A3, the fourth outer metal A4, the fifth outer metal A5, the sixth outer metal A6, and the seventh outer metal A7, and second surface areas (e.g., non-conductive surface areas) provided by the first outer non-metal B1, the second outer non-metal B2, the third outer non-metal B3, the fourth outer non-metal B4, the fifth outer non-metal B5, the sixth outer non-metal B6, and the seventh outer non-metal B7. The first surface areas and the second surface areas may be smoothly connected without a substantial height difference.

According to various embodiments, the position, number, or shape of segments (e.g., gaps) of the outer metal A are not limited to the illustrated examples and may vary (not separately illustrated). The shape of the outer metal A and/or the outer non-metal B are not limited to the illustrated examples and may vary (not separately illustrated).

According to various embodiments, an integrated or single metal structure (e.g., single continuous metal structure or complete metal structure) including the rear plate 32 and the side 33 may be provided.

According to an embodiment, the electronic device 3 may include a display module 301, a first camera module 302, a second camera module 303, a third camera module 304, a fourth camera module 305, a light emitting module 306, a first sensor module 307, a second sensor module 308, an audio input module (not separately illustrated), a first sound output module (not separately illustrated), a second sound output module (not separately illustrated), a third sound output module (not separately illustrated), a key input module 313, a connection terminal 314, and/or an antenna module 315. Although not separately illustrated, the electronic device 3 may omit at least one of the above components or may additionally include other components.

According to an embodiment, a display area (or active area or screen area) of the display module 301 is visually visible through the front plate 31.

According to an embodiment, the electronic device 3 may be implemented to expose as much of the display area as possible through the front plate 31 (e.g., large screen or full screen). The display module 301 may be provided, for example, with substantially the same outer shape as that of the front plate 31.

According to an embodiment, the first camera module 302, the second camera module 303, the third camera module 304, and/or the fourth camera module 305 may include one or more lenses, an image sensor(s), and/or an image signal processor (ISP).

According to an embodiment, the first camera module 302, the second camera module 303, and the third camera module 304 may be provided corresponding to the rear surface 30B of the electronic device 3. The first camera module 302 may be defined or interpreted as a 'first rear camera module', the second camera module 303 may be defined or interpreted as a 'second rear camera module', and/or the third camera module 304 may be defined or interpreted as a 'third rear camera module'.

According to an embodiment, the first camera module 302 may be positioned corresponding to a first camera hole provided (or formed) in the rear plate 32 and be visually visible from the outside of the electronic device 3 through the first camera hole. The second camera module 303 may be positioned corresponding to a second camera hole provided (or formed) in the rear plate 32 and be visually visible from the outside of the electronic device 3 through the second camera hole. The third camera module 304 may be positioned corresponding to a third camera hole provided (or formed) in the rear plate 32 and be visually visible from the outside of the electronic device 3 through the third camera hole. In various embodiments, the rear plate 32 may be implemented to include a first light transmitting area replacing the first camera hole, a second light transmitting area replacing the second camera hole, and/or a third light transmitting area replacing the third camera hole.

According to an embodiment, when viewed from above the rear surface 30B of the electronic device 3 (e.g., when viewed in the +z-axis direction), the first camera module 302, the second camera module 303, and the third camera module 304 may be disposed in a direction (e.g., the -y-axis direction) from the third side 333 to the fourth side 334. When viewed from above the rear surface 30B of the electronic device 3, the first camera module 302 may be positioned corresponding to a first corner where the first side 331 and the third side 333 are connected, and the second camera module 303 may be positioned between the first camera module 302 and the third camera module 304.

According to various embodiments, relative positions of the first camera module 302, the second camera module 303, and the third camera module 304 are not limited to the illustrated example and may vary (not separately illustrated). The number of camera modules (e.g., rear camera modules) corresponding to the rear plate 32 is not limited to the illustrated example and may vary (not separately illustrated).

According to various embodiments, the first camera module 302, the second camera module 303, and/or the third camera module 304 may include a wide angle camera module, a telephoto camera module, a color camera module, a monochrome camera module, or an IR camera (e.g., time of flight (TOF) camera, structured light camera) module.

According to an embodiment, the first camera module 302, the second camera module 303, and the third camera module 304 may have different properties (e.g., field of view) or functions.

According to various embodiments, the first camera module 302, the second camera module 303, and/or the third camera module 304 may provide different angles of view (or lenses with different angles of view). The electronic device 3 may selectively use angles of view of the first camera module 302, the second camera module 303, and/or the third camera module 304 based on a user's selection regarding the angle of view.

According to an embodiment, the fourth camera module 305 may be positioned inside the electronic device 3 corresponding to the front surface 30A of the electronic device 3. External light may pass through the front plate 31 to reach the fourth camera module 305. The fourth camera module 305 may be defined or interpreted as a 'front camera module'.

According to an embodiment, when viewed from above the front surface 30A of the electronic device 3 (e.g., when viewed in the -z-axis direction), the fourth camera module 305 may be positioned closer to the third side 333 than the fourth side 334. When viewed from above the front surface 30A of the electronic device 3, a distance at which the fourth camera module 305 is spaced from the first side 331 and a distance at which the fourth camera module 305 is spaced from the second side 332 may be substantially the same.

According to an embodiment, the fourth camera module 305 may be positioned in alignment with or at least partially inserted into an opening provided in a display area of the display module 301. External light may pass through the opening of the front plate 31 and the display area to reach the fourth camera module 305. The opening in the display area, aligned or overlapped with the fourth camera module 305, may be provided in the form of a hole. In various embodiments, when viewed from above the front surface 30A of the electronic device 3, the opening in the display area, aligned or overlapped with the fourth camera module 305, may be provided as a notch (not separately illustrated).

According to various embodiments, when viewed from above the front surface 30A of the electronic device 3, the fourth camera module 305 may overlap with the display area of the display module 301. The fourth camera module 305 may be positioned at the rear surface of the display area or below or beneath the display area. When viewed from the outside of the electronic device 3, the fourth camera module 305 or the position of the fourth camera module 305 may be substantially indistinguishable (or invisible). The fourth camera module 305 may include, for example, a hidden display rear camera (e.g., under display camera (UDC)). External light may pass through the front plate 31 and the display area to reach the fourth camera module 305.

According to various embodiments, the fourth camera module 305 may be aligned and positioned in a recess (not separately illustrated) provided on the rear surface of the display area or may be at least partially inserted into the recess. When viewed from the outside of the electronic device 3, the fourth camera module 305 or the position of the fourth camera module 305 may be substantially invisible or indistinguishable.

According to various embodiments, although not separately illustrated, a partial area of the display area of the display module 301 that at least partially overlaps with the fourth camera module 305 may include a different pixel structure and/or wiring structure compared to other areas. A pixel structure and/or wiring structure provided in the partial area of the display area that at least partially overlaps with the fourth camera module 305 may be implemented to reduce light loss between the outside of the electronic device 3 and the fourth camera module 305. A partial area of the display area that at least partially overlaps with the fourth camera module 305 may have, for example, a different pixel density (e.g., number of pixels per unit area) compared to other areas. For example, a partial area of the display area that at least partially overlaps with the fourth camera module 305 may not substantially include a plurality of pixels.

According to an embodiment, the light emitting module 306 may be provided corresponding to the rear surface 30B of the electronic device 3. The light emitting module 306 may be positioned corresponding to a flash hole or a light transmitting area provided (or formed) in the rear plate 32. The light emitting module 306 may include a light source for the first camera module 302, the second camera module 303, and/or the third camera module 304. The light emitting module 306 may include, but is not limited to, an LED, an IR LED, or a xenon lamp.

According to various embodiments, the electronic device 3 may include another light emitting module (e.g., LED, IR LED, or xenon lamp) (not separately illustrated) positioned therein corresponding to the front surface 30A thereof. The other light emitting module may provide status information of the electronic device 3 in the form of light. In various embodiments, the other light emitting module may provide a light source linked to the operation of the fourth camera module 305.

According to an embodiment, the first sensor module 307 may be positioned inside the electronic device 3 corresponding to the front surface 30A of the electronic device 3. The first sensor module 307 may include, for example, an optical sensor (e.g., proximity sensor or light sensor).

According to an embodiment, when viewed from above the front surface 30A of the electronic device 3, the first sensor module 307 may be positioned closer to the third side 333 than the fourth side 334. When viewed from above the front surface 30A of the electronic device 3, the first sensor module 307 may be positioned closer to the fourth camera module 305 than the second side 332. The position of the first sensor module 307 is not limited to the illustrated example and may vary.

According to an embodiment, when viewed from above the front surface 30A of the electronic device 3, the first sensor module 307 may overlap with the display area of the display module 301. The first sensor module 307 may be positioned on the rear surface of the display area or below or beneath the display area. When viewed from the outside of the electronic device 3, the first sensor module 307 or the position of the first sensor module 307 may be substantially invisible or indistinguishable. External light may pass through the front plate 31 and the display area to reach the first sensor module 307.

According to various embodiments, the first sensor module 307 may be aligned and positioned in a recess (not separately illustrated) provided on the rear surface of the display area, or may be at least partially inserted into the recess. When viewed from the outside of the electronic device 3, the first sensor module 307 or the position of the first sensor module 307 may be substantially invisible or indistinguishable.

According to various embodiments, although not separately illustrated, a partial area of the display area of the display module 301 that at least partially overlaps with the first sensor module 307 may include a different pixel structure and/or wiring structure compared to other areas. A pixel structure and/or wiring structure provided in a partial area of the display area that at least partially overlaps with the first sensor module 307 may be implemented to reduce light loss between the outside of the electronic device 3 and the first sensor module 307. For example, a partial area of the display area that at least partially overlaps with the first sensor module 307 may have a different pixel density (e.g., number of pixels per unit area) compared to other areas. For example, a partial area of the display area that at least partially overlaps with the first sensor module 307 may not substantially include a plurality of pixels.

According to various embodiments, the first sensor module 307 may be positioned in alignment with or at least partially inserted into an opening provided in a display area of the display module 301. External light may pass through the opening of the front plate 31 and the display area to reach the first sensor module 307. An opening of the display area aligned or overlapped with the first sensor module 307 may be provided in the form of a hole. In various embodiments, when viewed from above the front surface 30A of the electronic device 3, the opening of the display area aligned or overlapped with the first sensor module 307 may be provided as a notch (not separately illustrated).

According to an embodiment, the second sensor module 308 may be disposed in the electronic device 3 in at least partially identical or similar manner to the first sensor module 307. When viewed from above the front surface 30A of the electronic device 3, the second sensor module 308 may overlap with the display area of the display module 301. The second sensor module 308 may be positioned on the rear surface of the display area or below or beneath the display area. When viewed from the outside of the electronic device 3, the second sensor module 308 or the position of the second sensor module 308 may be substantially invisible or indistinguishable.

According to an embodiment, the second sensor module 308 may include an optical, electrostatic, or ultrasonic biometric sensor module (e.g., fingerprint recognition sensor module).

According to an embodiment, when viewed from above the front surface 30A of the electronic device 3, the second sensor module 308 may be positioned closer to the fourth side 334 than the third side 333. When viewed from above the front surface 30A of the electronic device 3, a distance at which the second sensor module 308 is spaced from the first side 331 and a distance at which the second sensor module 308 is spaced from the second side 332 may be substantially the same. The position of the second sensor module 308 is not limited to the illustrated example and may vary.

According to various embodiments, the electronic device 3 may include at least one other sensor module (not separately illustrated) provided at various other positions.

According to an embodiment, the sound input module (not separately illustrated) may include a microphone. The microphone may be, for example, positioned inside the electronic device 3 corresponding to a microphone hole 309 provided at the fourth side 334. The positions or numbers of the microphone and the microphone hole corresponding to the microphone are not limited to the illustrated example and may vary (not separately illustrated).

According to an embodiment, the first sound output module (not separately illustrated) may include a first speaker (not separately illustrated) used for reproducing data regarding multimedia or recording. The first speaker may be, for example, positioned inside the electronic device 3 corresponding to a first speaker hole 310 provided on the third side 333. The second sound output module (not separately illustrated) may include a second speaker (not separately illustrated) used for reproducing data regarding multimedia or recording. The second speaker may be, for example, positioned inside the electronic device 3 corresponding to a second speaker hole 311 provided at the fourth side 334. The positions or numbers of speakers for reproducing data regarding multimedia or recording and the corresponding speaker holes may vary (not separately illustrated).

According to various embodiments, the first sound output module may include a first piezo speaker, and the first speaker hole 310 may be omitted. The first sound output module may include a second piezo speaker, and the second speaker hole 311 may be omitted.

According to an embodiment, the third sound output module (not separately illustrated) may include a third speaker (e.g., call receiver) (not separately illustrated) used for a call. The third speaker may be, for example, positioned inside the electronic device 3 corresponding to a third speaker hole 312 (e.g., a through hole or a notch-shaped opening) provided in the front plate 31 or the third side 333 between the front plate 31 and the third side 333. The positions or numbers of the third speaker and the third speaker hole 312 corresponding to the third speaker may vary (not separately illustrated).

According to various embodiments, the third sound output module may include a third piezo speaker, and the third speaker hole 312 may be omitted.

According to various embodiments, a single hole (not separately illustrated) that replaces the microphone hole 309 and the second speaker hole 311 may be provided (or formed).

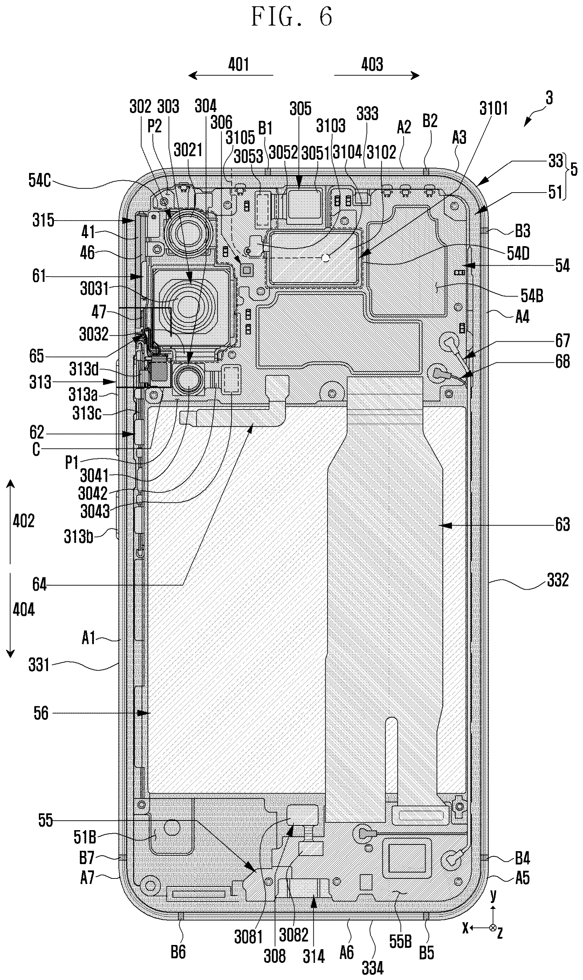

According to an embodiment, the key input module 313 may include a first key 313a positioned in a first key hole of the side 33, a second key 313b positioned in a second key hole of the side 33, and/or a key signal generator 313c (see FIG. 6) positioned inside the electronic device 3. For example, the first key 313a may be positioned in a first key hole of the first side 331, and the second key 313b may be positioned in a second key hole of the first side 331. The key signal generator 313c (see FIG. 6) may generate a first key signal corresponding to pressing or touching of the first key 313a and a second key signal corresponding to pressing or touching of the second key 313b. The position or number of key input modules is not limited to the illustrated example and may vary (not separately illustrated).

According to an embodiment, the connection terminal 314 (e.g., connector) may be positioned inside the electronic device 3 corresponding to a connection terminal hole (e.g., connector hole) of the side 33. A connection terminal hole may be formed, for example, at the fourth side 334. An external electronic device may be electrically connected to the electronic device 3 through the connection terminal 314. The electronic device 3 may receive power and/or data from or transmit power and/or data to the external electronic device through the connection terminal 314. The connection terminal 314 may include, for example, a USB connector or an HDMI connector. The position or number of the connection terminals 314 is not limited to the illustrated example and may vary (not separately illustrated).

According to an embodiment, the electronic device 3 may include another connection terminal (not separately illustrated) for connecting to an external storage medium such as a SIM card (or a universal SIM (USIM) card) or a memory card (e.g., secure digital memory (SD) card).

According to an embodiment, the antenna module 315 may be positioned inside the electronic device 3 corresponding to the side 33. The antenna module 315 may be, for example, positioned inside the electronic device 3 corresponding to the first side 331. The antenna module 315 may be positioned closer to the first side 331 than the second side 332. An electromagnetic wave transmitted (or radiated) from the antenna module 315 may pass through the first side 331 and propagate to the outside of the electronic device 3. An electromagnetic wave transmitted from the outside of the electronic device 3 may pass through the first side 331 and be received (or detected) by the antenna module 315.

According to various embodiments, the antenna module 315 may be the third antenna module 246 of FIG. 2.

According to an embodiment, the antenna module 315 may include an antenna structure 41, a communication circuit (or wireless communication circuit) 44, a power management circuit 45, an electromagnetic shield 46, and/or a connector 47.

According to an embodiment, the antenna structure 41 may include a third printed circuit board 410. The third printed circuit board 410 may include a first surface 411 and a second surface 412 that faces in a direction opposite to that of the first surface 411. The first surface 411 and the second surface 412 may be, for example, substantially parallel.

According to an embodiment, the first surface 411 of the third printed circuit board 410 may face the first side 331.

According to an embodiment, a first direction 401, in which the first surface 411 of the third printed circuit board 410 faces, may be substantially parallel to a direction (e.g., the +x axis direction) from the second side 332 to the first side 331, when viewed from above the front surface 30A of the electronic device 3.

According to an embodiment, the third printed circuit board 410 may include a plurality of pattern layers (not separately illustrated) including a conductive pattern, and a plurality of non-conductive layers (e.g., insulating layers) (not separately illustrated) alternately laminated with the plurality of pattern layers.

According to an embodiment, the third printed circuit board 410 may include a plurality of conductive vias (not separately illustrated). The conductive via may be a conductive hole provided to dispose a connecting wire for electrically connecting conductive patterns of different pattern layers. The conductive via may include, for example, a plated through hole (PTH), a laser via hole (LVH), a buried via hole (BVH), or a stacked via. At least one conductive via may, for example, electrically connect signal line patterns (e.g., patterns of conductive lines utilized as electrical paths) included in different pattern layers as part of a signal line. At least one conductive via may, for example, electrically connect ground planes (or ground areas or ground patterns) included in different pattern layers.

According to an embodiment, the third printed circuit board 410 may include an antenna array 42. The antenna array 42 may be implemented as, for example, some conductive patterns among a plurality of pattern layers included in the third printed circuit board 410. The antenna array 42 may be disposed on the first surface 411 or may be disposed within the third printed circuit board 410 closer to the first surface 411 than the second surface 412. The antenna array 42 may include a plurality of antenna elements 421, 422, 423, 424, and 425. The plurality of antenna elements 421, 422, 423, 424, and 425 may be, for example, the antenna 248 of FIG. 2.

According to an embodiment, the plurality of antenna elements 421, 422, 423, 424, and 425 may have substantially the same shape and be disposed at a constant interval. The plurality of antenna elements 421, 422, 423, 424, and 425 may be disposed in a second direction 402 (e.g., +y-axis direction), when viewed from above the first surface 411 (e.g., when viewed in the -x-axis direction). The second direction 402 may be a direction (e.g., +y-axis direction) from the fourth side 334 to the third side 333, when viewed from above the front surface 30A of the electronic device 3.

According to an embodiment, when viewed from above the first surface 411 of the third printed circuit board 410, the plurality of antenna elements 421, 422, 423, 424, and 425 may be substantially rectangular. The shapes of the plurality of antenna elements 421, 422, 423, 424, and 425 are not limited thereto and may vary. The plurality of antenna elements 521, 522, 523, 524, and 525 may be provided in, for example, a square or a triangle and various other polygonal shapes (not separately illustrated). The plurality of antenna elements 421, 422, 423, 424, and 425 may be provided (or formed) in, for example, a circular or oval shape (not separately illustrated).

According to various embodiments, the number or position of antenna elements included in the antenna array 42 is not limited to the illustrated embodiment and may vary (not separately illustrated).

According to various embodiments, the number or position of the antenna arrays 42 is not limited to the illustrated embodiment and may vary (not separately illustrated).

According to an embodiment, the third printed circuit board 410 may include a ground plane 43 that operates as an antenna ground. The ground plane 43 may contribute to securing an antenna radiation performance (or radio transmission and reception performance or communication performance) and/or coverage with respect to the plurality of antenna elements 421, 422, 423, 424, and 425. The ground plane 43 may reduce electromagnetic interference (EMI) (or signal loss) with respect to the plurality of antenna elements 421, 422, 423, 424, and 425.

According to an embodiment, the ground plane 43 may be disposed closer to the second surface 412 of the third printed circuit board 410 than the antenna array 42. When viewed from above the first surface 411 of the third printed circuit board 410, the antenna array 42 may at least partially overlap with the ground plane 43. For example, the antenna array 42 may be included in a first pattern layer (not separately illustrated) of the third printed circuit board 410, and the ground plane 43 may be included in a second pattern layer (not separately illustrated) closer to the second surface 412 than the first pattern layer.

According to an embodiment, the antenna structure 41 may operate as a patch antenna. When the communication circuit 44 provides (or feeds) an electromagnetic signal (or a wireless signal, an RF signal, or a radiated current) to the plurality of antenna elements 421, 422, 423, 424, and 425, the antenna structure 41 may operate as a resonator (e.g., patch antenna) because the plurality of antenna elements 421, 422, 423, 424, and 425 act as radiating elements while resonating with the ground plane 43. The antenna structure 41 may include, for example, a first resonator (e.g., a first patch antenna, a first patch resonator, a first patch resonator, or a first radiator) including a first antenna element 421, a second resonator (e.g., a second patch antenna, a second patch resonator, a second patch resonator, or a second radiator) including a second antenna element 422, a third resonator (e.g., a third patch antenna, a third patch resonator, a third patch resonator, or a third radiator) including a third antenna element 423, a fourth resonator (e.g., a fourth patch antenna, a fourth patch resonator, a fourth patch resonator, or a fourth radiator) including a fourth antenna element 424, and/or a fifth resonator (e.g., a fifth patch antenna, a fifth patch resonator, a fifth patch resonator, or a fifth radiator) including a fifth antenna element 424. The plurality of antenna elements 421, 422, 423, 424, and 425 may be defined or interpreted as a plurality of patches.

According to an embodiment, the plurality of antenna elements 421, 422, 423, 424, and 425 may be included in a single pattern layer (not separately illustrated) among the plurality of pattern layers included in the third printed circuit board 410 (e.g., single-layer patch structure). For example, the plurality of antenna elements 421, 422, 423, 424, and 425 may be directly fed from the communication circuit 44.

According to various embodiments, the third printed circuit board 410 may further include a plurality of dummy antenna elements (e.g., dummy patches) (not separately illustrated) (e.g., stacked patch structure). When viewed from above the first surface 411 of the third printed circuit board 410, the plurality of dummy antenna elements may be positioned to overlap one-to-one with the plurality of antenna elements 421, 422, 423, 424, and 425 and be electrically floating. One pattern layer including the plurality of dummy antenna elements may be positioned closer to the first surface 411 than another pattern layer including the plurality of antenna elements 421, 422, 423, 424, and 425. The communication circuit 44 may provide (or feed) an electromagnetic signal (or a radio signal, an RF signal, or a radiated current) to a plurality of antenna elements 421, 422, 423, 424, and 525, and the dummy antenna elements may be indirectly fed from the plurality of antenna elements 421, 422, 423, 424, and 425. The plurality of antenna elements 421, 422, 423, 424, and 425 may be defined or interpreted as a plurality of feeding antenna elements. The plurality of dummy antenna elements may be electromagnetically coupled to the plurality of antenna elements 421, 422, 423, 424, and 425 to operate as part of a radiator and adjust radiation characteristics. The plurality of dummy antenna elements may, for example, shift a resonant frequency of the antenna module 315 to a designated frequency or by a designated amount. The plurality of dummy antenna elements may, for example, expand a bandwidth for transmitting or receiving electromagnetic waves via the antenna module 315 or may form different frequency bands (e.g., multi-bands). The plurality of dummy antenna elements may, for example, reduce electromagnetic noise to improve an antenna performance.

According to various embodiments, when viewed from above the first surface 411, the third printed circuit board 410 may further include a plurality of feeding antenna elements (not separately illustrated) that at least partially overlap with the plurality of antenna elements 421, 422, 423, 424, and 425 and that are physically separated from the plurality of antenna elements 421, 422, 423, 424, and 425 (e.g., stacked patch structure). One pattern layer including the plurality of antenna elements 421, 422, 423, 424, and 425 may be positioned closer to the first surface 411 than another pattern layer including the plurality of feeding antenna elements. The communication circuit 44 may provide (or feed) an electromagnetic signal (or a radio signal, an RF signal, or a radiated current) to a plurality of feeding antenna elements, and the plurality of antenna elements 421, 422, 423, 424, and 425 may be indirectly fed from the plurality of feeding antenna elements. The plurality of antenna elements 421, 422, 423, 424, and 425 may be defined or interpreted as a plurality of dummy antenna elements.

According to an embodiment, the communication circuit 44 may be disposed on the second surface 412 of the third printed circuit board 410 via a conductive adhesive material (or conductive bonding material) (not separately illustrated) such as solder. The communication circuit 44 may be electrically connected to the plurality of antenna elements 421, 422, 423, 424, and 425 via wires (or electrical paths) (not separately illustrated) included in the third printed circuit board 410.

According to an embodiment, the communication circuit 44 may include a radio frequency integrate circuit (RFIC). The communication circuit 44 may be, for example, the third RFIC 226 of FIG. 2.

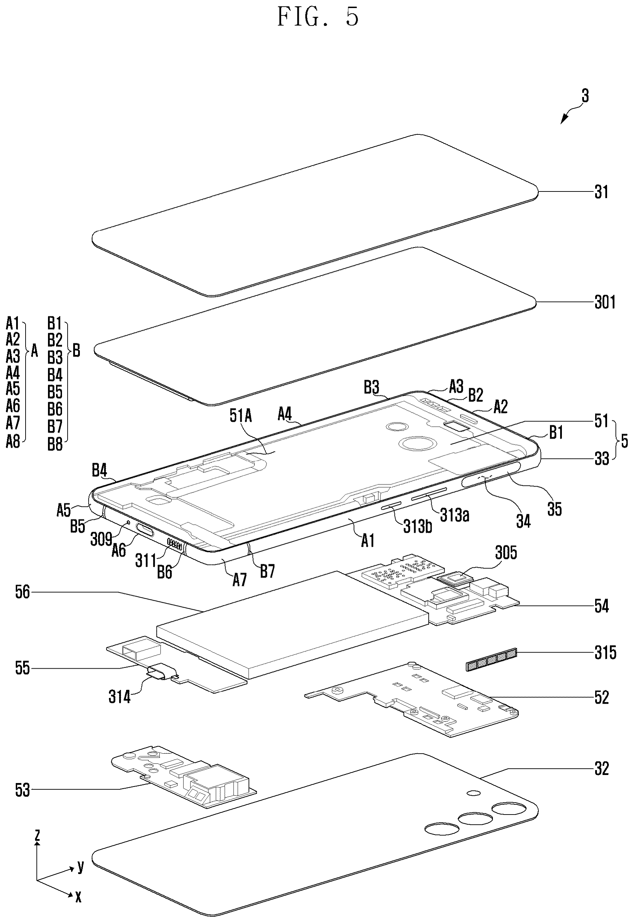

According to various embodiments, although not separately illustrated, the communication circuit 44 may be disposed on a printed circuit board different from the third printed circuit board 410. For example, the communication circuit 44 may be omitted from the antenna module 315. The different printed circuit board may be, for example, the first printed circuit board 541 of FIG. 5 on which components such as the processor 120, the memory 130, or the communication module 190 of FIG. 1 are disposed.

According to an embodiment, the communication circuit 44 may up-convert or down-convert a frequency of a transmitted or received signal. For example, the communication circuit 44 may receive an intermediate frequency (IF) signal from a wireless communication circuit (e.g., the wireless communication module 192 of FIG. 1) disposed on another printed circuit board (e.g., the first printed circuit board 541 of FIG. 5) and up-convert the received IF signal to a radio frequency (RF) signal (e.g., millimeter wave). According to an embodiment, the communication circuit 44 may down-convert an RF signal received through the antenna array 42 to an IF signal, and the IF signal may be provided to a wireless communication circuit (e.g., the wireless communication module 192 of FIG. 1) disposed on another printed circuit board (e.g., the first printed circuit board 541 of FIG. 5).

According to an embodiment, the communication circuit 44 may be configured to transmit and/or receive signals of substantially the same frequency band (or frequency) via the plurality of antenna elements 421, 422, 423, 424, and 425.

According to an embodiment, the communication circuit 44 may be configured to transmit and/or receive signals in at least a portion of a frequency band from about 3 GHz to about 100 GHz via the plurality of antenna elements 421, 422, 423, 424, and 425.

According to an embodiment, although not separately illustrated, the third printed circuit board 410 may include a first electrical path (or first transmission line or first feeding line) corresponding to the first antenna element 421, a second electrical path (or second transmission line or second feeding line) corresponding to the second antenna element 422, a third electrical path (or third transmission line or third feeding line) corresponding to the third antenna element 423, a fourth electrical path (or fourth transmission line or fourth feeding line) corresponding to the fourth antenna element 424, and/or a fifth electrical path (or fifth transmission line or fifth feeding line) corresponding to the fifth antenna element 425. The communication circuit 44 may provide (or feed) an electromagnetic signal (or a radio signal, an RF signal, or a radiated current) to the first antenna element 421 via the first electrical path. The communication circuit 44 may provide (or feed) an electromagnetic signal to the second antenna element 422 via the second electrical path. The communication circuit 44 may provide (or feed) an electromagnetic signal to the third antenna element 423 via the third electrical path. The communication circuit 44 may provide (or feed) an electromagnetic signal to the fourth antenna element 424 via the fourth electrical path. The communication circuit 44 may provide (or feed) an electromagnetic signal to the fifth antenna element 425 via the fifth electrical path. The first electrical path, the second electrical path, the third electrical path, the fourth electrical path, and/or the fifth electrical path may include, for example, a combination of signal line patterns included in different pattern layers and at least one conductive via electrically connecting the signal line patterns.

According to an embodiment, shapes of the plurality of antenna elements 421, 422, 423, 424, and 425 and feeding points (e.g., points or portions in which electromagnetic signals are transmitted) of the plurality of antenna elements 421, 422, 423, 424, and 425 may be variously provided so as to radiate at least one linear polarized wave corresponding to at least one selected or designated frequency band. For example, the plurality of antenna elements 421, 422, 423, 424, and 425 may be configured to radiate a first linear polarized wave and a second linear polarized wave, respectively, having polarization directions perpendicular to each other (e.g., a direction in which an electric field oscillates or a direction parallel to a vector of an electric field) when fed.

According to various embodiments, shapes of the plurality of antenna elements 421, 422, 423, 424, and 425 and feed points of the plurality of antenna elements 421, 422, 423, 424, and 425 may be configured to radiate circularly polarized waves corresponding to at least one selected or designated frequency band.

According to an embodiment, the electronic device 3 may include a beamforming system (or beamforming circuit) for the antenna module 315. The beamforming system may enable reception of stronger signals from a desired direction, transmission of signals toward a desired direction, or suppression of signals incoming from undesired directions. The beamforming system included in the communication circuit 44 may control the phase or amplitude of an electromagnetic signal (or a radio signal, an RF signal, or a radiated current) to adjust a beam pattern (e.g., a shape and direction of the beam).

According to an embodiment, the processor (e.g., the processor 120 of FIG. 1) may determine a phase of an electromagnetic signal (or wireless signal, RF signal, or radiated current) provided to (or fed to) the plurality of antenna elements 421, 422, 423, 424, and 425 based on codebook information on beamforming stored in the memory (e.g., the memory 130 of FIG. 1) according to a frequency (or frequency band) used by an application (or program). The communication circuit 44 of the antenna module 315 may adjust the phase of the electromagnetic signal provided to (or fed to) the plurality of antenna elements 421, 422, 423, 424, and 425 under the control of the processor. The communication circuit 44 of the antenna module 315 may efficiently control (e.g., allocate or dispose) a plurality of beams through a plurality of resonators (or radiating portions) (e.g., a first resonator, a second resonator, a third resonator, a fourth resonator, and a fifth resonator) included in the antenna module 315 under the control of the processor.

According to an embodiment, a radiation field from a first resonator including a first antenna element 421, a radiation field from a second resonator including a second antenna element 422, a radiation field from a third resonator including a third antenna element 423, a radiation field from a fourth resonator including a fourth antenna element 424, or a radiation field from a fifth resonator including a fifth antenna element 425 may substantially provide a beam pattern that radiates or concentrates electromagnetic energy (or wave energy) more strongly in a first direction 401 in which the first surface 411 of the third printed circuit board 410 faces.

According to an embodiment, interference (e.g., constructive interference and/or detailed interference) among a radiation field (or beam pattern) from a first resonator including a first antenna element 421, a radiation field (or beam pattern) from a second resonator including a second antenna element 422, a radiation field (or beam pattern) from a third resonator including a third antenna element 423, a radiation field (or beam pattern) from a fourth resonator including a fourth antenna element 424, and a radiation field (or beam pattern) from a fifth resonator including a fifth antenna element 425 may substantially radiate or concentrate electromagnetic wave energy (or wave energy) more strongly in a first direction 401 in which the first surface 411 of the third printed circuit board 410 faces.

According to an embodiment, the power management circuit 45 may be disposed on the second surface 412 of the third printed circuit board 410 via a conductive adhesive material (or conductive bonding material) (not separately illustrated), such as solder. The power management circuit 45 may be electrically connected to the communication circuit 44 or various other components (e.g., passive components) disposed on the third printed circuit board 410 via wires (or electrical paths) (not separately illustrated) included in the third printed circuit board 410.

According to an embodiment, the power management circuit 45 may include a power management integrated circuit (PMIC).

According to various embodiments, the power management circuit 45 may be disposed on a printed circuit board (e.g., the first printed circuit board 541 of FIG. 5) different from the third printed circuit board 410. For example, the power management circuit 45 may be omitted from the antenna module 315.

According to an embodiment, the electromagnetic shield 46 may be disposed on the second surface 412 so as to surround the communication circuit 44, the power management circuit 45, or other various electrical elements disposed on the second surface 412. The electromagnetic shield 46 may be electrically connected to the ground plane 43. A combination of the electromagnetic shield 46 and the ground plane 43 may be defined or interpreted as a ground structure of the antenna module 315. The ground structure may reduce electromagnetic interference (e.g., electromagnetic noise) with respect to a plurality of electrical elements, such as the communication circuit 44 and the power management circuit 45. The electromagnetic shield 46 may include a conductive member, such as, for example, a shield can. The electromagnetic shield 46 may include, for example, a protective member such as urethane resin, and a conductive paint, such as electromagnetic interference (EMI) paint, applied to the outer surface of the protective member. The electromagnetic shield 46 may be provided (or formed) as, for example, various shielding sheets.

According to an embodiment, the connector 47 may be disposed on the second surface 412 of the third printed circuit board 410 via a conductive adhesive material (or conductive bonding material) (not separately illustrated) such as solder.

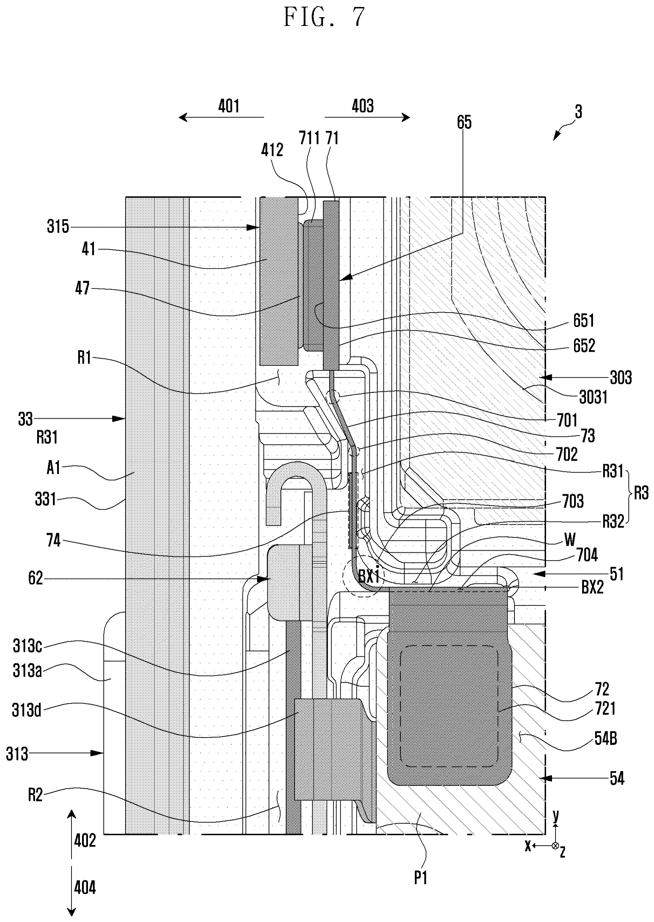

According to an embodiment, the antenna module 315 may be electrically connected to another printed circuit board (e.g., the first printed circuit board 54 of FIG. 5) via an electrical connection member (not separately illustrated), such as a flexible printed circuit board (FPCB) (e.g., a third flexible printed circuit board 65 of FIG. 7). One end of the electrical connection member may be electrically connected to a connector (e.g., FPCB connector) 47 disposed on the second surface 412 of the third printed circuit board 410, and the other end of the electrical connection member may be electrically connected to a connector disposed on another printed circuit board (e.g., the first printed circuit board 54 of FIG. 5).

According to various embodiments, the antenna module 315 may include a frequency tuning circuit (or matching circuit) (not separately illustrated) disposed on the third printed circuit board 410. The frequency tuning circuit may include, for example, a tuner or a passive element. The frequency tuning circuit may perform impedance matching, or shift a resonant frequency to a designated frequency or by a designated amount.

According to an embodiment, the electronic device 3 may include a radio frequency (RF) window area (or electromagnetic wave transparent area) (not separately illustrated) corresponding to the antenna module 315. An electromagnetic wave transmitted (or radiated) from the antenna module 315 may pass through the RF window area and propagate to the outside of the electronic device 3. An electromagnetic wave transmitted from the outside of the electronic device 3 may pass through the RF window area to be received (or detected) by the antenna module 315. The RF window area may be positioned to correspond at least partially to the coverage (or beam coverage) (e.g., communication range) of the antenna module 315.

According to an embodiment, when viewed from above the first surface 411 of the third printed circuit board 410, the RF window area may overlap at least partially with the first surface 411.

According to an embodiment, when viewed from above the first surface 411 of the third printed circuit board 410, the RF window area may include a portion of the first side 331 that at least partially overlaps with the first surface 411.

According to an embodiment, the RF window area may include a dielectric of non-conductive material, an air gap, or a combination thereof. The air gap may be defined or interpreted as a dielectric having a permittivity of air.

According to an embodiment, the RF window area may be implemented to reduce an influence on an antenna radiation performance (or radio transmission and reception performance) and/or coverage (or beam coverage) of the antenna module 315. The RF window area may have a permittivity that may reduce an electromagnetic influence on the antenna module 315. The RF window area may have a permittivity that may reduce degradation of the antenna radiation performance of the antenna module 315, or a permittivity that does not degrade the antenna radiation performance below a critical level. The RF window area may have a permittivity that affects the coverage of the antenna module 315 only within the intended range, or a permittivity that does not substantially affect the coverage of the antenna module 315.

According to an embodiment, the permittivity of the RF window area may be a value (e.g., low permittivity) that may reduce the difference with that of air.

According to various embodiments, the RF window area may be implemented to include, or operate as, a dielectric lens (or electromagnetic lens). The dielectric lens may focus and/or diverge electromagnetic waves, similar to how an optical lens refracts light waves. The dielectric lens may secure or improve an antenna radiation performance and/or coverage of the antenna module 315.

According to an embodiment, the first outer metal A1 included in the side metal A of the side 33 may include a radiation hole (or opening) 34 provided corresponding to the antenna module 315. An electromagnetic wave transmitted (or radiated) from the antenna module 315 may pass through the radiation hole 34 and propagate to the outside of the electronic device 3. An electromagnetic wave transmitted from the outside of the electronic device 3 may pass through the radiation hole 34 and be received (or detected) by the antenna module 315.

According to an embodiment, the radiation hole 34 of the first outer metal A1 may reduce an influence of the first outer metal A on electromagnetic waves radiated from the antenna module 315, compared to a comparative example in which the radiation hole 34 is omitted, thereby reducing deformation (e.g., distortion) of the beam pattern.

Hereinafter, 'comparative examples' mentioned in the disclosure are only presented for comparison with the embodiments of the disclosure, and do not have a prior status with respect to various embodiments of the disclosure.

According to an embodiment, the first side 331 may include a non-conductive portion 35 of a non-conductive material (e.g., polymer) disposed in the radiation hole 34 of the first outer metal A1.

According to an embodiment, when viewed from above the first surface 411 of the third printed circuit board 410, the non-conductive portion 35 may overlap with the antenna array 42. The non-conductive portion 35 may be included in an RF window area corresponding to the antenna module 315.

According to an embodiment, an electromagnetic wave transmitted (or radiated) from the antenna module 315 may pass through a non-conductive portion 35 and propagate to the outside of the electronic device 3. An electromagnetic wave transmitted from the outside of the electronic device 3 may pass through a non-conductive portion 35 and be received (or detected) by the antenna module 315.

According to an embodiment, the radiation hole 34 provided (or formed) in the first outer metal A1 corresponding to the antenna module 315 may be a through hole. The through hole may be defined or interpreted as an opening entirely surrounded by a conductive area. The shape of the radiation hole 34 is not limited to the illustrated example and may vary. For example, the radiation hole 34 may be implemented as a notch-shaped opening (not separately illustrated).

According to an embodiment, the non-conductive portion 35 may have a permittivity that may reduce an electromagnetic influence on an antenna radiation performance (or radio transmission and reception performance) and/or coverage (or beam coverage) of the antenna module 315.

According to an embodiment, the permittivity of the non-conductive portion 35 may be a value (e.g., low permittivity) that may reduce the difference with that of air.

According to an embodiment, the non-conductive portion 35 may provide a portion of the side surface 30C of the electronic device 3. A partial surface area of the side surface 30C of the electronic device 3 provided by the non-conductive portion 35 may be smoothly connected to a partial surface area of the side surface 30C of the electronic device 3 provided by the first outer metal A1 without a substantial height difference.

According to various embodiments, the side 33 may further include a coating layer (not separately illustrated) of various colors or textures that substantially provide the side surface 30C. The coating layer may reduce or prevent the non-conductive portion 35 and the first outer metal A1 from being visually distinguishable.

According to various embodiments, in order to reduce or prevent the non-conductive portion 35 and the first outer metal A1 from being visually distinguishable, the non-conductive portion 35 and the first outer metal A1 may have substantially the same color.

According to an embodiment, the radiation hole 34, the first key hole, and the second key hole of the first outer metal A1 may be disposed in a direction (e.g., the -y axis direction) from the third side 333 to the fourth side 334. The first key hole may be positioned between the radiation hole 34 and the second key hole.

According to various embodiments, although not separately illustrated, the antenna module 315 may be positioned corresponding to the second side 332, the third side 333, or the fourth side 334.

According to various embodiments, although not separately illustrated, another antenna module substantially identical to or at least partially similar to the antenna module 315 may be positioned corresponding to the first side 331, the second side 332, the third side 333, or the fourth side 334.

The electronic device 3 may further include various components according to a provision form thereof. These components may be modified in various ways according to the convergence trend of the electronic device 3 and thus cannot all be listed, but components equivalent to those mentioned above may also be additionally included in the electronic device 3. In various embodiments, specific components may be excluded from the above-mentioned components or replaced with other components according to a provision form thereof.

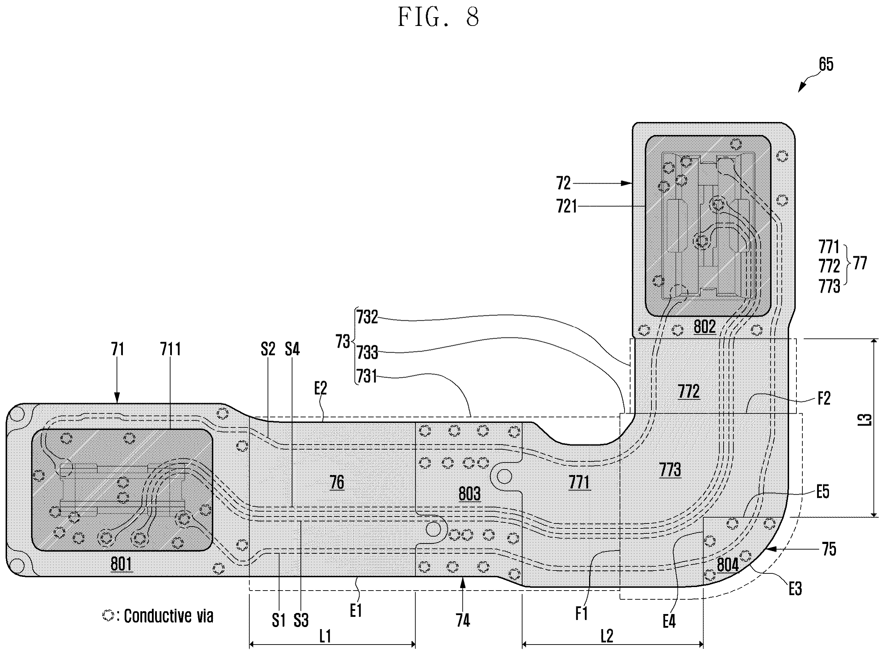

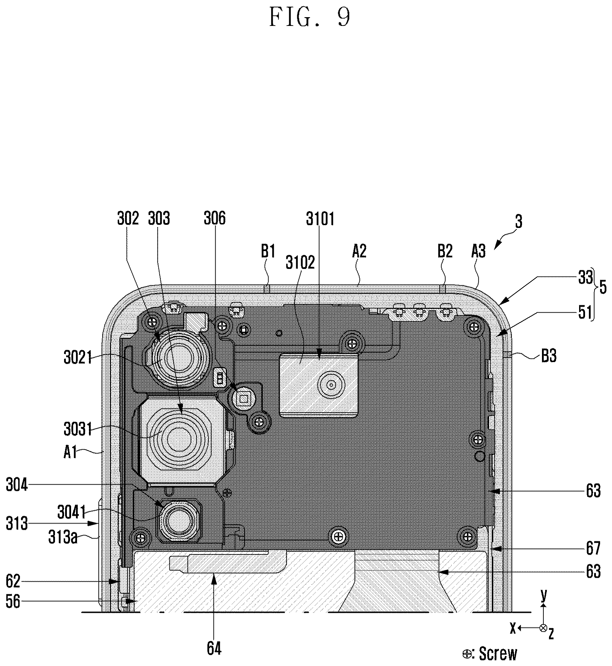

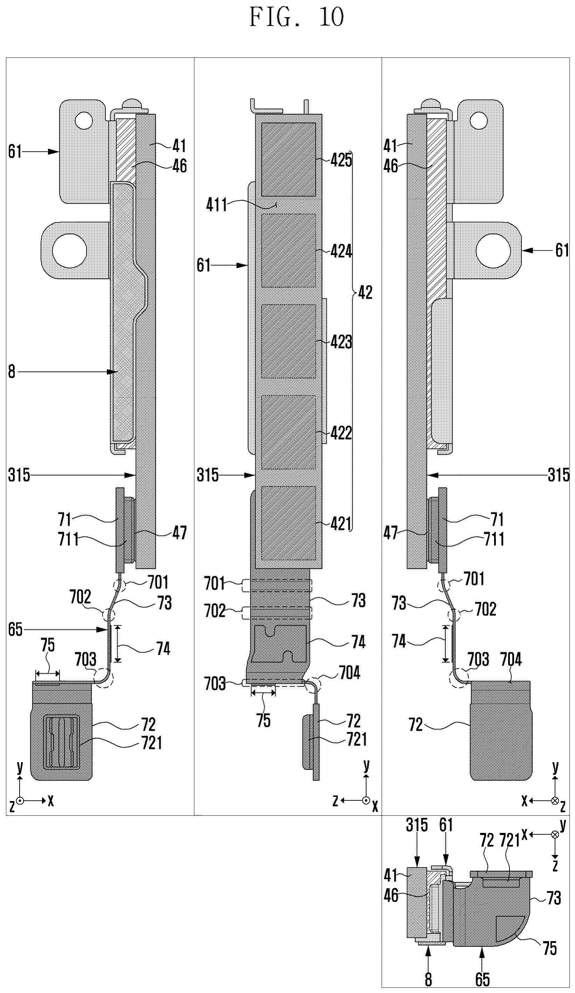

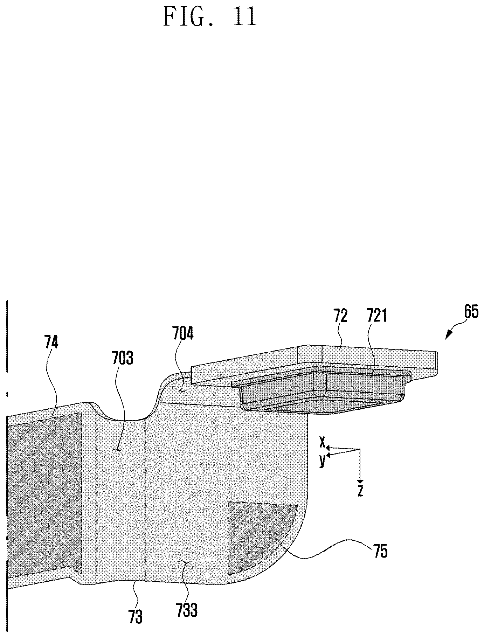

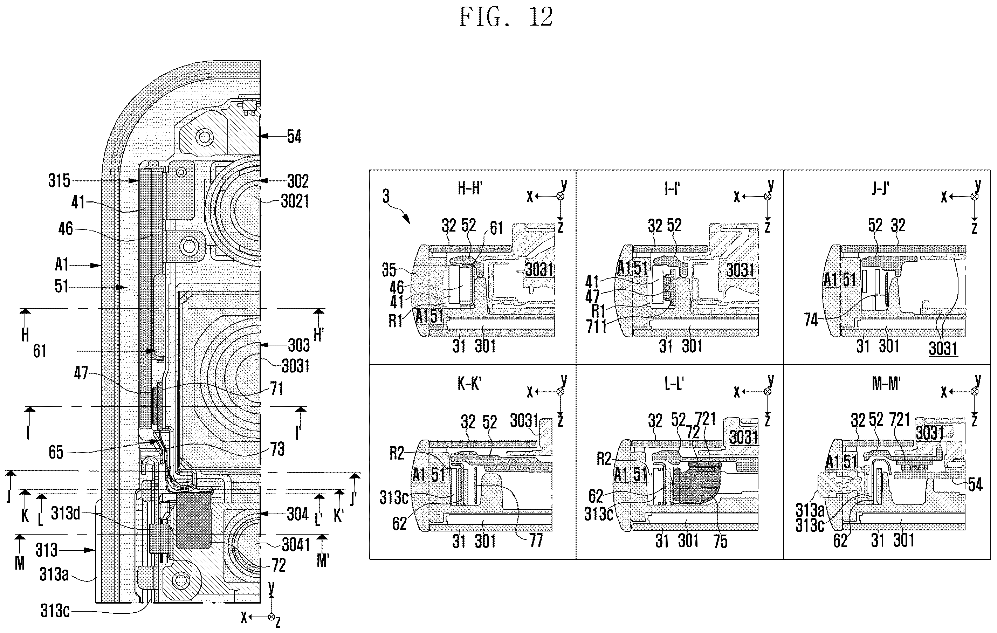

FIG. 5 is an exploded perspective view illustrating an electronic device 3 according to an embodiment of the disclosure. FIG. 6 is a diagram illustrating a portion of an electronic device 3 according to an embodiment of the disclosure. FIG. 7 is an enlarged view illustrating an area 'C' of FIG. 6 according to an embodiment of the disclosure. FIG. 8 is a diagram illustrating a third flexible printed circuit board 65 in an unfolded state according to an embodiment of the disclosure. FIG. 9 is a diagram illustrating a portion of an electronic device 3 according to an embodiment of the disclosure. FIG. 10 is a diagram illustrating a combination of an antenna module 315, a first bracket 61, and a third flexible printed circuit board 65 according to an embodiment of the disclosure. FIG. 11 is a perspective view illustrating a third flexible printed circuit board 65 according to an embodiment of the disclosure. FIG. 12 is a cross-sectional view illustrating a portion of an electronic device 3 according to an embodiment of the disclosure, and illustrating an electronic device 3 taken along lines HH', II', JJ', KK', LL', and MM'.

With reference to FIGS. 5, 6, 7, 8, 9, 10, 11, and 12, the electronic device 3 may include a front plate 31, a rear plate 32, a frame (or frame structure or framework) 5, a second support part 52, a third support part 53, a display module 301, a first camera module 302, a second camera module 303, a third camera module 304, a fourth camera module 305, a light emitting module 306, a second sensor module 308, a first sound output module 3101, a key input module 313, a connection terminal 314, an antenna module 315, a first printed circuit board 54, a second printed circuit board 55, a battery 56, a first bracket 61, a second bracket 62, a first flexible printed circuit 63, a second flexible printed circuit board 64, a third flexible printed circuit board 65, a first cable 66, and/or a second cable 67. Although not separately illustrated, the electronic device 3 may omit some of the above components or additionally include other components.

According to an embodiment, the frame 5 may include a first support part (or a first support body, a first support member, a first support structure, or a bracket) 51 and a side 33 connected to (or extended from) the first support part 51. The first support part 51 may be positioned at least partially between the front plate 31 and the rear plate 32. The first support part 51 may include a metallic material and/or a non-metallic material (e.g., polymer). The side 33 may be provided (or formed) as a combination of an outer metal A and an outer non-metal B. A combination (e.g., the frame 5) of the first support part 51 and the side 33 may be a structural component, which may dispose and/or support a plurality of electrical elements (or functional components) and/or one or more other structural elements.

According to various embodiments, the first support part 51 may be interpreted as a part of the housing 30 (see FIG. 3).

According to an embodiment, the first support part 51 may include a first support surface 51A and a second support surface 51B. The first support surface 51A may face the front plate 31. The second support surface 51B may be disposed at the side opposite to that of the first support surface 51A and face the rear plate 32.

According to an embodiment, the first support surface 51A of the first support part 51 may include (or provide) a front seating portion for stably disposing or supporting one or more components. The front seating portion may be provided as a combination of surface areas of different heights.

According to an embodiment, the second support surface 51B of the first support part 51 may include (or provide) a rear seating portion for stably disposing or supporting a plurality of components. The rear seating portion may be provided as a combination of surface areas of different heights.

According to an embodiment, the first support part 51 may be provided as a combination of an inner metal (not separately illustrated) and an inner non-metal (not separately illustrated). The inner metal may be provided (or formed) as a combination of one or more conductive portions. The inner non-metal may be provided (or formed) as a combination of one or more non-conductive portions.

According to an embodiment, the first support surface 51A and/or the second support surface 51B of the first support part 51 may be provided (or formed) as a combination of an inner metal (not separately illustrated) and an inner non-metal (not separately illustrated). Some surface area of the first support surface 51A or the second support surface 51B may include a conductive surface area provided by the inner metal, and other surface areas of the first support surface 51A or the second support surface 51B may include a non-conductive surface area provided by the inner non-metal.

According to an embodiment, the inner metal (not separately illustrated) of the first support part 51 may be connected to the outer metal A of the side 33.

According to an embodiment, the first metal material included in the inner metal (not separately illustrated) of the first support part 51 may be different from the second metal material included in the outer metal A of the side 33.

According to various embodiments, the first metal material included in the inner metal (not separately illustrated) of the first support part 51 may be identical to the second metal material included in the outer metal A of the side 33.

According to an embodiment, an integrated or single metal (or metal structure) (e.g., single continuous structure or complete structure) including an inner metal (not separately illustrated) of the first support part 51 and the outer metal A of the side 33 may be provided (or formed). Some of the integrated or single metal may be included in the first support part 51, and other portions of the integrated or single metal may be included in the side 33.

According to an embodiment, the inner non-metal (not separately illustrated) of the first support part 51 may be at least partially connected to the outer non-metal B of the side 33.

According to an embodiment, a first non-metallic material included in the inner non-metal (not separately illustrated) of the first support part 51 may be the same as or different from a second non-metallic material included in the outer non-metal B of the side 33.

According to an embodiment, an integrated or single non-metal (or non-metal structure) (e.g., single continuous structure or complete structure) that replaces the inner non-metal (not separately illustrated) of the first support part 51 and the outer non-metal B of the side 33 may be provided (or formed). Some of the integrated or single non-metal may be included in the first support part 51 and other portions of the integrated or single non-metal may be included in the side 33.

According to an embodiment, the electronic device 3 may include a first space (not separately illustrated) between the first support part 51 (or the first support surface 51A) and the front plate 31. The display module 301 may be disposed on the first support surface 51A or may be supported by the first support surface 51A in the first space.

According to an embodiment, the display module 301 may be coupled to the front plate 31 via an optically transparent adhesive member (or optically transparent bonding material) (not separately illustrated) such as an optical clear adhesive (OCA), an optical clear resin (OCR), or a super view resin (SVR).

According to an embodiment, the display module 301 may be electrically connected to the first printed circuit board 54 via a flexible printed circuit board (not separately illustrated) passing through an opening (e.g., through hole) provided (or formed) in the first support part 51.

According to an embodiment, the electronic device 3 may include a second space (not separately illustrated) between the first support part 51 (or the second support surface 51B) and the rear plate 32. The first camera module 302, the second camera module 303, the third camera module 304, the fourth camera module 305, the light emitting module 306, the second sensor module 308, the first sound output module 3101, the key input module 313, the connection terminal 314, the antenna module 315, the first printed circuit board 54, the second printed circuit board 55, the battery 56, the first bracket 61, the second bracket 62, the first flexible printed circuit board 63, the second flexible printed circuit board 64, the third flexible printed circuit board 65, the first cable 66, and/or the second cable 67 may be disposed on the second support surface 51B or may be supported by the second support surface 51B in a second space.

According to an embodiment, the first printed circuit board 54 may be disposed on the second support surface 51B of the first support part 51 via mechanical fastening such as a screw fastening. The first printed circuit board 54 may include a first substrate surface (not separately illustrated) facing the first support part 51 and a second substrate surface 54B facing in a direction opposite to that of the first substrate surface. A plurality of electrical elements, such as the processor (e.g., the processor 120 of FIG. 1), the memory (e.g., the memory 130 of FIG. 1), the power management module (e.g., the power management module 188 of FIG. 1), the communication module (e.g., the communication module 190 of FIG. 1), the subscriber identification module (e.g., the subscriber identification module 196), and the light emitting module 306, may be disposed on the first printed circuit board 54.

According to an embodiment, the second printed circuit board 55 may be disposed on the second support surface 51B of the first support part 51 via mechanical fastening such as a screw fastening. The second printed circuit board 55 may include a third substrate surface (not separately illustrated) facing the first support part 51 and a fourth substrate surface 55B facing in a direction opposite to that of the third substrate surface. A plurality of electrical elements, such as connection terminals 314, may be disposed on the second printed circuit board 55.

According to an embodiment, the battery 56 may be disposed on (or coupled to) the second support surface 51B of the first support part 51 via mechanical fastening such as screw fastening or bonding using an adhesive material (or bonding material). The battery 56 may be electrically connected to the first printed circuit board 54 via the second flexible printed circuit board 64.

According to an embodiment, when viewed from above the rear plate 32 (e.g., when viewed in the +z-axis direction), the first printed circuit board 54 and the second printed circuit board 55 may be spaced apart from each other with the battery 56 interposed therebetween. When viewed from above the rear plate 32, the first printed circuit board 54 may be positioned at least partially between the third side 333 and the battery 56. When viewed from above the rear plate 32, the second printed circuit board 55 may be positioned at least partially between the fourth side 334 and the battery 56.

According to various embodiments, although not separately illustrated, the first printed circuit board 54 or the second printed circuit board 55 may include a primary printed circuit board (or main printed circuit board), a secondary printed circuit board (or sub printed circuit board), and/or an interposer substrate. When viewed from above the rear plate 32, the primary printed circuit board and the secondary printed circuit board may at least partially overlap. The interposer substrate may be disposed between the primary printed circuit board and the secondary printed circuit board and electrically connect the primary printed circuit board and the secondary printed circuit board.

According to an embodiment, the first flexible printed circuit board 63 may electrically connect the first printed circuit board 54 and the second printed circuit board 55.

According to an embodiment, when viewed from above the rear plate 32, the first flexible printed circuit board 63 may cover a portion of the battery 56 and be disposed across the battery 56.

According to an embodiment, the first cable 66 (e.g., first coaxial cable) and/or the second cable 67 (e.g., second coaxial cable) may electrically connect the first printed circuit board 54 and the second printed circuit board 55.

According to an embodiment, the first cable 66 and/or the second cable 67 may be extended between the battery 56 and the second side 332. The first support part 51 may include a recess (not separately illustrated) in which the first cable 66 and/or the second cable 67 are/is interposed between the battery 56 and the second side 332.

According to an embodiment, the first cable 66 and/or the second cable 67 may be an FRC (flexible RF cable or flexible PCB type RF cable).

According to an embodiment, the first camera module 302, the second camera module 303, the third camera module 304, and/or the fourth camera module 305 may be positioned closer to the third side 333 than the battery 56, when viewed from above the rear plate 32.

According to an embodiment, the first camera module 302 may include a camera unit 3021 and a flexible printed circuit board (not separately illustrated) extended from or connected to the camera unit 3021. Although not separately illustrated, the camera unit 3021 may include one or more lenses, an image sensor(s), and/or an image signal processor, and a circuit board on which they are disposed. The flexible printed circuit board may be electrically connected to the circuit board of the camera unit 3021. For example, an integrated or single circuit board that replaces the circuit board of the camera unit 3021 and the flexible printed circuit board may be implemented. The camera unit 3021 may be electrically connected to the first printed circuit board 54 through a connection between a connector (not separately illustrated) disposed on a flexible printed circuit board and a connector (not separately illustrated) disposed on the first printed circuit board 54.

According to an embodiment, the camera unit 3021 of the first camera module 302 may be disposed on or coupled to the second support surface 51B of the first support part 51. The first support part 51 may include a camera seating portion that stably supports the camera unit 3021.

According to an embodiment, a flexible printed circuit board (not separately illustrated) of the first camera module 302 may be extended between the first support part 51 and the first printed circuit board 54. A connector (not separately illustrated) disposed on the flexible printed circuit board of the first camera module 302 may be electrically connected to a connector (not separately illustrated) disposed on a first substrate surface (not separately illustrated) (e.g., a surface facing the first support part 51) of the first printed circuit board 54.

According to an embodiment, the second camera module 303 may be substantially identical to or at least partially similar to the first camera module 302 and be electrically connected to the first printed circuit board 54. The second camera module 303 may include a camera unit 3031 and a flexible printed circuit board 3032.

According to an embodiment, the camera unit 3031 of the second camera module 303 may be disposed on or coupled to the second support surface 51B of the first support part 51. The first support part 51 may include a camera seating portion that stably supports the camera unit 3031.

According to an embodiment, the flexible printed circuit board 3032 of the second camera module 303 may be extended between the first support part 51 and the first printed circuit board 54. A connector (not separately illustrated) disposed on the flexible printed circuit board 3032 of the second camera module 303 may be electrically connected to a connector (not separately illustrated) disposed on the first substrate surface (not separately illustrated) (e.g., a surface facing the first support part 51) of the first printed circuit board 54.

According to an embodiment, the third camera module 304 may be substantially identical to or at least partially similar to the first camera module 302 and be electrically connected to the first printed circuit board 54. The third camera module 304 may include a camera unit 3041 and a flexible printed circuit board 3042.

According to an embodiment, the camera unit 3041 of the third camera module 304 may be positioned between the first printed circuit board 54 and the rear plate 32. The camera unit 3041 of the third camera module 304 may be disposed on (or coupled) to the first printed circuit board 54 via, for example, an adhesive material (or bonding material). A connector 3043 disposed on the flexible printed circuit board 3042 of the third camera module 304 may be connected to a connector (not separately illustrated) disposed on the second substrate surface 54B (e.g., a surface facing the rear plate 32) of the first printed circuit board 54.

According to an embodiment, the fourth camera module 305 may be substantially identical to or at least partially similar to the first camera module 302 and be electrically connected to the first printed circuit board 54. The fourth camera module 305 may include a camera unit 3051 and a flexible printed circuit board 3052.

According to an embodiment, the camera unit 3051 of the fourth camera module 305 may be disposed on or coupled to the second support surface 51B of the first support part 51. The first support part 51 may include a camera seating portion that stably supports the camera unit 3051.

According to an embodiment, a connector 3053 disposed on the flexible printed circuit board 3052 of the fourth camera module 305 may be electrically connected to a connector (not separately illustrated) disposed on a second substrate surface 54B of the first printed circuit board 54.

According to an embodiment, the camera unit 3021 of the first camera module 302 and the camera unit 3031 of the second camera module 303 may not overlap with the first printed circuit board 54, when viewed from above the rear plate 32. The first printed circuit board 54 may include a first opening 54C corresponding to the camera unit 3021 of the first camera module 302 and the camera unit 3031 of the second camera module 303. The camera unit 3021 of the first camera module 302 and the camera unit 3031 of the second camera module 303 may overlap with the first opening 54C, when viewed from above the rear plate 32.

According to an embodiment, the first opening 54C of the first printed circuit board 54 may be a notch open toward the first side 331, when viewed from above the rear plate 32.

According to an embodiment, the first printed circuit board 54 may include a first protruding portion P1 and a second protruding portion P2 positioned at opposite sides with the first opening 54C interposed therebetween due to the first opening 54C in the form of a notch. The first protruding portion P1 may be extended between the camera unit 3031 of the second camera module 303 and the battery 56, when viewed from above the rear plate 32. The second protruding portion P2 may be extended between the camera unit 3021 of the first camera module 302 and the third side 333, when viewed from above the rear plate 32.

According to an embodiment, the camera unit 3041 of the third camera module 304 may overlap with the first protruding portion P1 of the first printed circuit board 54, when viewed from above the rear plate 32.

According to an embodiment, the camera unit 3051 of the fourth camera module 305 may not overlap with the first printed circuit board 54, when viewed from above the rear plate 32. The first printed circuit board 54 may include a second opening 54D corresponding to the camera unit 3051. The camera unit 3051 may overlap with the second opening 54D, when viewed from above the rear plate 32. The camera unit 3051 may be disposed on (or coupled to) the first support part 51. The first support part 51 may include an opening (not separately illustrated) that overlaps with the camera unit 3051, when viewed from above the rear plate 32, and the camera unit 3051 may face the display module 301 through the opening of the first support part 51. External light may reach the camera unit 3051 through openings in the front plate 31, the display module 301, and the first support part 51.

According to an embodiment, the second opening 54D of the first printed circuit board 54 may be a notch open toward the third side 333, when viewed from above the rear plate 32.

According to an embodiment, the light emitting module 306 may be disposed on the second substrate surface 54B of the first printed circuit board 54 and be electrically connected to the first printed circuit board 54.

According to an embodiment, the second sensor module 308 may be positioned closer to the fourth side 334 than the battery 56, when viewed from above the rear plate 32. The second sensor module 308 may include a sensor unit 3081 and a flexible printed circuit board 3082 extended from or connected to the sensor unit 3081. Although not separately illustrated, the sensor unit 3081 may include a circuit board on which a sensor (e.g., fingerprint recognition sensor) is disposed. The flexible printed circuit board 3082 may be electrically connected to the circuit board of the sensor unit 3081. For example, an integrated or single circuit board that replaces the circuit board of the sensor unit 3081 and the flexible printed circuit board 3082 may be implemented. The sensor unit 3081 may be electrically connected to the second printed circuit board 55 through a connection between a connector (not separately illustrated) disposed on the flexible printed circuit board 3082 and a connector (not separately illustrated) disposed on the second printed circuit board 55.

According to an embodiment, the sensor unit 3081 of the second sensor module 308 may be disposed on (or coupled to) the first support part 51. The first support part 51 may include a sensor seating portion that stably supports the sensor unit 3081.

According to an embodiment, the sensor unit 3081 of the second sensor module 308 may not overlap with the second printed circuit board 55, when viewed from above the rear plate 32.

According to an embodiment, the first support part 51 may include an opening (not separately illustrated) that overlaps with the sensor unit 3081 of the second sensor module 308, when viewed from above the rear plate 32, and the sensor unit 3081 may face the display module 301 through the opening of the first support part 51.

According to an embodiment, the first sound output module 3101 may be positioned closer to the third side 333 than the battery 56, when viewed from above the rear plate 32. The first sound output module 3101 may include a speaker unit 3102 and a flexible printed circuit board 3103 extended from or connected to the speaker unit 3102. The speaker unit 3102 may include a speaker housing and a speaker (not separately illustrated) received in the speaker housing. The speaker of the speaker unit 3102 may be electrically connected to the first printed circuit board 54 through a connection between a connector (not separately illustrated) disposed on the flexible printed circuit board 3103 and a connector (not separately illustrated) disposed on the first printed circuit board 54.

According to an embodiment, the speaker unit 3102 of the first sound output module 3101 may be disposed on (or coupled to) the first support part 51. The first support part 51 may include a speaker seating portion that stably supports the speaker unit 3102.

According to an embodiment, when viewed from above the rear plate 32, the speaker unit 3102 of the first sound output module 3101 may not overlap with the first printed circuit board 54. When viewed from above the rear plate 32, the speaker unit 3102 may overlap with the second opening 54D of the first printed circuit board 54.

According to an embodiment, the camera unit 3051 of the fourth camera module 305 may be positioned between the speaker unit 3102 of the first sound output module and the third side 333, when viewed from above the rear plate 32.

According to an embodiment, the camera unit 3021 of the first camera module 302, the camera unit 3031 of the second camera module 303, and the camera unit 3041 of the third camera module 304 may be positioned closer to the first side 331 than the speaker unit 3102 of the first sound output module 3101, when viewed from above the rear plate 32.

According to an embodiment, the camera unit 3021 of the first camera module 302 may be positioned closer to the third side 333 than the speaker unit 3102 of the first sound output module 3101, when viewed from above the rear plate 32. The camera unit 3051 of the fourth camera module 305 may be positioned closer to the third side 333 than the camera unit 3021 of the first camera module 302, when viewed from above the rear plate 32.

According to an embodiment, the speaker unit 3102 of the first sound output module 3101 may be positioned closer to the third side 333 than the camera unit 3031 of the second camera module 303, when viewed from above the rear plate 32.

According to an embodiment, the first support part 51 may include a guide that guides the movement of sound so that the sound output from the speaker unit 3102 is emitted to the outside of the electronic device 3 through the first speaker hole 310 (see FIG. 3). The guide may include, for example, a through hole 3104 provided (or formed) in the first support part 51, and a recess (not separately illustrated) extended from the through hole 3104 to the first speaker hole 310 (see FIG. 3). Due to a combination of the first support part 51 and the display module 301, a sound passage 3105 corresponding to the recess may be provided. The sound output from the speaker unit 3102 may be emitted to the outside of the first speaker hole 310 (see FIG. 3) through the through hole 3104 and the passage 3105.

According to an embodiment, the first speaker hole 310 (see FIG. 3) may be positioned closer to the second side 332 than the camera unit 3021 of the first camera module 302 and closer to the first side 331 than the camera unit 3021 of the fourth camera module 305, when viewed from above the rear plate 32. The sound passage 3105 may be extended between the camera unit 3021 of the first camera module 302 and the camera unit 3051 of the fourth camera module 305, when viewed from above the rear plate 32. When viewed from above the rear plate 32, the sound passage 3105 may overlap with the first printed circuit board 54.

According to an embodiment, the key input module 313 may include a first key 313a, a second key 313b, a key signal generator 313c, and/or a flexible printed circuit board 313d. The first key 313a may be positioned in a first key hole of the first outer metal A1, and the second key 313b may be positioned in a second key hole of the first outer metal A1. The key signal generator 313c may include a circuit board (not separately illustrated) configured to generate a first key signal corresponding to pressing or touching of the first key 313a and a second key signal corresponding to pressing or touching of the second key 313b. The flexible printed circuit board 313d may be extended from the circuit board of the key signal generator 313c or may be electrically connected to the circuit board of the key signal generator 313c. For example, an integrated or single circuit board that replaces the circuit board of the key signal generator 313c and the flexible printed circuit board 313d may be implemented. The key signal generator 313c may be electrically connected to the first printed circuit board 54 through a connection between a connector (not separately illustrated) disposed on the flexible printed circuit board 313d and a connector (not separately illustrated) disposed on the first printed circuit board 54.

According to an embodiment, the key signal generator 313c of the key input module 313 may be disposed in (or coupled to) the second bracket 62. The key signal generator 313c may be disposed in or coupled to the second bracket 62 through bonding using an adhesive material (or a bonding material) (not separately illustrated) or mechanical fastening such as screw fastening. The second bracket 62 may connect the key signal generator 313c to the first support part 51. The third bracket 62 may be coupled to the first support part 51 through screw fastening. The key signal generator 313c may be stably and firmly connected to the first support part 51 via the second bracket 62.

According to an embodiment, the second bracket 62 may include an integrated or single metal body (or metal structure) (e.g., single continuous metal structure) that replaces one or more bent portions.

According to an embodiment, the first support part 51 (or the front seating portion of the first support part 51) may include a second seating portion corresponding to a combination of the second bracket 62 and the key signal generator 313c. The second seating portion may include, for example, a second recess R2 into which the combination of the second bracket 62 and the key signal generator 313c may be fitted.

According to an embodiment, the second bracket 62 may have an elastic structure that may be elastically inserted into the second recess R2 of the first support part 51. Elastically disposing the second bracket 62 in the second recess R2 may prevent or mitigate separation of the second bracket 62 from the second recess R2.

According to various embodiments, the second bracket 62 may be coupled to the first support part 51 through screw fastening.

According to an embodiment, the second recess R2 may be extended in a second direction (e.g., the +y axis direction) from the fourth side 334 to the third side 333, when viewed from above the rear plate 32.

According to an embodiment, a portion of the entire section in which the second recess R2 is extended in the second direction 402 (e.g., the +y-axis direction) may be positioned between the battery 56 and the first side 331, when viewed from above the rear plate 32. Another portion of the section in which the second recess R2 is extended in the second direction 402 may be positioned between the first protruding portion P1 of the first printed circuit board 54 and the first side 331, when viewed from above the rear plate 32. Another portion of the section in which the second recess R2 is extended in the second direction 402 may be positioned between the second camera module 303 and the first side 331, when viewed from above the rear plate 32. In various embodiments, although not separately illustrated, when viewed from above the rear plate 32, the second recess R2 may not be extended between the second camera module 303 and the second side 332, and a combination of the key signal generator 313c and the second bracket 62 may be provided (or formed) in a corresponding shape.

According to an embodiment, a connector (not separately illustrated) disposed on the flexible printed circuit board 313d of the key input module 313 may be electrically connected to a connector (not separately illustrated) disposed on a first substrate surface (not separately illustrated) (e.g., a surface facing the first support part 51) of the first printed circuit board 54.

According to an embodiment, the antenna module 315 may be disposed in (or coupled to) the first bracket 61. The antenna module 315 may be disposed in or coupled to the first bracket 61 through bonding using an adhesive material (or bonding material) (not separately illustrated) or through mechanical fastening such as screw fastening. The first bracket 61 may connect the antenna module 315 to the first support part 51. The antenna module 315 may be stably and firmly connected to the first support part 51 through the first bracket 61.

According to an embodiment, the first bracket 61 may be disposed on or coupled to the first support part 51 via an adhesive material (or bonding material) 8.

According to an embodiment, the first bracket 61 may be disposed on or coupled to the first support part 51 via a screw.

According to an embodiment, the first support part 51 (or the front seating portion of the first support part 51) may include a first seating portion corresponding to a combination of the first bracket 61 and the antenna module 315. The first seating portion may include, for example, a first recess R1 into which a combination of the first bracket 61 and the antenna module 315 may be insert-fitted.

According to an embodiment, the first bracket 61 may include an integrated or single metal body (or metal structure) (e.g., single continuous metal structure) that replaces one or more bent portions.

According to various embodiments, the first bracket 61 may have an elastic structure that may be elastically inserted into the first recess R1 of the first support part 51.

According to an embodiment, the first recess R1 may be spaced apart from the second recess R2 in a second direction 402 (e.g., the +y-axis direction), when viewed from above the rear plate 32. The first recess R1 may be substantially extended in the second direction 402, when viewed from above the rear plate 32.

According to an embodiment, a portion of the section in which the first recess R1 is extended in the second direction 402 (e.g., the +y-axis direction) may be positioned between the first camera module 302 and the first side 331, when viewed from above the rear plate 32. Another portion of the section in which the first recess R1 is extended in the second direction 402 may be positioned between the second camera module 303 and the first side 331, when viewed from above the rear plate 32.

According to an embodiment, the third flexible printed circuit board 65 may electrically connect the antenna module 315 and the first printed circuit board 54. The third flexible printed circuit board 65 may be in the form of a film having a thickness between the third surface 651 and the fourth surface 652 facing in a direction opposite to that of the third surface 651.

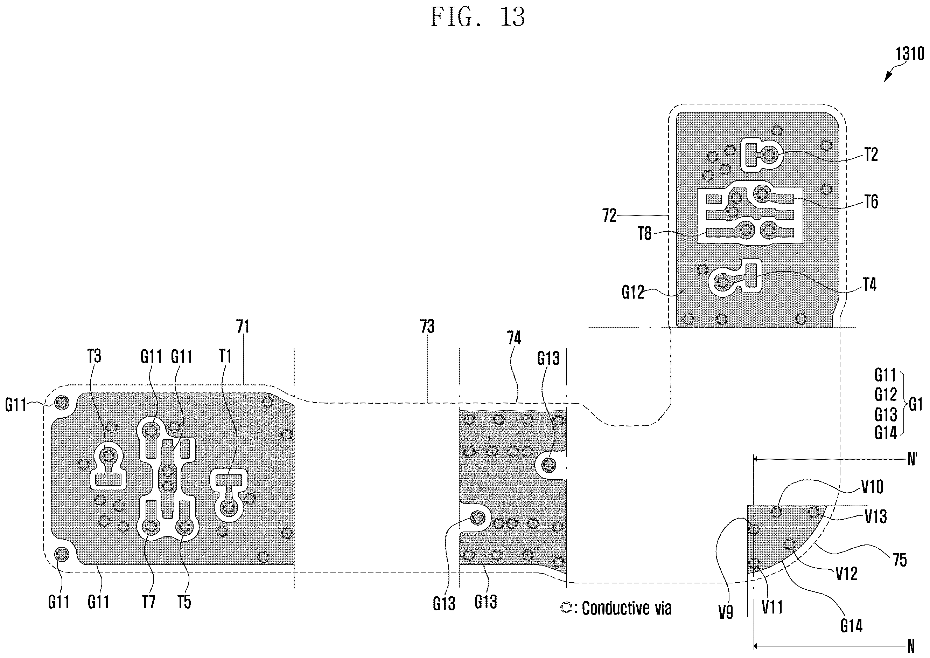

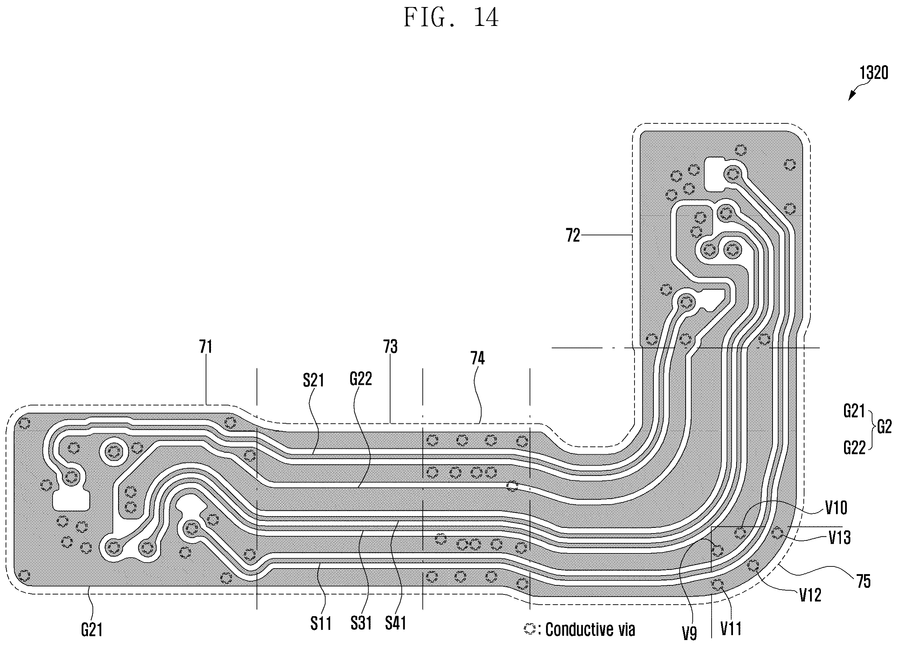

According to an embodiment, the third flexible printed circuit board 65 may include a plurality of pattern layers (e.g., the first pattern layer 1310 of FIG. 13, the second pattern layer 1320 of FIG. 13, and the third pattern layer 1330 of FIG. 14) including conductive patterns, a plurality of non-conductive layers (e.g., insulating layers) (not separately illustrated) disposed between the plurality of pattern layers, and a plurality of conductive vias. The conductive vias may be conductive holes (e.g., PTH, LVH, BVH, or stacked vias) provided to dispose connecting wires for electrically connecting conductive patterns of different pattern layers of the third flexible printed circuit board 65. The one or more conductive vias may electrically connect, for example, signal line patterns (e.g., conductive patterns (lines) utilized as electrical paths) included in different pattern layers of the third flexible printed circuit board 65 as part of a signal line (or electrical path). The one or more conductive vias may electrically connect, for example, ground planes (or ground areas or ground patterns) included in different pattern layers of the third flexible printed circuit board 65. The number of pattern layers and non-conductive layers included in the flexible printed circuit board may vary.

According to an embodiment, the third flexible printed circuit board 65 may include a plurality of signal lines (e.g., a first signal line S1, a second signal line S2, a third signal line S3, and a fourth signal line S4), and/or a ground structure (not separately illustrated). The plurality of signal lines may be physically separated from each other. The plurality of signal lines may be physically separated from the ground structure.

According to an embodiment, the third flexible printed circuit board 65 may be an FRC.

According to an embodiment, the first signal line S1 and/or the second signal line S2 may transmit an electromagnetic signal (or a radio signal, RF signal, or radiated current) between the antenna module 315 and the wireless communication circuit (e.g., the wireless communication module 192 of FIG. 1) disposed on the first printed circuit board 54. The first signal line S1 may be defined or interpreted as a 'first transmission line', and the second signal line S2 may be defined or interpreted as a 'second transmission line'.

According to an embodiment, the third signal line S3 and/or the fourth signal line S4 may transmit power. For example, the power management circuit (e.g., the power management module 188 of FIG. 1) disposed on the first printed circuit board 54 may transmit power to the power management circuit 45 (see FIG. 4) of the antenna module 315 via the third signal line S3 and the fourth signal line S4.

According to an embodiment, the third signal line S3 (e.g., first power line) and the fourth signal line S4 (e.g., second power line) may be extended between the first signal line S1 (e.g., first transmission line) and the second signal line S2 (e.g., second transmission line). In various embodiments, the third flexible printed circuit board 65 may include one or more other signal lines (not separately illustrated) extended between the first signal line S1 (e.g., first transmission line) and the second signal line S2 (e.g., second transmission line).

According to an embodiment, a combination (e.g., conductive structure) of one or more conductive vias electrically connecting ground planes of different pattern layers of the third flexible printed circuit board 65 and ground planes (or ground areas or ground patterns) of different pattern layers may form a ground structure (not separately illustrated) of the third flexible printed circuit board 65. The ground structure of the third flexible printed circuit board 65 may reduce electromagnetic interference (EMI) or crosstalk between a plurality of signal lines (e.g., a first signal line S1, a second signal line S2, a third signal line S3, and a fourth signal line S4) included in the third flexible printed circuit board 65. The ground structure of the third flexible printed circuit board 65 may reduce or shield an electromagnetic influence (e.g., electromagnetic interference) of noise from the outside of the third flexible printed circuit board 65 on a plurality of signal lines of the third flexible printed circuit board 65. The ground structure may be defined or interpreted as a 'shielding structure'.

According to an embodiment, the third flexible printed circuit board 65 may include one or more rigid portions (or rigid areas or rigid sections) (e.g., a first portion 71, a second portion 72, a first rigid portion 74, and a second rigid portion 75) and one or more flexible portions (or flexible areas or flexible sections). The rigid portion may be defined or interpreted as being less flexible or more rigid than the flexible portion. The flexible portion may be defined or interpreted as being more flexible or less rigid than the rigid portion. The rigid portion may have, for example, a greater thickness or a higher number of laminates than the flexible portion; thus, the rigid portion may be rigid. The rigid portion may include, for example, a different material from that of the flexible portion in order to be rigid compared to the flexible portion.

According to various embodiments, the third flexible circuit board 65 may be implemented as a rigid flexible printed circuit board.

According to an embodiment, the third flexible printed circuit board 65 may include a first portion 71 in which a first connector 711 is disposed, a second portion 72 in which a second connector 721 is disposed, and a third portion 73 connecting the first portion 71 and the second portion 72 (or between the first portion 71 and the second portion 72 or extending the first portion 71 and the second portion 72). The first connector 711 and the second connector 721 may be disposed on the third surface 651 of the third flexible printed circuit board 65. The first connector 711 may be electrically connected to the connector 47 of the antenna module 315. The second connector 721 may be electrically connected to a connector (not separately illustrated) disposed on the first printed circuit board 54.

According to an embodiment, the first connector 711 may be a first board to board (BTB) connector, and the second connector 721 may be a second BTB connector. The first connector 711 and the second connector 721 may be disposed on the third surface 651 of the third flexible printed circuit board 65 via a conductive adhesive material (or bonding material) (not illustrated) such as solder, copper, silver paste, aluminum, silver-aluminum, carbon paste, or carbon nanotube (CNT) paste.

According to an embodiment, the first signal line S1, the second signal line S2, the third signal line S3, and the fourth signal line S4 may be electrically connected to the first connector 711 and the second connector 721. The first signal line S1 may include a first terminal (e.g., first conductive pad) (not separately illustrated) included in the first portion 71 and a second terminal (e.g., second conductive pad) (not separately illustrated) included in the second portion 72. The first terminal may be physically and electrically connected to the first connector 711 via a conductive adhesive material (or bonding material) (not separately illustrated) such as solder, copper, silver paste, aluminum, silver-aluminum, carbon paste, or CNT paste. The second terminal may be physically and electrically connected to the second connector 721 via a conductive adhesive material (or bonding material) (not separately illustrated). The second signal line S2, the third signal line S3, and/or the fourth signal line S4 may be electrically connected to the first connector 711 and the second connector 721 in substantially the same manner as the first signal line S1.

According to various embodiments, although not separately illustrated, the first signal line S1, the second signal line S2, the third signal line S3, or the fourth signal line S4 may include a combination of a plurality of signal line patterns included in different pattern layers of the third flexible printed circuit board 65 and at least one conductive via electrically connecting the plurality of signal line patterns.

According to an embodiment, a ground structure (not separately illustrated) of the third flexible printed circuit board 65 may be electrically connected to the first connector 711 and the second connector 721. The ground structure may include a third terminal (e.g., third conductive pad) (not separately illustrated) included in the first portion 71 and a fourth terminal (e.g., fourth conductive pad) (not separately illustrated) included in the second portion 72. The third terminal may be physically and electrically connected to the first connector 711 via a conductive adhesive material (or bonding material) (not separately illustrated) such as solder, copper, silver paste, aluminum, silver-aluminum, carbon paste, or CNT paste. The fourth terminal may be physically and electrically connected to the second connector 721 via a conductive adhesive material (or bonding material) (not separately illustrated).

According to an embodiment, the connector 47 of the antenna module 315 may be disposed on the second surface 412 of the antenna structure 41 included in the antenna module 315. The second surface 412 of the antenna structure 41 may face in a third direction 403 (e.g., the -x axis direction) from the first side 331 to the second side 332, when viewed from above the rear plate 32. A partial area of the third surface 651 of the third flexible printed circuit board 65 included in the first portion 71 where the first connector 711 is disposed may face the second surface 412 of the antenna module 315. A partial area of the third surface 651 included in the first portion 71 may substantially face, for example, in the first direction 401 (e.g., the +x axis direction).

According to an embodiment, the first portion 71 of the third flexible printed circuit board 65 including the first connector 711 may be positioned between the antenna structure 41 of the antenna module 315 and the second camera module 303, when viewed from above the rear plate 32.

According to an embodiment, the second connector 721 of the third flexible printed circuit board 65 may be electrically connected to a connector (not separately illustrated) disposed on the second substrate surface 54B of the first printed circuit board 54.

According to an embodiment, a connector (not separately illustrated) electrically connected to the second connector 721 of the third flexible printed circuit board 65 may be disposed on a first protruding portion P1 of the first printed circuit board 54.

According to an embodiment, a partial area included in a second portion 71, in which the second connector 721 is disposed on the third surface 651 of the third flexible printed circuit board 65, may face the second substrate surface 54B of the first printed circuit board 54. A partial area of the third surface 651 included in the second portion 71 may substantially face, for example, in the +z-axis direction.

According to an embodiment, the second portion 72 of the third flexible printed circuit board 65 including the second connector 721 may be positioned closer to the first side 331 than the camera unit 3041 of the third camera module 304, when viewed from above the rear plate 32. When viewed from above the rear plate 32, the second portion 72 may not overlap with the third camera module 304.

According to an embodiment, when viewed from above the rear plate 32, the second portion 72 of the third flexible printed circuit board 65 including the second connector 721 may be spaced apart from the second camera module 303 in a fourth direction 404 (e.g., the -y axis direction) opposite to the second direction 402.

According to an embodiment, when viewed from above the rear plate 32, the second portion 72 of the third flexible printed circuit board 65 may be positioned closer to the first side 331 than the first portion 71 of the third flexible printed circuit board 66. When viewed from above the rear plate 32, the first portion 71 may be positioned closer to the third side 333 than the second portion 72.

According to an embodiment, the first portion 71 of the third flexible printed circuit board 65 may be substantially rigid. The first portion 71 may be a first rigid plate substantially perpendicular to the first direction 401 (e.g., +x-axis direction) or the third direction 403 (e.g., -x-axis direction). A partial area of the third surface 651 of the third flexible printed circuit board 65 included in the first portion 71 may face the first direction 401, and a partial area of the fourth surface 652 of the third flexible printed circuit board 65 included in the first portion 71 may face the third direction 403.

According to various embodiments, the first portion 71 of the third flexible printed circuit board 65 may include a separately attached first reinforcing plate (e.g., first stiffener) (not illustrated) to have rigidity.

According to an embodiment, the second portion 72 of the third flexible printed circuit board 65 may be substantially rigid. The second portion 72 may be a second rigid plate substantially perpendicular to the +z-axis direction or the -z-axis direction. A partial area of the third surface 651 of the third flexible printed circuit board 65 included in the second portion 72 may face the front plate 31 (e.g., the +z-axis direction), and a partial area of the fourth surface 652 of the third flexible printed circuit board 65 included in the first portion 71 may face the rear plate 32 (e.g., the -z-axis direction).

According to various embodiments, the second portion 72 of the third flexible printed circuit board 65 may include a separately attached second reinforcing plate (e.g., second stiffener) (not separately illustrated) to have rigidity.

According to an embodiment, due to positions and directions in which the first portion 71 and the second portion 72 are disposed, the third portion 73 of the third flexible printed circuit board 65 may be disposed in a bent manner. The third portion 73 may include a first partial area 731 extended from the first portion 71, a second partial area 732 extended from the second portion 72, and a corner 733 where the first partial area 731 and the second partial area 732 are connected (or between the first partial area 731 and the second partial area 732, or extending the first partial area 731 and the second partial area 732). In the unfolded state of the third flexible printed circuit board 65, the first partial area 731 and the second partial area 732 may be extended in different directions (e.g., directions perpendicular to each other).

According to an embodiment, the third portion 73 may be provided (or formed) in a fan shape, including a first boundary F1 between the first partial area 731 and the corner 733, a second boundary F2 between the second partial area 732 and the corner 733, and a curved edge connecting the first boundary F1 and the second boundary F2.

According to an embodiment, the third flexible printed circuit board 65 may include a first edge E1 and a second edge E2 extended from the first portion 71 to the second portion 72. Due to the corner 733 included in the third portion 73 of the third flexible printed circuit board 65, the first edge E1 may have a longer length than that of the second edge E2.

According to an embodiment, the first signal line S1 may be positioned closer to the first edge E1 than the second signal line S2. The second signal line S2 may be positioned closer to the second edge E2 than the first signal line S 1. Because the first signal line S1 is positioned closer to the first edge E1 than the second signal line S2, the first signal line S1 may have a longer length than that of the second signal line S2. With respect to the corner 733, the first edge E1 may be defined or interpreted as an 'outer edge', and the second edge E2 may be defined or interpreted as an 'inner edge'. With respect to the corner 733, the first signal line S1 may be defined or interpreted as an 'outer signal line', and the second signal line S2 may be defined or interpreted as an 'inner signal line'.

According to an embodiment, the first support part 51 (or front seating portion) may include a third recess R3 into which the third portion 73 of the third flexible printed circuit board 65 is inserted. The third recess R3 may be extended from the first recess R1 between the camera unit 3031 of the second camera module 303 and the first protruding portion P1 of the first printed circuit board 54, when viewed from above the rear plate 32. When viewed from above the rear plate 32, the third recess R3 may include a first partial recess R31 extended from the first recess R1 between the second recess R2 and the camera unit 3031 of the second camera module 303, and a second partial recess R32 extended from the first partial recess R31 between the camera unit 3031 of the second camera module 303 and the first protruding portion P1 of the first printed circuit board 54.

According to an embodiment, the first partial recess R31 of the second recess R2 and the third recess R3 may be connected. In various embodiments, the first support part 51 may include a partition (not separately illustrated) disposed between the first partial recess R31 of the second recess R2 and the third recess R3.

According to an embodiment, the second partial recess R32 of the third recess R3 may include a support wall W positioned between the camera unit 3031 of the second camera module 303 and the first protruding portion P1 of the first printed circuit board 54, when viewed from above the rear plate 32. For example, the support wall W may substantially face in the second direction 402 (e.g., the +y-axis direction).

According to an embodiment, the third portion 73 of the third flexible printed circuit board 65 may be disposed in a bent shape having a first bent portion 701, a second bent portion 702, a third bent portion 703, and/or a fourth bent portion 704.

According to an embodiment, the first bent portion 701 and the second bent portion 702 may be disposed to correspond between the first portion 71 and the third bent portion 703.

According to an embodiment, the third bent portion 703 may be disposed at a position where the first partial recess R31 and the second partial recess R32 of the third recess R3 are connected.

According to an embodiment, the fourth bent portion 704 may be disposed to correspond between the corner 733 of the third portion 73 corresponding to the support wall W and the second portion 72 disposed in the first protruding portion P1 of the first printed circuit board 54.

According to various embodiments, the corner 733 included in the third portion 73 of the third flexible printed circuit board 65 may be disposed on or coupled to the support wall W via an adhesive material (or bonding material) (not separately illustrated). Due to a relative position between the corner 733 of the third portion 73 supported on the support wall W and the first portion 71 connected to the antenna module 315, and a relative position between the corner 733 of the third portion 73 supported on the support wall W and the second portion 72 connected to the first printed circuit board 54, the third bent portion 703 and the fourth bent portion 704 may be formed.

According to an embodiment, the third bent portion 703 may have a first bending axis BX1. The first bending axis BX1 may be, for example, substantially parallel to a direction (e.g., the +z-axis direction or the -z-axis direction) perpendicular to the first direction 401 (or the third direction 403) and the second direction 402 (or the fourth direction 404). The first bending axis BX1 may be substantially parallel to the first boundary F1 between the first partial area 731 and the corner 733.

According to an embodiment, the fourth bent portion 704 may have a second bending axis BX2. The second bending axis BX2 may be, for example, substantially parallel to the first direction 401 or the third direction 403. The second bending axis BX2 may be substantially parallel to the second boundary F2 between the second partial area 732 and the corner 733.

According to an embodiment, the first boundary F1 and the second boundary F2 may form an angle of substantially about 90 degrees. In various embodiments, although not separately illustrated, the first boundary F1 and the second boundary F2 may form an acute angle or an obtuse angle according to a relative position and/or angle between the first bending axis BX1 of the third bent portion 703 and the second bending axis BX2 of the fourth bent portion 704.

According to an embodiment, the third portion 73 of the third flexible printed circuit board 65 may include a first rigid portion 74 and/or a second rigid portion 75. The first rigid portion 74 may be positioned between the first portion 71 and the first bent portion 701 of the third portion 73. The second rigid portion 75 may be at least partially included in the corner 733 corresponding to (or disposed at) the support wall W1 of the third portion 73. Portions of the third portion 73 other than the first rigid portion 74 and the second rigid portion 75 may be substantially flexible.

According to an embodiment, the third flexible printed circuit board 65 may include a first flexible portion 76 between the first portion 71 and the first rigid portion 74. The third flexible printed circuit board 65 may include a second flexible portion 77 between the first rigid portion 74 and the second rigid portion 75, as well as the second portion 72.

According to an embodiment, the first bent portion 701 and the second bent portion 702 may be provided (or formed) through the first flexible portion 76.

According to an embodiment, the third bent portion 703 and the fourth bent portion 704 may be provided (or formed) through the second flexible portion 77.

According to an embodiment, the second flexible portion 77 may include a third flexible portion 771, a fourth flexible portion 772, and/or a fifth flexible portion 773. The third flexible portion 771 may be disposed between the first rigid portion 74 and the corner 733. The fourth flexible portion 772 may be disposed between the second portion 72 and the corner 733. The fifth flexible portion 773 may be disposed at the corner 733. The fifth flexible portion 773 may connect (or extend) the third flexible portion 771 and the fourth flexible portion 772. The third bent portion 703 may be provided (or formed) through the third flexible portion 771. The fourth bent portion 704 may be provided (or formed) through the fourth flexible portion 772.

According to an embodiment, the corner 733 including the second rigid portion 75 and the fifth flexible portion 773 of the third portion 73 of the third flexible printed circuit board 65 may be disposed on (or coupled to) the support wall W of the first support part 51.

According to an embodiment, the third flexible printed circuit board 65 may include a plurality of conductive vias included in a plurality of rigid portions. The first portion 71, the second portion 72, the first rigid portion 74, and the second rigid portion 75 may include a plurality of conductive vias. The plurality of rigid portions of the third flexible printed circuit board 66 may include the plurality of conductive vias to be less flexible than the flexible portion of the third flexible printed circuit board 66. The plurality of conductive vias may electrically connect ground planes (or ground areas or ground patterns) included in different pattern layers of the third flexible printed circuit board 65. The ground planes included in different pattern layers may include via holes (not separately illustrated) for the plurality of conductive vias. A combination of one or more conductive vias electrically connecting ground planes of different pattern layers and ground planes (or ground areas or ground patterns) of different pattern layers may form a ground structure (not separately illustrated) of the third flexible printed circuit board 65.

According to an embodiment, a shielding portion provided (or formed) using a plurality of conductive vias among ground structures of the third flexible printed circuit board 65 may include a first shielding portion (or first shielding section) 801 included in the first portion 71, a second shielding portion (or second shielding section) 802 included in the second portion 72, a third shielding portion (or third shielding section) 803 included in the first rigid portion 74, and/or a fourth shielding portion (or fourth shielding section) 804 included in the second rigid portion 75.

According to an embodiment, the first shielding portion 801 included in the first portion 71 and the third shielding portion 803 of the first rigid portion 74 may be connected through a portion (not separately illustrated) included in the first flexible portion 76 of the ground structure. The fourth shielding portion 804 of the second rigid portion 75 may be connected to the third shielding portion 803 of the first rigid portion 74 and the second shielding portion 802 of the second portion 72 through a portion (not separately illustrated) included in the second flexible portion 77 of the ground structure.

According to an embodiment, in order to provide flexible characteristics and to reduce or prevent damage (e.g., via crack) to the conductive vias by bending, the first flexible portion 76 and the second flexible portion 77 of the third flexible printed circuit board 65 may not include a plurality of conductive vias. In various embodiments, the first flexible portion 76 and the second flexible portion 77 may include a smaller number of conductive vias than the plurality of rigid portions (e.g., the first portion 71, the second portion 72, the first rigid portion 74, and the second rigid portion 75) (not separately illustrated).

According to an embodiment, the first shielding portion 801 may be provided (or formed) corresponding to the first signal line S1, the second signal line S2, the third signal line S3, and/or the fourth signal line S4. The first shielding portion 801 may surround at least a portion of the first signal line S1 included in the first portion 71, a portion of the second signal line S2 included in the first portion 71, a portion of the third signal line S3 included in the first portion 71, and/or a portion of the fourth signal line S4 included in the first portion 71. In the first portion 71, the first shielding portion 801 may reduce the influence (e.g., signal loss and/or deformation) of electromagnetic noise and/or electromagnetic interference on the first signal line S1, the second signal line S2, the third signal line S3, and/or the fourth signal line S4.

According to an embodiment, the second shielding portion 802 may be provided (or formed) corresponding to the first signal line S1, the second signal line S2, the third signal line S3, and/or the fourth signal line S4. The second shielding portion 802 may surround at least a portion of the first signal line S1 included in the second portion 72, a portion of the second signal line S2 included in the second portion 72, a portion of the third signal line S3 included in the second portion 72, and/or a portion of the fourth signal line S4 included in the second portion 72. In the second portion 72, the second shielding portion 802 may reduce the influence (e.g., signal loss and/or deformation) of electromagnetic noise and/or electromagnetic interference on the first signal line S1, the second signal line S2, the third signal line S3, and/or the fourth signal line S4.

According to an embodiment, the third shielding portion 803 may be provided (or formed) corresponding to the first signal line S1, the second signal line S2, the third signal line S3, and/or the fourth signal line S4. The third shielding portion 803 may surround at least a portion of the first signal line S1 included in the first rigid portion 74, a portion of the second signal line S2 included in the first rigid portion 74, a portion of the third signal line S3 included in the first rigid portion 74, and/or a portion of the fourth signal line S4 included in the first rigid portion 74. In the first rigid portion 74 of the third portion 73, the third shielding portion 803 may reduce the influence (e.g., signal loss and/or deformation) of electromagnetic noise and/or electromagnetic interference on the first signal line S1, the second signal line S2, the third signal line S3, and/or the fourth signal line S4.

According to an embodiment, the fourth shielding portion 804 may be provided (or formed) corresponding to the first signal line S1 (e.g., the first transmission line). The fourth shielding portion 804 may surround at least a portion of the first signal line S1 included in the second rigid portion 75. In the second rigid portion 75 of the third portion 73, the fourth shielding portion 804 may reduce the influence of electromagnetic noise and/or electromagnetic interference (e.g., signal loss and/or deformation) on the first signal line S1.

According to an embodiment, a length of the third portion 73 of the third flexible printed circuit board 65 extended from the first portion 71 to the second portion 72 may be longer than a reference value (e.g., about 5 mm). If a length of the third portion 73 extended from the first portion 71 to the second portion 72 is greater than the reference value, it may be difficult to provide (or form) a signal line (e.g., the first signal line S1, the second signal line S2, the third signal line S3, or the fourth signal line S4) with a length equal to or less than the reference value. If a length of the signal line of or included in the third portion 73, extending from the first portion 71 to the second portion 72, is greater than the reference value, the possibility that electromagnetic noise and/or electromagnetic interference will affect the signal line becomes relatively higher than when the length is equal to or less than the reference value; thus, it may be difficult to secure a stable signal transmission performance. Because the third portion 73 may have a section that may reduce or shield electromagnetic noise and/or electromagnetic interference through the third shielding portion 803 of the first rigid portion 74, the possibility that electromagnetic noise and/or electromagnetic interference will affect the signal line (e.g., the first signal line S 1, the second signal line S2, the third signal line S3, or the fourth signal line S4) may be reduced compared to the comparative example in which the first rigid portion 74 including the third shielding portion 803 is omitted.

According to an embodiment, in the first partial area 731 of the third portion 73, the first rigid portion 74 may be disposed between the first flexible portion 76 and the third flexible portion 771. Because the first flexible portion 76 is disposed to have the first bent portion 701 and the second bent portion 702, expanding the first rigid portion 74 while reducing the first flexible portion 76 may be limited. Because the third flexible portion 771 is disposed to have the third bent portion 703, expanding the first rigid portion 74 while reducing the third flexible portion 771 may be limited.

According to an embodiment, a length L1 of the first flexible portion 76 extended from the first portion 71 to the second rigid portion 75 may be less than or equal to a reference value (e.g., about 5 mm). The first length L1 may be, for example, about 2.85 mm. Because a portion of the signal lines (e.g., the first signal line S1, the second signal line S2, the third signal line S3, or the fourth signal line S4) included in the first flexible portion 76 may be substantially extended along the first flexible portion 76 to have a length less than or equal to the reference value, the possibility that electromagnetic noise and/or electromagnetic interference in the first flexible portion 76 will affect the signal lines may be reduced. For example, a portion of the first signal line S1 included in the first flexible portion 76 may have a length of about 3.0 mm. For example, a portion of the second signal line S2 included in the first flexible portion 76 may have a length of about 2.5 mm.

According to an embodiment, a length of a portion of the second signal line S2 (e.g., second transmission line) included in the second flexible portion 77 of the third portion 73 and extended from the first rigid portion 74 to the second portion 72 may be less than or equal to a reference value (e.g., about 5 mm). A portion (e.g., a portion included in the second flexible portion 77) of the second signal line S2 between the first rigid portion 74 and the second portion 72 may be extended along a portion of the first edge E1 extended from the first rigid portion 74 to the second portion 72. A length of the first edge E1 extended from the first rigid portion 74 to the second portion 72 may be about 4 mm. Because a portion of the second signal line S2 included in the second flexible portion 77 may be substantially extended along the second flexible portion 77 to have a length less than or equal to a reference value, the possibility that electromagnetic noise and/or electromagnetic interference in the second flexible portion 77 will affect the second signal line S2 may be reduced.

According to an embodiment, because the first signal line S1 (e.g., the first transmission line) may be positioned closer to the first edge E1 than the second signal line S2, the first signal line S1 may have a relatively longer length than that of the second signal line S2. A length of a portion of the first signal line S1 included in the second flexible portion 77 of the third portion 73 and extended from the first rigid portion 74 to the second portion 72 may be longer than a reference value (e.g., about 5 mm). Because a portion of the first signal line S1 included in the second flexible portion 77 may be substantially extended along the second flexible portion 77 to have a length longer than the reference value, the possibility that electromagnetic noise and/or electromagnetic interference in the second flexible portion 77 may affect the first signal line S1 may be relatively high, compared to an example having a length less than or equal to the reference value. Because the third portion 73 may have a section capable of reducing or shielding electromagnetic noise and/or electromagnetic interference through the fourth shielding portion 804 of the second rigid portion 75, the possibility that electromagnetic noise and/or electromagnetic interference may affect the first signal line S1 may be reduced, compared to a comparative example in which the second rigid portion 75 including the fourth shielding portion 804 is omitted.

According to an embodiment, a length extended from the first rigid portion 74 to the second rigid portion 75 of the first signal line S1 may be less than or equal to a reference value (e.g., about 5 mm). A length extended from the first rigid portion 74 to the second rigid portion 75 of the first signal line S1 may be, for example, about 3 mm. Because a length extended from the first rigid portion 74 to the second rigid portion 75 of the first signal line S1 may have a length less than or equal to the reference value, the possibility that electromagnetic noise and/or electromagnetic interference in the second flexible portion 77 will affect the first signal line S1 may be reduced.

According to various embodiments, the second partial area 732 of the third portion 73 may be implemented to include a third rigid portion (not separately illustrated) that includes a fifth shielding portion (not separately illustrated).

According to an embodiment, the third flexible printed circuit board 65 may include a first ground plane (e.g., a first ground plane G1 of FIG. 13) of a first pattern layer (e.g., a first pattern layer 1310 of FIG. 13), a second ground plane (e.g., a second ground plane G2 of FIG. 13) of a second pattern layer (e.g., a second pattern layer 1320 of FIG. 13), a third ground plane (e.g., a third ground plane G3 of FIG. 14) of a third pattern layer (e.g., a third pattern layer 1330 of FIG. 14), and a plurality of conductive vias. The second pattern layer may be disposed between the first pattern layer and the third pattern layer. The plurality of conductive vias may electrically connect the first ground plane, the second ground plane, and the third ground plane. The first signal line S1, the second signal line S2, the third signal line S3, and/or the fourth signal line S4 may be included in the second pattern layer.

According to an embodiment, a first ground plane (e.g., a first ground plane G1 of FIG. 13) included in a first pattern layer (e.g., a first pattern layer 1310 of FIG. 13) of a third flexible printed circuit board 65 may include at least one first ground pattern (e.g., at least one first ground pattern G11 of FIG. 13) included in a first portion 71, at least one second ground pattern (e.g., a second ground pattern G12 of FIG. 13) included in a second portion 72, at least one third ground pattern (e.g., a third ground pattern G13 of FIG. 13) included in a first rigid portion 74, and/or at least one fourth ground pattern (e.g., a fourth ground pattern G14 of FIG. 13) included in a second rigid portion 75. At least one first ground pattern, at least one second ground pattern, at least one third ground pattern, and at least one fourth ground pattern may be physically separated.

According to an embodiment, at least one fourth ground pattern (e.g., at least one fourth ground pattern G14 of FIG. 13) included in a second rigid portion 75 of a first ground plane (e.g., the first ground plane G1 of FIG. 13) included in a first pattern layer (e.g., the first pattern layer 1310 of FIG. 13) of the third flexible printed circuit board 65 may be provided (or formed) in a fan shape. The at least one fourth ground pattern may include a third edge E3, a fourth edge E4, and/or a fifth edge E5. The third edge E3 may be provided (or formed) in a curved shape corresponding to the corner 733. One end of the third edge E3 may be connected to the fourth edge E4, and the other end of the third edge E3 may be connected to the fifth edge E5. The fourth edge E4 and the fifth edge E5 may be connected and form an angle of substantially about 90 degrees. In various embodiments, although not separately illustrated, the fourth edge E4 and the fifth edge E5 may form an acute angle or an obtuse angle.

According to an embodiment, the first boundary F1 between the first partial area 731 and the corner 733 of the third portion 73 may be substantially parallel to the fourth edge E4 of the second rigid portion 75. The fourth edge E4 may be spaced from the first boundary F1.

According to an embodiment, the second boundary F2 between the second partial area 732 and the corner 733 of the third portion 73 may be substantially parallel to the fifth edge E5 of the second rigid portion 75. The fifth edge E5 may be spaced from the second boundary F2.

According to an embodiment, the fourth edge E4 and the fifth edge E5 of the second rigid portion 75 may form an angle of substantially about 90 degrees.

According to an embodiment, a second length L2 extended from the first rigid portion 74 to the fourth edge E4 of the second rigid portion 75 may be provided (or formed) such that a portion of the first signal line S1 extended from the first rigid portion 74 to the second rigid portion 75 may have a length less than or equal to a reference value (e.g., about 5 mm). The second length L2 may be, for example, about 3 mm. Because a portion of the first signal line S1 extended from the first rigid portion 74 to the second rigid portion 75 may have a length less than or equal to the reference value, the possibility that electromagnetic noise and/or electromagnetic interference in the second flexible portion 77 will affect the signal line may be reduced. For example, a portion of the first signal line S1 extended from the first rigid portion 74 to the second rigid portion 75 may have a length of about 3.0 mm.

According to an embodiment, the second length L2 may be provided (or formed) to reduce bending stress on the third bent portion 703. The second length L2 may be provided (or formed) to reduce breakage (e.g., crack) of the first signal line S1, the second signal line S2, the third signal line S3, and/or the fourth signal line S4 in the third bent portion 703.

According to an embodiment, a third length L3 extended from the second portion 72 to the fifth edge E5 of the second rigid portion 75 may be provided (or formed) such that a portion of the first signal line S1 extended from the second portion 72 to the second rigid portion 75 may have a length less than or equal to a reference value (e.g., about 5 mm). The third length L3 may be, for example, about 3 mm. Because a portion of the first signal line S1 extended from the second portion 72 to the second rigid portion 75 may have a length less than or equal to the reference value, the possibility that electromagnetic noise and/or electromagnetic interference in the second flexible portion 77 will affect the signal line may be reduced. For example, a portion of the first signal line S1 extended from the second portion 72 to the second rigid portion 75 may have a length of about 3.0 mm.

According to an embodiment, the third length L3 may be provided (or formed) to reduce bending stress on the fourth bent portion 704. The third length L3 may be provided (or formed) to reduce breakage (e.g., cracking) of the first signal line S1, the second signal line S2, the third signal line S3, and/or the fourth signal line S4 in the fourth bent portion 704.

According to various embodiments, although not separately illustrated, the first boundary F1 and the fourth edge E4 may not be parallel.

According to various embodiments, although not separately illustrated, the second boundary F2 and the fifth edge E5 may not be parallel.

According to various embodiments, although not separately illustrated, the fourth edge E4 and the fifth edge E5 of the second rigid portion 75 may form an acute angle or an obtuse angle.

According to various embodiments, although not separately illustrated, a direction in which the first surface 411 (see FIG. 4) of the antenna module 315 faces may be implemented to form an acute angle or an obtuse angle with the +z-axis direction or the -z-axis direction. In this case, the third flexible printed circuit board 65 may be provided in a form (not separately illustrated) that may reduce structural interference and damage (or bending stress) with other components.

According to an embodiment, the second support part (or second support body, second support member, or second support structure) 52 may be positioned between the first support part 51 and the rear plate 32. The second support part 52 may be coupled to the first support part 51 via a screw. At least a portion of the second support part 52 may cover a combination of the first printed circuit board 54 and one or more components electrically and mechanically connected to the first printed circuit board 54.

According to an embodiment, the second support part 52 may include a plurality of first screw holes corresponding to the plurality of screws, and the first printed circuit board 54 may include a plurality of second screw holes aligned and overlapped with the plurality of first screw holes.

According to an embodiment, the second support part 52 may include at least one third screw hole corresponding to at least one screw, and the first bracket 61 may include at least one fourth screw hole aligned and overlapped with the at least one third screw hole.

According to an embodiment, when viewed from above the rear plate 32, the camera unit 3021 of the first camera module 302, the camera unit 3031 of the second camera module 303, the camera unit 3041 of the third camera module 304, and the light emitting module 306 may overlap with openings included in the second support part 52.

According to an embodiment, when viewed from above the rear plate 32, the second support part 52 may include an opening aligned and overlapped with the speaker unit 3102 of the first sound output module 3101.

According to an embodiment, when viewed from above the rear plate 32, the third support part 53 may be at least partially spaced apart from the second support part 52 with the battery 56 interposed therebetween. The third support part 53 may be coupled to the first support part 51 via a plurality of screws. At least a portion of the third support part 53 may cover a combination of the second printed circuit board 55 and one or more components electrically and mechanically connected to the second printed circuit board 55.

According to an embodiment, the second support part 52 and/or the third support part 53 may include a metallic material and/or a non-metallic material (e.g., polymer).

According to an embodiment, the frame 5 may be defined or interpreted as a 'front case' of the electronic device 3, and the second support part 52 and/or the third support part 53 may be defined or interpreted as a 'rear case' of the electronic device 3.

According to various embodiments, the second support part 52 and/or the third support part 53 may be interpreted as a part of the housing 30 (see FIG. 3).

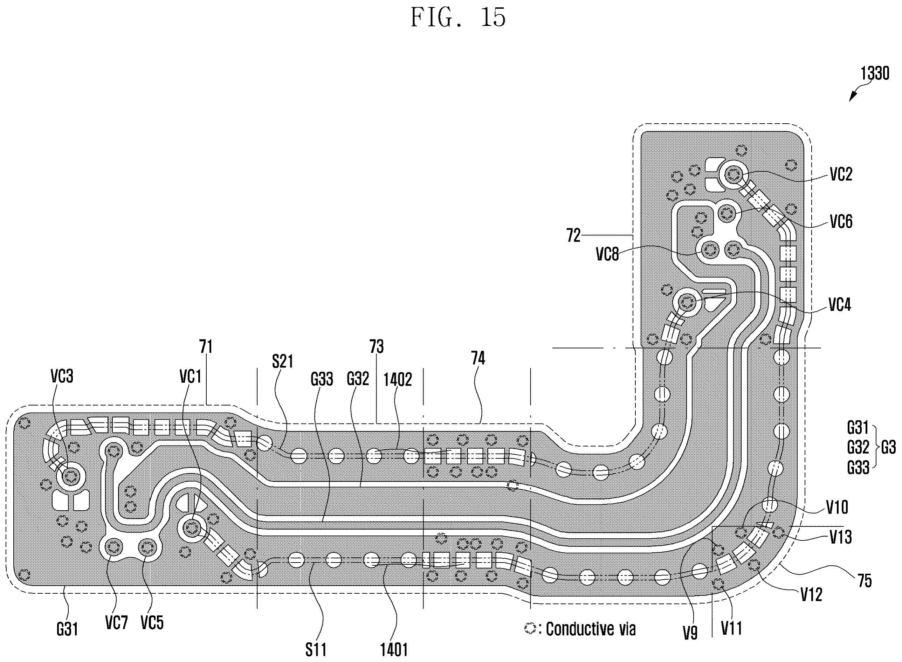

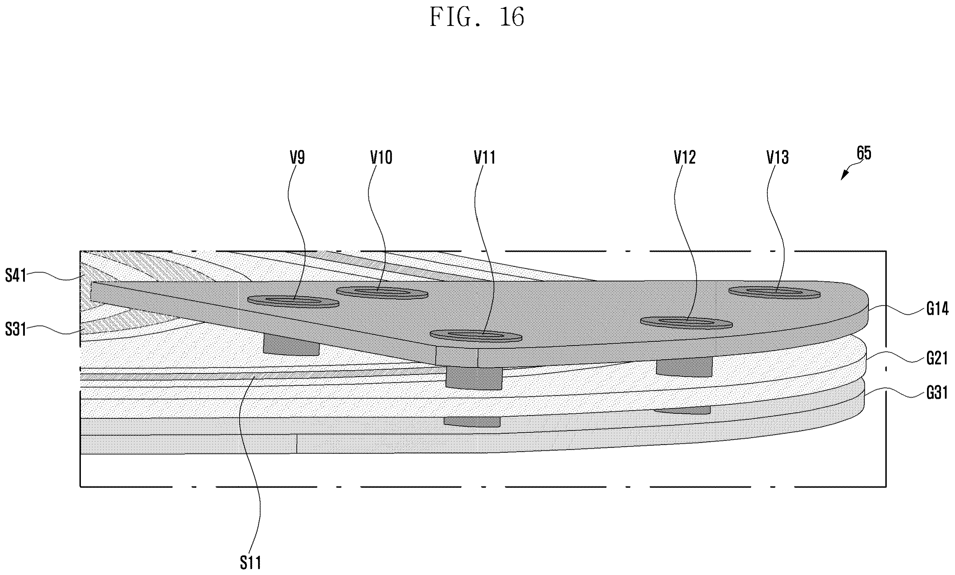

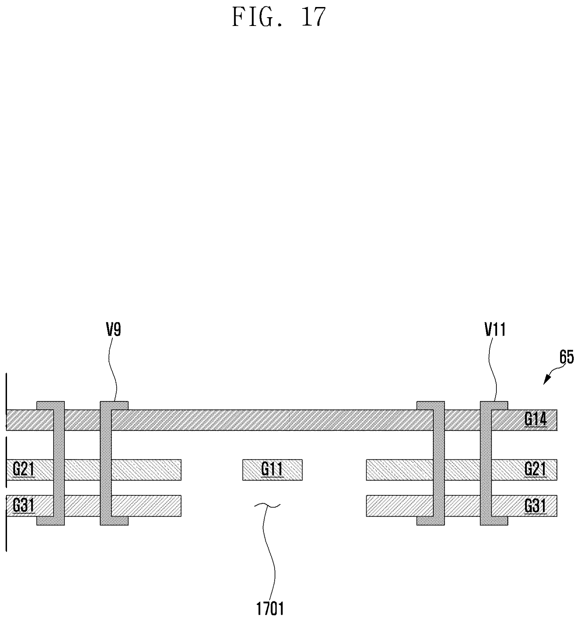

FIG. 13 is a diagram illustrating a first pattern layer 1310 according to an embodiment of the disclosure. FIG. 14 is a diagram illustrating a second pattern layer 1320 according to an embodiment of the disclosure. FIG. 15 is a diagram illustrating a third pattern layer 1330 according to an embodiment of the disclosure. FIG. 16 is a perspective view illustrating a portion of a third flexible printed circuit board 65 according to an embodiment of the disclosure. FIG. 17 is a cross-sectional view illustrating a third flexible printed circuit board 65 taken along line NN' of FIG. 13 according to an embodiment of the disclosure.

With reference to FIGS. 13, 14, 15, and 16, the third flexible printed circuit board 65 may include a first pattern layer 1310, a second pattern layer 1320, and/or a third pattern layer 1330.

According to an embodiment, the second pattern layer 1320 may be disposed between the first pattern layer 1310 and the third pattern layer 1330. The third flexible printed circuit board 65 may include a first insulating layer (e.g., first non-conductive layer) (not separately illustrated) disposed between the first pattern layer 1310 and the second pattern layer 1320. The third flexible printed circuit board 65 may include a second insulating layer (e.g., second non-conductive layer) (not separately illustrated) disposed between the second pattern layer 1320 and the third pattern layer 1330.

According to an embodiment, the first pattern layer 1310 may be disposed corresponding to the third surface 651 (see FIG. 7) of the third flexible printed circuit board 65, and the third pattern layer 1330 may be disposed corresponding to the fourth surface 652 of the third flexible printed circuit board 65.

According to an embodiment, the first pattern layer 1310 may include a first terminal T1, a second terminal T2, a third terminal T3, a fourth terminal T4, a fifth terminal T5, a sixth terminal T6, a seventh terminal T7, an eighth terminal T8, and/or a first ground plane G1.

According to an embodiment, the first terminal T1, the third terminal T3, the fifth terminal T5, and/or the seventh terminal T7 may be included in the first portion 71. The first terminal T1, the third terminal T3, the fifth terminal T5, and/or the seventh terminal T7 may be electrically connected to the first connector 711 (see FIG. 8) through a conductive adhesive material (or bonding material) such as solder.

According to an embodiment, the second terminal T2, the fourth terminal T4, the sixth terminal T6, and/or the eighth terminal T8 may be included in the second portion 72. The second terminal T2, the fourth terminal T4, the sixth terminal T6, and/or the eighth terminal T8 may be electrically connected to the second connector 721 (see FIG. 8) through a conductive adhesive material (or bonding material) such as solder.

According to an embodiment, the first ground plane G1 may include at least one first ground pattern G11 included in the first portion 71, at least one second ground pattern G12 included in the second portion 72, at least one third ground pattern G13 included in the first rigid portion 74, and/or at least one fourth ground pattern G14 included in the second rigid portion 75.

According to an embodiment, in the first pattern layer 1310, at least one first ground pattern G11, at least one second ground pattern G12, at least one third ground pattern G13, and at least one fourth ground pattern G14 may be physically separated.

According to an embodiment, at least one first ground pattern G11 may be physically separated from the first terminal T1, the third terminal T3, the fifth terminal T5, and the seventh terminal T7.

According to an embodiment, at least one second ground pattern G12 may be physically separated from the second terminal T2, the fourth terminal T4, the sixth terminal T6, and the eighth terminal T8.

According to an embodiment, at least one fourth ground pattern G14 may be provided (or formed) in a fan shape. A shape of the at least one fourth ground pattern G14 is not limited to the illustrated example and may vary.

According to an embodiment, the second pattern layer 1320 may include a first signal line pattern S11, a second signal line pattern S21, a third signal line pattern S31, a fourth signal line pattern S41, and/or a second ground plane G2.

According to an embodiment, the first signal line pattern S11 may be extended from one end included in the first portion 71 to the other end included in the second portion 72. A via connection portion disposed at one end of the first signal line pattern S11 included in the first portion 71 may be electrically connected to a via connection portion included in the first terminal T1 of the first pattern layer 1310 through a first conductive via. A via connection portion disposed at the other end of the first signal line pattern S11 included in the second portion 72 may be electrically connected to a via connection portion included in the second terminal T2 of the first pattern layer 1310 through a second conductive via. The via connection portion may include a via hole for the conductive via. A combination of the first signal line pattern S11, the first terminal T1, the second terminal T2, the first conductive via, and the second conductive via may provide (or form) the first signal line S1 (see FIG. 8).

According to an embodiment, the second signal line pattern S21 may be extended from one end included in the first portion 71 to the other end included in the second portion 72. A via connection portion disposed at one end of the second signal line pattern S21 included in the first portion 71 may be electrically connected to a via connection portion included in the third terminal T3 of the first pattern layer 1310 through a third conductive via. A via connection portion disposed at the other end of the second signal line pattern S21 included in the second portion 72 may be electrically connected to a via connection portion included in the fourth terminal T4 of the first pattern layer 1310 through a fourth conductive via. A combination of the second signal line pattern S21, the third terminal T3, the fourth terminal T4, the third conductive via, and the fourth conductive via may provide (or form) the second signal line S2 (see FIG. 8).

According to an embodiment, the third signal line pattern S31 may be extended from one end included in the first portion 71 to the other end included in the second portion 72. A via connection portion disposed at one end of the third signal line pattern S31 included in the first portion 71 may be electrically connected to a via connection portion included in the fifth terminal T5 of the first pattern layer 1310 through a fifth conductive via. A via connection portion disposed at the other end of the third signal line pattern S31 included in the second portion 72 may be electrically connected to a via connection portion included in the sixth terminal T6 of the first pattern layer 1310 through a sixth conductive via. A combination of the third signal line pattern S31, the fifth terminal T5, the sixth terminal T6, the fifth conductive via, and the sixth conductive via may provide (or form) the third signal line S3 (see FIG. 8).

According to an embodiment, the fourth signal line pattern S41 may be extended from one end included in the first portion 71 to the other end included in the second portion 72. A via connection portion disposed at one end of the fourth signal line pattern S41 included in the first portion 71 may be electrically connected to a via connection portion included in the seventh terminal T7 of the first pattern layer 1310 through a seventh conductive via. A via connection portion disposed at the other end of the fourth signal line pattern S41 included in the second portion 72 may be electrically connected to a via connection portion included in the eighth terminal T8 of the first pattern layer 1310 through an eighth conductive via. A combination of the fourth signal line pattern S41, the seventh terminal T7, the eighth terminal T8, the seventh conductive via, and the eighth conductive via may provide (or form) the fourth signal line S4 (see FIG. 8).

According to an embodiment, the second ground plane G2 may include a fifth ground pattern G21 and/or a sixth ground pattern G22 extended from the first portion 71 to the second portion 72. In the second pattern layer 1320, the fifth ground pattern G21 and the sixth ground pattern G22 may be physically separated. In various embodiments, an integrated or single ground pattern (e.g., single continuous ground pattern) that replaces the fifth ground pattern G21 and the sixth ground pattern G22 may be provided (or formed).

According to an embodiment, the second ground plane G2 may be physically separated from the first signal line pattern S11, the second signal line pattern S21, the third signal line pattern S31, and the fourth signal line pattern S41.

According to an embodiment, the third pattern layer 1330 may include a first via connection portion VC1, a second via connection portion VC2, a third via connection portion VC3, a fourth via connection portion VC4, a fifth via connection portion VC5, a sixth via connection portion VC6, a seventh via connection portion VC7, an eighth via connection portion VC8, and/or a third ground plane G3.

According to an embodiment, the first via connection portion VC1, the third via connection portion VC3, the fifth via connection portion VC5, and/or the seventh via connection portion VC7 may be included in the first portion 71. The first via connection portion VC1, the third via connection portion VC3, the fifth via connection portion VC5, and/or the seventh via connection portion VC7 may be physically separated from the third ground plane G3.

According to an embodiment, the first via connection portion VC1 may be electrically connected to a via connection portion included in the first terminal T1 of the first pattern layer 1310 and a via connection portion disposed at one end of the first signal line pattern S11 of the second pattern layer 1320 through a first PTH.

According to an embodiment, the third via connection portion VC3 may be electrically connected to a via connection portion included in the third terminal T3 of the first pattern layer 1310 and a via connection portion disposed at one end of the second signal line pattern S21 of the second pattern layer 1320 through a third PTH.

According to an embodiment, the fifth via connection portion VC5 may be electrically connected to a via connection portion included in the fifth terminal T5 of the first pattern layer 1310 and a via connection portion disposed at one end of the third signal line pattern S31 of the second pattern layer 1320 through a fifth PTH.

According to an embodiment, the seventh via connection portion VC7 may be electrically connected to a via connection portion included in the seventh terminal T7 of the first pattern layer 1310 and a via connection portion disposed at one end of the fourth signal line pattern S41 of the second pattern layer 1320 through a seventh PTH.

According to an embodiment, the second via connection portion VC2, the fourth via connection portion VC4, the sixth via connection portion VC6, and/or the eighth via connection portion VC8 may be included in the second portion 72. The second via connection portion VC2, the fourth via connection portion VC4, the sixth via connection portion VC6, and/or the eighth via connection portion VC8 may be physically separated from the third ground plane G3.

According to an embodiment, the second via connection portion VC2 may be electrically connected to a via connection portion included in the second terminal T2 of the first pattern layer 1310 and a via connection portion disposed at the other end of the first signal line pattern S11 of the second pattern layer 1320 through a second PTH.

According to an embodiment, the fourth via connection portion VC4 may be electrically connected to a via connection portion included in the fourth terminal T4 of the first pattern layer 1310 and a via connection portion disposed at the other end of the second signal line pattern S21 of the second pattern layer 1320 through a fourth PTH.

According to an embodiment, the sixth via connection portion VC6 may be electrically connected to a via connection portion included in the sixth terminal T6 of the first pattern layer 1310 and a via connection portion disposed at the other end of the third signal line pattern S31 of the second pattern layer 1320 through a sixth PTH.

According to an embodiment, the eighth via connection portion VC8 may be electrically connected to a via connection portion included in the eighth terminal T8 of the first pattern layer 1310 and a via connection portion disposed at the other end of the fourth signal line pattern S41 of the second pattern layer 1320 through an eighth PTH.

According to an embodiment, the third ground plane G3 may include a seventh ground pattern G31, an eighth ground pattern G32, and/or a ninth ground pattern G33 extended from the first portion 71 to the second portion 72. In the third pattern layer 1330, the seventh ground pattern G31, the eighth ground pattern G32, and the ninth ground pattern G33 may be physically separated. In various embodiments, an integrated or single ground pattern (e.g., single continuous ground pattern) that replaces at least two of the seventh ground pattern G31, the eighth ground pattern G32, and the ninth ground pattern G33 may be provided (or formed).

According to an embodiment, the first ground plane G1 of the first pattern layer 1310, the second ground plane G2 of the second pattern layer 1320, and the third ground plane G3 of the third pattern layer 1330 may be electrically connected through a plurality of conductive vias (e.g., PTHs). A combination of the first ground plane G1, the second ground plane G2, the third ground plane G3, and the plurality of conductive vias may provide (or form) a ground structure of the third flexible printed circuit board 65.

According to an embodiment, a combination of at least one third ground pattern G13 of the first pattern layer 1310, a portion overlapped with at least one third ground pattern G13 of the second ground plane G2 of the second pattern layer 1320, a portion overlapped with at least one third ground pattern G13 of the third ground plane G3 of the third pattern layer 1330, and a plurality of conductive vias disposed corresponding to the at least one third ground pattern G13 may provide (or form) the first rigid portion 74 (see FIG. 8). The first rigid portion 74 (see FIG. 8) may further include at least one third ground pattern G13 compared to the first flexible portion 76 (see FIG. 8) and the second flexible portion 77 (see FIG. 8) to be less flexible than the first flexible portion 76 (see FIG. 8) and the second flexible portion 77 (see FIG. 8). The first rigid portion 74 (see FIG. 8) may further include a plurality of conductive vias compared to the first flexible portion 76 (see FIG. 8) and the second flexible portion 77 (see FIG. 8) to be less flexible than the first flexible portion 76 (see FIG. 8) and the second flexible portion 77 (see FIG. 8).

According to various embodiments, the first rigid portion 74 (see FIG. 8) may include a separately attached third reinforcing plate (e.g., third stiffener) (not separately illustrated) so as to have rigidity.

According to an embodiment, a combination of at least one fourth ground pattern G14 of the first pattern layer 1310, a portion overlapped with at least one fourth ground pattern G14 of the second ground plane G2 of the second pattern layer 1310, a portion overlapped with at least one fourth ground pattern G14 of the third ground plane G3 of the third pattern layer 1330, and a plurality of conductive vias disposed corresponding to the at least one fourth ground pattern G14 may provide (or form) the second rigid portion 75 (see FIG. 8). The second rigid portion 75 (see FIG. 8) may further include at least one fourth ground pattern G14 compared to the first flexible portion 76 (see FIG. 8) and the second flexible portion 77 (see FIG. 8) to be less flexible than the first flexible portion 76 (see FIG. 8) and the second flexible portion 77 (see FIG. 8). The second rigid portion 75 (see FIG. 8) may further include a plurality of conductive vias compared to the first flexible portion 76 (see FIG. 8) and the second flexible portion 77 (see FIG. 8) to be less flexible than the first flexible portion 76 (see FIG. 8) and the second flexible portion 77 (see FIG. 8).

According to various embodiments, the second rigid portion 75 (see FIG. 8) may include a separately attached fourth reinforcing plate (e.g., fourth stiffener) (not separately illustrated) so as to have rigidity.

According to an embodiment, at least one fourth ground pattern G14 included in the first pattern layer 1310 may be provided (or formed) as a single fan-shaped ground pattern. The second rigid portion 75 (see FIG. 8) may be provided (or formed) in a fan shape corresponding to the at least one fourth ground pattern G14.

According to an embodiment, the first signal line pattern S11 included in the second pattern layer 1320 may cross between at least one fourth ground pattern G14 included in the first layer 1310 and the seventh ground pattern G31 included in the third layer 1330.

According to an embodiment, at least one fourth ground pattern G14 included in the first pattern layer 1310 may be electrically connected to the fifth ground pattern G21 included in the second pattern layer 1320 and the seventh ground pattern G31 included in the third pattern layer 1330 through the ninth conductive via V9, the tenth conductive via V10, the eleventh conductive via V11, the twelfth conductive via V12, and/or the thirteenth conductive via V13.

According to an embodiment, with respect to the first signal line pattern S11 included in the second pattern layer 1320, the ninth conductive via V9 and the tenth conductive via V10 may be disposed at one side of the first signal line pattern S11, and the eleventh conductive via V11, the twelfth conductive via V12, and the thirteenth conductive via V13 may be disposed at the other side of the first signal line pattern S11. In various embodiments, although not separately illustrated, the numbers and/or positions of the conductive vias disposed at one side with respect to the first signal line pattern S11 corresponding to at least one fourth ground pattern G14 are not limited to the illustrated example and may vary. In various embodiments, although not separately illustrated, the numbers and/or positions of conductive vias disposed at the other side with respect to the first signal line pattern S11 corresponding to at least one fourth ground pattern G14 are not limited to the illustrated examples and may vary.

According to an embodiment, the third ground plane G3 included in the third pattern layer 1330 may include a first opening pattern 1401 for impedance matching to the first signal line S1 (e.g., first transmission line) (see FIG. 8). The first opening pattern 1401 may include a plurality of openings disposed along the first signal line pattern S11. In FIG. 17, reference numeral '1701' may be one opening corresponding to line NN' of FIG. 13 among the plurality of openings of the first opening pattern 140. Impedance matching to the first signal line S1 (see FIG. 8) may reduce loss and/or deformation of a signal when the signal is transmitted through the first signal line S1. Impedance matching for the first signal line S1 (see FIG. 8) may secure or improve signal integrity when a signal is transmitted through the first signal line S1.

According to an embodiment, the third ground plane G3 included in the third pattern layer 1330 may include a second opening pattern 1402 for impedance matching to the second signal line S2 (e.g., second transmission line) (see FIG. 8). The second opening pattern 1402 may include a plurality of openings disposed along the second signal line pattern S21. Impedance matching to the second signal line S2 (see FIG. 8) may reduce loss and/or distortion of a signal when the signal is transmitted through the second signal line S2. Impedance matching to the second signal line S2 (see FIG. 8) may secure or improve signal integrity when a signal is transmitted through the second signal line S2.

According to an embodiment, in order to reduce an electromagnetic influence (e.g., frequency band shifting phenomenon) of the third signal line pattern S31 and the fourth signal line pattern S41 on the first signal line pattern S11, at least one fourth ground pattern G14 included in the first pattern layer 1310 may be disposed so as not to overlap with the third signal line pattern S31 and the fourth signal line pattern S41, when viewed from above at least one fourth ground pattern G4.

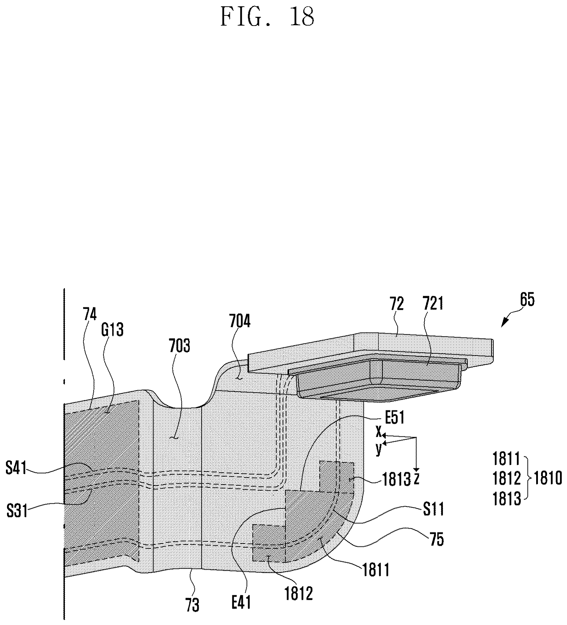

FIG. 18 is a perspective view illustrating a third flexible printed circuit board 65 according to various embodiments of the disclosure.

With reference to FIG. 18, the third flexible printed circuit board 65 may include a second portion 72 and/or a third portion 73 in which a second connector 721 is disposed.

According to an embodiment, the third portion 73 may include a first rigid portion 74 and a second rigid portion 75.

According to an embodiment, the first pattern layer 1310 (see FIG. 13) of the third flexible printed circuit board 65 may include at least one third ground pattern G13 included in the first rigid portion 74. The at least one third ground pattern G13 may include one or more via holes (not separately illustrated) corresponding to one or more conductive vias for electrical connection with a ground pattern included in another pattern layer (e.g., the second pattern layer 1320 of FIG. 14 or the third pattern layer 1330 of FIG. 15).

According to an embodiment, the first pattern layer 1310 (see FIG. 13) of the third flexible printed circuit board 65 may include at least one tenth ground pattern 1810 included in the second rigid portion 75. The at least one tenth ground pattern 1810 may replace at least one fourth ground pattern G14 according to an exemplary embodiment of FIG. 13. The at least one tenth ground pattern 1810 may include one or more via holes (not separately illustrated) corresponding to one or more conductive vias for electrical connection with a ground pattern included in another pattern layer (e.g., the second pattern layer 1320 of FIG. 14 or the third pattern layer 1330 of FIG. 15).

According to an embodiment, at least one tenth ground pattern 1810 may include a first area 1811, a second area 1812, and/or a third area 1813. The first area 1811 may be provided (or formed) in a fan shape. The first area 1811 may have substantially the same shape as at least one fourth ground pattern G14 according to an exemplary embodiment of FIG. 13. The second area 1812 may be extended from a fourth edge E41 (e.g., the fourth edge E4 of FIG. 8) of the first area 1811. The third area 1813 may be extended from a fifth edge E51 (e.g., the fifth edge E5 of FIG. 8) of the first area 1811.

According to an embodiment, the first signal line pattern S11 may overlap with the first area 1811, the second area 1812, and the third area 1813.

According to an embodiment, a plurality of conductive vias (not separately illustrated) corresponding to at least one tenth ground pattern 1810 may include at least one conductive via disposed at one side with respect to the first signal line pattern S11 and at least one conductive via disposed at the other side with respect to the first signal line pattern S11.

According to an embodiment, in order to reduce an electromagnetic influence (e.g., frequency band shifting phenomenon) of the third signal line pattern S31 and the fourth signal line pattern S41 on the first signal line pattern S11, at least one tenth ground pattern 1810 included in the first pattern layer 1310 may be disposed so as not to overlap with the third signal line pattern S31 and the fourth signal line pattern S41.

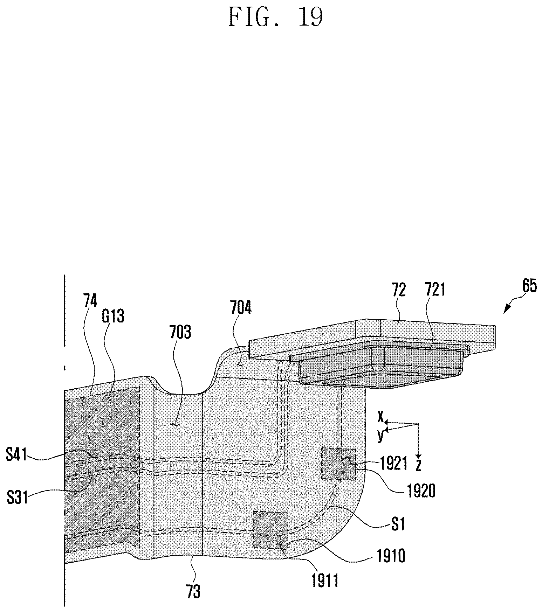

FIG. 19 is a perspective view illustrating a third flexible printed circuit board 65 according to various embodiments of the disclosure.

With reference to FIG. 19, the third flexible printed circuit board 65 may include a second portion 72 and/or a third portion 73 in which a second connector 721 is disposed.

According to an embodiment, the third portion 73 may include a first rigid portion 74, a third rigid portion 1910, and/or a fourth rigid portion 1920. The third rigid portion 1910 and the fourth rigid portion 1920 may replace the second rigid portion 75 according to an exemplary embodiment of FIG. 8.

According to an embodiment, the first pattern layer 1310 (see FIG. 13) of the third flexible printed circuit board 65 may include at least one third ground pattern G13 included in the first rigid portion 74. The at least one third ground pattern G13 may include one or more via holes (not separately illustrated) corresponding to one or more conductive vias for electrical connection with a ground pattern included in another pattern layer (e.g., the second pattern layer 1320 of FIG. 14 or the third pattern layer 1330 of FIG. 15).

According to an embodiment, the first pattern layer 1310 (see FIG. 13) of the third flexible printed circuit board 65 may include at least one eleventh ground pattern 1911 included in the third rigid portion 1910, and/or at least one twelfth ground pattern 1921 included in the fourth rigid portion 1920. The at least one eleventh ground pattern 1911 and the at least one twelfth ground pattern 1921 may be physically separated. The at least one eleventh ground pattern 1911 and the at least one twelfth ground pattern 1921 may replace at least one fourth ground pattern G14 according to an exemplary embodiment of FIG. 13.

According to an embodiment, at least one eleventh ground pattern 1911 may include one or more via holes (not separately illustrated) corresponding to one or more conductive vias for electrical connection with a ground pattern included in another pattern layer (e.g., the second pattern layer 1320 of FIG. 14 or the third pattern layer 1330 of FIG. 15).

According to an embodiment, at least one twelfth ground pattern 1921 may include one or more via holes (not separately illustrated) corresponding to one or more conductive vias for electrical connection with a ground pattern included in another pattern layer (e.g., the second pattern layer 1320 of FIG. 14 or the third pattern layer 1330 of FIG. 15).

According to an embodiment, the first signal line pattern S11 may overlap with at least one eleventh ground pattern 1911 and at least one twelfth ground pattern 1921.

According to an embodiment, a plurality of conductive vias (not separately illustrated) corresponding to at least one eleventh ground pattern 1911 may include at least one conductive via disposed at one side with respect to the first signal line pattern S11 and at least one conductive via disposed at the other side with respect to the first signal line pattern S11.

According to an embodiment, a plurality of conductive vias (not separately illustrated) corresponding to at least one twelfth ground pattern 1921 may include at least one conductive via disposed at one side with respect to the first signal line pattern S11 and at least one conductive via disposed at the other side with respect to the first signal line pattern S11.

According to an embodiment, in order to reduce an electromagnetic influence (e.g., frequency band shifting phenomenon) of the third signal line pattern S31 and the fourth signal line pattern S41 on the first signal line pattern S11, at least one eleventh ground pattern 1911 and at least one twelfth ground pattern 1921 included in the first pattern layer 1310 may be disposed so as not to overlap with the third signal line pattern S31 and the fourth signal line pattern S41.

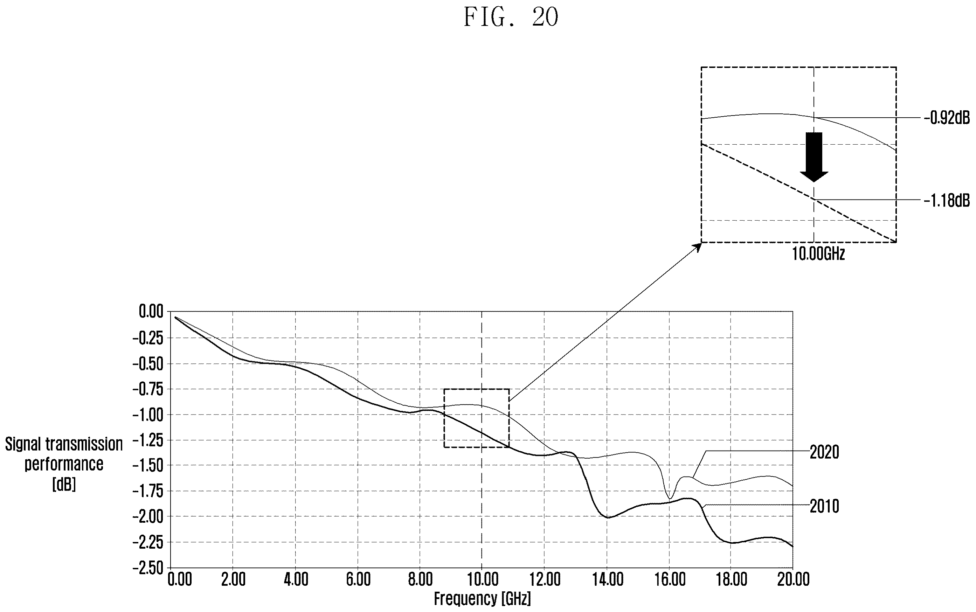

FIG. 20 is a graph illustrating a signal transmission performance of a third flexible printed circuit board 65 according to an exemplary embodiment of the disclosure including at least one fourth ground pattern G14 (see FIG. 13) and a third flexible printed circuit board of a comparative example not including at least one fourth ground pattern G14.

With reference to FIG. 20, a graph 2010 represents a signal transmission performance for a third flexible printed circuit board 65 according to an exemplary embodiment of the disclosure. A graph 2020 represents a signal transmission performance for a third flexible printed circuit board of a comparative example. The third flexible printed circuit board 65 according to an exemplary embodiment of the disclosure may provide an improved signal transmission performance compared to the third flexible printed circuit board of the comparative example due to at least one fourth ground pattern G14 corresponding to the first signal line S1. For example, the third flexible printed circuit board 65 according to an exemplary embodiment of the disclosure may have a signal transmission performance value of about -1.18 dB, which is a gain of about 0.26 dB, compared to a signal transmission performance value of about -0.92 dB provided by the third flexible printed circuit board of the comparative example.

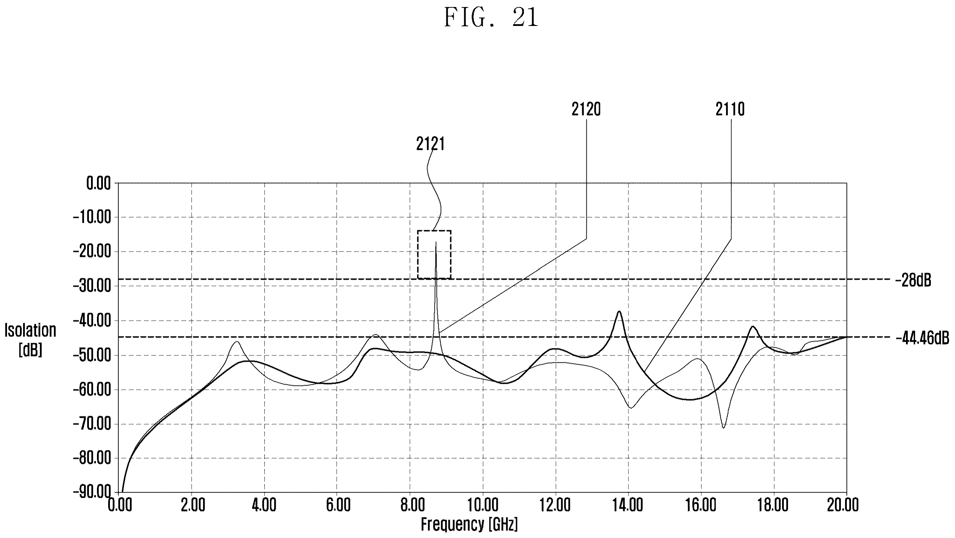

FIG. 21 is a graph illustrating isolation of a third flexible printed circuit board 65 according to an exemplary embodiment of the disclosure including at least one fourth ground pattern G14 (see FIG. 13) and a third flexible printed circuit board of a comparative example not including at least one fourth ground pattern G14.

With reference to FIG. 21, a graph 2110 represents isolation of the third flexible printed circuit board 65 according to an exemplary embodiment of the disclosure. A graph 2120 represents isolation of a third flexible printed circuit board of a comparative example. The third flexible printed circuit board 65 according to an exemplary embodiment of the disclosure may provide improved isolation compared to the third flexible printed circuit board of the comparative example due to at least one fourth ground pattern G14 corresponding to the first signal line S1. The third flexible printed circuit board 65 according to an exemplary embodiment of the disclosure may provide designated electromagnetic isolation. The 'designated electromagnetic isolation' may refer to an isolation level for securing or improving signal integrity by reducing loss or distortion of a signal transmitted through a signal line (e.g., the first signal line S1). The designated electromagnetic isolation may refer to an improved isolation level over reference isolation of, for example, about -28 dB. The third flexible printed circuit board of the comparative example may have isolation that falls below reference isolation of, for example, about -28 dB by causing a resonance that causes signal leakage or loss in the designated and/or selected frequency band (see 2121). The third flexible printed circuit board 65 according to the exemplary embodiment of the disclosure may provide improved isolation of about -44.46 dB over the reference isolation of, for example, about -28 dB.

According to an exemplary embodiment of the disclosure, the electronic device 3 includes a first electrical element, a second electrical element, and a flexible printed circuit board (e.g., a third flexible printed circuit board 65) connecting the first electrical element and the second electrical element. The flexible printed circuit board includes a first portion 71 in which a first connector 711 electrically connected to the first electrical element is disposed or included. The flexible printed circuit board includes a second portion 72 in which a second connector 721 electrically connected to the second electrical element is disposed or included. The flexible printed circuit board includes a third portion 73 between the first portion 71 and the second portion 72. The third portion 73 includes a first partial area 731 extended from the first portion 71. The third portion 73 includes a second partial area 732 extended from the second portion 72. The third portion 73 includes a corner 733 between the first partial area 731 and the second partial area 732. The corner 733 includes a fan-shaped rigid portion (e.g., the second rigid portion 75). For example, the fan-shaped rigid portion (e.g., the second rigid portion 75) includes at least two edges (e.g., the fourth edge E4 and the fifth edge E5 of FIG. 8) and at least one arc (e.g., the edge E3 of FIG. 8).

According to an exemplary embodiment of the disclosure, a flexible printed circuit board (e.g., a third flexible printed circuit board 65) may include a plurality of conductive vias (e.g., a ninth conductive via V9, a tenth conductive via V10, an eleventh conductive via V11, a twelfth conductive via V12, and/or a thirteenth conductive via V13) disposed in a rigid portion (e.g., a second rigid portion 75).

According to an exemplary embodiment of the disclosure, a flexible printed circuit board (e.g., a third flexible printed circuit board 65) may include a first signal line S1, a second signal line S2, and a third signal line S3 extended from a first connector 711 to a second connector 721. The third signal line S3 may be extended between the first signal line S1 and the second signal line S2. A portion of the first signal line S1 included in the corner 733 may be disposed closer to an outer edge of the corner 733 than a portion of the second signal line S2 included in the corner 733 to have a longer length. The first signal line S1 may cross a rigid portion (e.g., the second rigid portion 75).

According to an exemplary embodiment of the disclosure, the electronic device 3 may be configured to transmit a wireless signal through a first signal line S1 and a second signal line S2 and to transmit power through a third signal line S3.

According to an exemplary embodiment of the disclosure, a flexible printed circuit board (e.g., a third flexible printed circuit board 65) may include a ground structure that at least partially surrounds a first signal line S1, a second signal line S2, and a third signal line S3. The ground structure may include a first opening pattern 1401 and a second opening pattern 1402. The first opening pattern 1401 may overlap with the first signal line S1 and include a plurality of openings at least partially disposed along the first signal line S1. The second opening pattern 1402 may overlap with the second signal line S2 and include a plurality of openings at least partially disposed along the second signal line S2.

According to an exemplary embodiment of the disclosure, the first partial area 731 may include another rigid portion (e.g., the first rigid portion 74) spaced apart from the first portion 71 and the rigid portion (e.g., the second rigid portion 75). The flexible printed circuit board (e.g., the third flexible printed circuit board 65) may include a plurality of conductive vias disposed in the other rigid portion.

According to an exemplary embodiment of the disclosure, the first partial area 731 may include a flexible portion (e.g., a first flexible portion 76) between the first portion 71 and another rigid portion (e.g., the first rigid portion 74). The flexible portion may be extended from the first portion to the other rigid portion (e.g., the first rigid portion 74) by a length of 5 mm or less.

According to an exemplary embodiment of the disclosure, a flexible printed circuit board (e.g., a third flexible printed circuit board 65) may include a first pattern layer 1310, a second pattern layer 1320, and a third pattern layer 1330. The second pattern layer 1320 may be disposed between the first pattern layer 1310 and the third pattern layer 1330. The first pattern layer 1310 may include a fan-shaped ground pattern (e.g., at least one fourth ground pattern G14) included in a rigid portion (e.g., the second rigid portion 75). The ground pattern may be electrically connected to a ground pattern included in the second pattern layer 1320 and a ground pattern included in the third pattern layer 1330 through a plurality of conductive vias.

According to an exemplary embodiment of the disclosure, the first electrical element may include an antenna module 315. The second electrical element may include a first printed circuit board 54 on which a wireless communication circuit configured to transmit and/or receive millimeter waves through the antenna module 315 is disposed.

According to an exemplary embodiment of the disclosure, the electronic device 3 may include a housing 30. The housing 30 may include a front plate 31 configured to form at least a portion of a front surface 30A of the electronic device 3. The housing 30 may include a rear plate 32 configured to form at least a portion of a rear surface 30B of the electronic device 3. The housing 30 may include a side 33 configured to form at least a portion of a side surface 30C of the electronic device 3. The antenna module 315 may include a second printed circuit board (e.g., a third printed circuit board 410), at least one antenna element (e.g., a plurality of antenna elements 421, 422, 423, 424, and 425), and a third connector (e.g., a connector 47). The second printed circuit board may include a first surface 411 that faces the first side 331 of the side 33, and a second surface 412 that faces opposite to the first surface 411. At least one antenna element may be disposed on the first surface 411 or disposed within the second printed circuit board closer to the first surface 411 than the second surface 412. The third connector may be disposed on the second surface 412. A first portion 71 of the flexible printed circuit board (e.g., the third flexible printed circuit board 65) may face the second surface 412 so as to electrically connect the first connector 711 to the third connector.

According to an exemplary embodiment of the disclosure, the electronic device 3 may include a camera unit 3031. The camera unit 3031 may be received in the housing 30 corresponding to a camera hole formed in the rear plate 32. When viewed from above the rear surface 30B of the electronic device 3, a first portion 71 of the flexible printed circuit board (e.g., the third flexible printed circuit board 65) may be positioned between the second surface 412 of the antenna module 315 and the camera unit 3031.

According to an exemplary embodiment of the disclosure, the electronic device 3 may further include a support wall W. When viewed from above the rear surface 30B of the electronic device 3, the support wall W may be positioned between the camera unit 3031 and the first printed circuit board 54. The support wall W may face the camera unit 3031 in a direction perpendicular to a direction in which the first surface 411 of the antenna module 315 faces. When viewed from above the rear surface 30B of the electronic device 3, a corner 733 of the flexible printed circuit board (e.g., the third flexible printed circuit board 65) may be positioned between the camera unit 3031 and the first printed circuit board 54 and be disposed in the support wall W1 through an adhesive material.

According to an exemplary embodiment of the disclosure, the electronic device 3 may further include a fourth connector disposed on a substrate surface (e.g., the second substrate surface 54B) of the first printed circuit board 54 that faces the rear plate 32. A second portion 72 of the flexible printed circuit board (e.g., the third flexible printed circuit board 65) may be positioned between the rear plate 32 and the substrate surface so as to electrically connect the second connector 721 to the fourth connector.

According to an exemplary embodiment of the disclosure, a first partial area 731 of the flexible printed circuit board (e.g., the third flexible printed circuit board 65) may be bent to have a first bending axis BX1 parallel to a direction from the front plate 31 to the rear plate 32. A second partial area 732 of the flexible printed circuit board may be bent to have a second bending axis BX2 parallel to a direction in which the first surface 411 of the antenna module 315 faces.

According to an exemplary embodiment of the disclosure, the electronic device 3 may further include a battery 56 received in the housing 30. When viewed from above the rear surface 30B of the electronic device 3, a second portion 72 and a corner 733 of the flexible printed circuit board (e.g., the third flexible printed circuit board 65) may be positioned between the camera unit 3031 and the battery 56.

The embodiments disclosed in the disclosure and the drawings are merely specific examples provided to more easily describe the technical content and to aid in understanding the disclosure, and are not intended to limit the scope of the disclosure. Accordingly, the scope of various embodiments of the disclosure should be construed to include modification or variations other than the embodiments disclosed herein. Furthermore, it will be understood that any embodiment(s) described herein may be used in combination with any other embodiment(s) described herein.

## Claims

1. An electronic device (3), comprising:
a first electrical element and a second electrical element; and
a flexible printed circuit board (65) configured to connect the first electrical element and the second electrical element,
wherein the flexible printed circuit board (65) comprises:
a first portion (71) on which a first connector (711) electrically connected to the first electrical element is disposed,
a second portion (72) on which a second connector (721) electrically connected to the second electrical element is disposed, and
a third portion (73) between the first portion (71) and the second portion (72),
the third portion (73) comprises a first partial area (731) extended from the first portion (71), a second partial area (732) extended from the second portion (72), and a corner (733) between the first partial area (731) and the second partial area (732), and
the corner (733) comprises a rigid portion (75) of a fan shape.

2. The electronic device of claim 1, wherein the flexible printed circuit board (65) comprises a plurality of conductive vias (V9, V10, V11, V12, V13) disposed in the rigid portion (75).

3. The electronic device of claim 2, wherein the flexible printed circuit board (65) comprises a first signal line (S1), a second signal line (S2), and a third signal line (S3) extended from the first connector (711) to the second connector (721),
the third signal line (S3) is extended between the first signal line (S1) and the second signal line (S2),
a portion of the first signal line (S1) included in the corner (733) is disposed closer to an outer edge of the corner (733) than a portion of the second signal line (S2) included in the corner (733) to have a longer length, and
the first signal line (S1) is configured to cross the rigid portion (75).

4. The electronic device of claim 3, wherein the electronic device is configured to transmit a wireless signal through the first signal line S1 and the second signal line (S2), and
the electronic device is configured to transmit power through the third signal line (S3).

5. The electronic device of claim 3 or 4, wherein the flexible printed circuit board (65) comprises a ground structure configured to surround at least a portion of the first signal line (S1), the second signal line (S2), and the third signal line (S3),
wherein the ground structure comprises:
a first opening pattern (1401) configured to overlap with the first signal line (S1) and including a plurality of openings disposed at least partially along the first signal line (S1), and
a second opening pattern (1402) configured to overlap with the second signal line (S2) and including a plurality of openings disposed at least partially along the second signal line (S1).

6. The electronic device of any one of claims 1 to 5, wherein the first partial area (731) comprises another rigid portion (74) spaced apart from the first portion (71) and the rigid portion (75), and
the flexible printed circuit board (65) comprises a plurality of conductive vias disposed in the another rigid portion (74).

7. The electronic device of claim 6, wherein the first partial area (731) comprises a flexible portion (76) between the first portion (71) and the another rigid portion (74), and
the flexible portion (76) is extended from the first portion (71) to the other rigid portion (74) with a length of 5 mm or less.

8. The electronic device of any one of claims 1 to 7, wherein the flexible printed circuit board (65) comprises a first pattern layer (1310), a second pattern layer (1320), and a third pattern layer (1330),
the second pattern layer (1320) is disposed between the first pattern layer (1310) and the third pattern layer (1330),
the first pattern layer (1310) comprises a fan-shaped ground pattern (G14) included in the rigid portion (75), and
the ground pattern (G14) is electrically connected to a ground pattern included in the second pattern layer (1320) and a ground pattern included in the third pattern layer (1330) through a plurality of conductive vias.

9. The electronic device of any one of claims 1 to 8, wherein the first electrical element comprises an antenna module (315), and
the second electrical element comprises a first printed circuit board (54) on which a wireless communication circuit configured to transmit and/or receive millimeter waves through the antenna module (315) is disposed.

10. The electronic device of claim 9, further comprising a housing (30) including a front plate (31) forming at least a portion of a front surface (30A) of the electronic device (3), a rear plate (32) forming at least a portion of a rear surface (30B) of the electronic device (3), and a side (33) forming at least a portion of a side surface (30C) of the electronic device (3),
wherein the antenna module (315) comprises:
a second printed circuit board (410) including a first surface (411) facing the first side (331) of the side (33) and a second surface (412) facing opposite to the first surface (411),
at least one antenna element (421, 422, 423, 424, 425) disposed on the first surface (411) or disposed inside the second printed circuit board (410) closer to the first surface (411) than the second surface (412), and
a third connector (47) disposed on the second surface (412),
wherein the first portion (71) of the flexible printed circuit board (65) is configured to face the second surface (412) so as to electrically connect the first connector (711) to the third connector (47).

11. The electronic device of claim 10, further comprising a camera unit (3031) received in the housing (30) corresponding to a camera hole formed in the rear plate (32),
wherein the first portion (71) of the flexible printed circuit board (65) is positioned between the second surface (412) of the antenna module (315) and the camera unit (3031), when viewed from above the rear surface (30B).

12. The electronic device of claim 11, further comprising a support wall (W) positioned between the camera unit (3031) and the first printed circuit board (54), when viewed from above the rear surface (30B),
wherein the support wall (W) is configured to face the camera unit (3031) in a direction perpendicular to a direction in which the first surface (411) faces, and
the corner (733) of the flexible printed circuit board (65) is positioned between the camera unit (3031) and the first printed circuit board (54) and is disposed on the support wall (W) through an adhesive material, when viewed from above the rear surface (30B).

13. The electronic device of claim 12, further comprising a fourth connector disposed on the substrate surface (54B) of the first printed circuit board (54) facing the rear plate (32),
wherein the second portion (72) of the flexible printed circuit board (65) is positioned between the rear plate (32) and the substrate surface (54B) so as to electrically connect the second connector (721) to the fourth connector.

14. The electronic device of claim 13, wherein the first partial area (731) of the flexible printed circuit board (65) is bent to have a first bending axis (BX1) parallel to a direction from the front plate (31) to the rear plate (32), and
the second partial area (732) of the flexible printed circuit board (65) is bent to have a second bending axis (BX2) parallel to a direction in which the first surface (411) of the antenna module (315) faces.

15. The electronic device of claim 13, further comprising a battery (56) received in the housing (30),
wherein the second portion (72) and the corner (733) of the flexible printed circuit board (65) are positioned between the camera unit (3031) and the battery (56), when viewed from above the rear surface (30B).
